# EUROPÄISCHE PATENTANMELDUNG

(11) **EP 3 875 639 A1**
(43) Veröffentlichungstag der Anmeldung: **08.09.2021**
(21) Anmeldenummer: 20172928.2
(22) Anmeldetag: 05.05.2020
(51) Int. Cl.: C25D 21/18, C25D 21/22, C25C 3/00, C23F 1/00, C25D 21/14, C25D 3/38

(54) **VERFAHREN ZUM HERSTELLEN VON LEITERPLATTEN- UND/ODER SUBSTRATEN INNERHALB EINES WERTSTOFFKREISLAUFS**

(30) Priorität: 04.03.2020 EP 20160862
(71) Anmelder: AT & S Austria Technologie & Systemtechnik Aktiengesellschaft, 8700 Leoben-Hinterberg (AT)
(72) Erfinder: Klocek, Jolanta, 8712 Niklasdorf (AT); Payerl, Claudia, 8020 Graz (AT); Frey, Gerhard, 8793 Trofaiach (AT); Schrei, Martin, 8382 Mogersdorf (AT); Redl, Alois, 8712 Niklasdorf (AT); Ebinger, Christoph, 70599 Stuttgart (DE); Herzog, René, 8045 Graz (AT); Zanker, Andreas, 8753 Fohnsdorf (AT); Mandl, Thomas, 8720 Knittelfeld (AT); Gross, Friedrich, 8700 Leoben (AT); Kern, Konstantin, 8700 Leoben (AT); Moitzi, Heinz, 8740 Zeltweg (AT)
(74) Vertreter: Dilg, Haeusler, Schindelmann Patentanwaltsgesellschaft mbH

(57) **Zusammenfassung**

Es wird ein Verfahren beschrieben zum Herstellen von Leiterplatten und/oder Substraten, wobei anfallende Rückstände in Teilströmen derart in einem Wertstoffkreislauf rückgeführt werden, dass im Betriebszustand des Herstellungsverfahrens als Abfall im Wesentlichen nur ein Medium in Einleitqualität anfällt.

## Beschreibung

Die Erfindung betrifft ein Verfahren zum Herstellen von Leiterplatten und/oder Substraten. Weiterhin betrifft die Erfindung eine Prozesskontrollvorrichtung zum Regulieren des Verfahrens. Ferner betrifft die Erfindung ein Computerprogramm-Produkt zum Steuern des Verfahrens und/oder der Prozesskontrollvorrichtung.

Die Erfindung kann sich somit auf das technische Gebiet der Leiterplatten- und/oder Substrat-Herstellung beziehen. Insbesondere kann sich die Erfindung auf das technische Gebiet des Aufbereitens (insbesondere Rückgewinnens) von Metallsalz-haltigem Medium aus der Leiterplatten- und/oder Substrat-Herstellung innerhalb eines Wertstoffkreislaufs beziehen. Weiter kann sich die Erfindung auf das technische Gebiet des Recycelns innerhalb der Leiterplatten- und/oder Substrat-Herstellung beziehen.

Für die Erzeugung von Leiterplatten und/oder Substraten werden prinzipiell große Mengen an Metallen, insbesondere Schwermetallen (z.B. Kupfer, Nickel, Gold, Silber, Palladium, Zinn, Eisen) benötigt. Innerhalb des Herstellungsprozesses fallen daher aus den unterschiedlichen Prozessen Metall-haltige Rückstände bzw. Metall-haltige Medien (insbesondere Lösungen) an.

Die aufzubereitenden Metall (-salz)-haltigen Medien (bzw. zu reinigenden Abfall- und Rückstandskonzentrate) stammen im Wesentlichen aus zwei unterschiedlichen Verarbeitungsprozessen bei der Leiterplatten- und/oder Substrat-Herstellung: i) dem Ätzprozess (z.B. Ätzen von Kupferfolien) und ii) dem Galvanikprozess (z.B. Galvanisieren mit Kupferschichten). Zudem fallen aufzubereitende Metall (-salz)-haltige Medien während Spülprozessen sowohl aus dem Ätzprozess als auch aus dem Galvanikprozess an. Diese Spülwässer enthalten nur geringe Konzentrationen an Metall, insbesondere Kupfer. Die aufzubereitenden Metall (-salz)-haltigen Medien aus den Ätzprozessen und den Galvanikprozessen weisen hingegen vergleichsweise hohe Konzentrationen an Metall auf.

Ein aufzubereitendes Metall (-salz)-haltiges Medium aus dem Ätzprozess enthält gewöhnlich ein Metallsalz, in welchem das Metall mit dem Salz einer Säure (von dem Ätzvorgang) chemisch verbunden vorliegt (beispielsweise Kupferchlorid, wobei das Chlorid aus Salzsäure stammt). Ein aufzubereitendes Metall (-salz)-haltiges Medium aus dem Galvanikprozess enthält gewöhnlich ebenfalls ein Metallsalz, in welchem das Metall mit dem Salz einer Säure der Elektrolyse chemisch verbunden vorliegt (beispielsweise Kupfersulfat, wobei das Sulfat aus Schwefelsäure stammt). Zusätzlich weist ein aufzubereitendes Metall (-salz)-haltiges Medium aus dem Galvanikprozess generell Fremdmetalle, beispielsweise Eisen, in hohen Konzentrationen auf.

Es sind zwar prinzipiell Methoden bekannt, Metall aus den beschriebenen Metall (-salz)-haltigen Medien rückzugewinnen. Allerdings ist ein rückgewonnenes Metall für die Leiterplatten- und/oder Substrat-Herstellung nur in hochreiner Form (z.B. 99% bis 99,99%, insbesondere etwa 99,9% rein) von Interesse. Eine solche Rückgewinnung kann z.B. mittels einer Elektrolyse erfolgen. Die oben beschriebenen Metall (-salz)-haltigen Medien sind hierfür allerdings denkbar ungeeignet, denn die Abscheidung von reinem Metall (z.B. Kupfer) ist durch die Zusammensetzung der Metall (-salz)-haltigen Medien behindert und/oder erschwert. So stören bzw. verunmöglichen Fremdmetalle wie Eisen erheblich eine qualitativ hochwertige Elektrolyse.

Aus diesem Grund werden konventionell Abfallkonzentrate aus der Leiterplatten- und/oder Substrat-Herstellung auf kostenintensive und wenig umweltfreundliche bzw. nachhaltige Weise entsorgt.

Es ist eine Aufgabe der vorliegenden Erfindung ein kostengünstiges, umweltfreundliches, und nachhaltiges Recycling von Abfällen (z.B. Metallsalz-haltigen Medien) aus der Leiterplatten- und/oder Substrat-Herstellung innerhalb eines Wertstoffkreislaufs auf effiziente und robuste Weise zu ermöglichen.

Gemäß einem Aspekt der Erfindung wird ein Verfahren (welches z.B. innerhalb einer Industrieanlage ausgeführt wird) beschrieben zum Herstellen von Leiterplatten und/oder Substraten, wobei anfallende Rückstände in Teilströmen (bzw. einem gesteuerten Fluss an Lösungen) derart in einem Wertstoffkreislauf rückgeführt werden, dass im Betriebszustand des Herstellungsverfahrens als Abfall im Wesentlichen nur ein (flüssiges) Medium in Einleitqualität anfällt.

Gemäß einem weiteren Aspekt der vorliegenden Erfindung wird eine Prozesskontrollvorrichtung zum Regulieren des oben beschriebenen Verfahrens diskutiert. Die Prozesskontrollvorrichtung weist auf: i) eine Datenbank zum Erfassen von zumindest einem Prozessparameter (bzw. einem Ist-Wert), insbesondere einer Mehrzahl von Prozessparametern, aus dem laufenden Prozess, ii) eine Datenmodell-Einheit, welche eingerichtet ist zum Speichern von zumindest einem vorbestimmten Prozessparameter (bzw. einem Soll-Wert), insbesondere einer Mehrzahl von vorbestimmten Prozessparametern, und iii) eine Berechnungsvorrichtung, welche eingerichtet ist zum a) Vergleichen des erfassten Prozessparameters mit dem vorbestimmten Prozessparameter (bzw. der Mehrzahlen miteinander), b) Bestimmen einer Steueroperation, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation (z.B. Flussrate anpassen, etc...).

Gemäß einem weiteren Aspekt der vorliegenden Erfindung wird ein Computerprogramm-Produkt beschrieben zum Steuern eines Verfahrens zum Aufbereiten eines Metallsalz-haltigen Mediums aus der Leiterplatten und/oder Substrat Herstellung, welches Computerprogramm-Produkt, wenn es von einem oder mehreren Prozessoren (bzw. einem oder mehreren Computern) ausgeführt wird, das Verfahren (wie oben beschrieben) und/oder die Prozesskontrollvorrichtung (wie oben beschrieben) steuert.

Im Rahmen dieses Dokuments kann unter dem Begriff "anfallende Rückstände" insbesondere ein Abfall-Medium bzw. eine Mehrzahl von Abfall-Medien (insbesondere ein flüssiges Medium) verstanden werden, welche aus Prozessschritten (z.B. Ätzprozess, Galvanikprozess, Spülwasser-Aufbereitung) der Leiterplatten- und/oder Substrat-Herstellung resultieren. Ein anfallender Rückstand kann z.B. Schwermetall- und/oder Säure- Reste (z.B. Kupfer, Kupfersulfat, Kupferchlorid, Eisen, Nickel, Gold, Salzsäure, Schwefelsäure) aufweisen. Insbesondere kann die Entsorgung eines solchen Rückstandes aufwendig und Kosten-intensiv sein. In einem Ausführungsbeispiel kann ein anfallender Rückstand ein (aufzubereitendes und/oder aufbereitetes) Metallsalz-haltiges Medium sein.

Im Rahmen dieses Dokuments kann unter dem Begriff "Metallsalz-haltiges Medium" insbesondere jegliches (flüssige) Medium verstanden werden, welches ein Metallsalz aufweist. Ein Metallsalz ist eine chemische Verbindung zwischen einem Metall und einer Säure. Beispiele für ein solches Metall können umfassen: Kupfer, Nickel, Gold, Silber, Cobalt, Cadmium, Magnesium, Natrium, Palladium, Zinn. Beispiele für Säuren können umfassen: Schwefelsäure, Salzsäure, Salpetersäure, Phosphorsäure; wobei das Metallsalz entsprechend z.B. als Sulfat, Chlorid, Nitrat, oder Phosphat vorliegt. Entsprechend kann ein Metallsalz z.B. Kupfersulfat oder Kupferchlorid sein. Dieses kann in dem Metallsalz-haltigen Medium als Metall-Ion und Salz-Ion vorliegen. Ein Metallsalz-haltiges Medium kann neben Metallsalz eine Lösung aufweisen, welche z.B. wässrig oder sauer sein kann, in welcher das Metallsalz gelöst ist. Beispielsweise kann das Medium neben Wasser auch Salzsäure und/oder Schwefelsäure aufweisen. In einem Beispiel stammt das Metallsalz-haltige Medium aus der Herstellung von Leiterplatten und/oder Substraten und kann entsprechende Rückstände aufweisen. Ferner kann das Metallsalz-haltige Medium aufbereitet sein, so dass im Wesentlichen nur das Metallsalz vorliegt. In einem Beispiel ist das Metallsalz-haltige Medium (im Wesentlichen) frei von (unerwünschtem) Fremdmetall (wie z.B. Eisen). In einem weiteren Beispiel weist das Metallsalz-haltige Medium (Reste von) Fremdmetall auf.

Im Rahmen dieses Dokuments kann unter dem Begriff "Wertstoffkreislauf" insbesondere verstanden werden, dass eine Mehrzahl von Wertstoffen (also Stoffen, welche für das Herstellungsverfahren benötigt werden, z.B. Hauptkomponenten und/oder Ausgangsmaterialien/Rohstoffe) innerhalb eines Herstellungsprozesses (bzw. einer Industrieanlage) stetig (bzw. kontinuierlich) recycelt wird. Insbesondere wird eine Mehrzahl von Wertstoffen aus einzelnen Prozessschritten aufbereitet und/oder rückgewonnen, um wieder den einzelnen Prozessschritten zugeführt zu werden. Die Wertstoffe verlassen einen Prozessschritt als Bestandteil eines Abfall-Mediums bzw. als anfallender Rückstand, können aber nach einer Prozess-internen Aufbereitung wieder innerhalb des Prozesses rückgeführt werden. Wertstoffe können z.B. Schwermetalle wie Kupfer, Nickel, Gold usw. umfassen. Diese können in verschiedenen Prozessschritten innerhalb von Metallsalz-haltigen Medien anfallen. Die anfallenden Rückstände können in Teilströmen geleitet werden (bzw. der Fluss eines Mediums kann gezielt gesteuert werden) und zumindest teilweise gemeinsam aufbereitet werden, so dass die Wertstoffe rückgewonnen werden können. Aus den Teilströmen, welche letztlich (insbesondere über das Aufbereiten eines Gesamtstroms) den einzelnen Prozessschritten rückgeführt werden, können Abtrennströme separiert werden, welche wiederum zu einzelnen Prozessschritten rückgeführt werden können und/oder über Aufbereitungen wie Aufkonzentrierung (bzw. Einstellen der Konzentration) wieder den Teilströmen zugeführt werden können.

In diesem Dokument kann unter dem Begriff "Schwermetall" insbesondere ein Metall verstanden werden, welches eine Dichte größer als 5,0 g/cm³ (alternativ größer als 4,5 g/cm³) aufweist. Hierzu zählen z.B. Kupfer, Nickel, Cobalt, Gold, Silber, Palladium, Wolfram, Zinn, Zink, Eisen, Blei, Chrom, Rhodium, Cadmium, etc. Nicht als Schwermetall bezeichnet werden nach dieser Definition z.B. Aluminium, Silizium, Natrium, Kalium, Calcium, Magnesium, etc.

Im Rahmen dieses Dokuments kann der Begriff "im Wesentlichen" derart ausgelegt werden, dass vernachlässigbare Rückstände bzw. Verschmutzungen umfasst sein können, welche nicht mehr über vertretbaren Aufwand entfernbar sind. Diese vernachlässigbaren Rückstände bzw. Verschmutzungen sind in einem Ausführungsbeispiel (bewusst) nicht erwünscht, lassen sich aber auch mit vernünftigem Aufwand nicht mehr entfernen. Beispielsweise kann ein Medium in Einleitqualität im Wesentlichen frei von Schwermetall sein, was derart verstanden werden soll, dass vernachlässigbare Rückstände bzw. Verschmutzungen (z.B. im unteren Prozent-, Promille-, oder sogar ppm-Bereich) vorhanden sein können. Der Fachmann versteht, dass, obwohl diese Rückstände bzw. Verschmutzungen nicht erwünscht sind, sie aber nicht mehr auf Aufwand-technisch vertretbare Weise separiert werden können.

Im Rahmen dieses Dokuments kann unter dem Begriff "Medium in Einleitqualität" insbesondere ein (flüssiges) Medium verstanden werden, welches unter Einhaltung gesetzlicher Normen bzw. Grenzwerte in eine Kläranlage und/oder ein Gewässer eingeleitet werden darf. In einem Beispiel weist das Medium in Einleitqualität (im Wesentlichen) keine Hauptkomponenten der Leiterplatten/Substrat-Herstellung mehr auf, sondern besteht lediglich aus Wasser, (Nicht-Schwermetall) Salzen, und (eventuell) organischem Material. In einem bevorzugten Ausführungsbeispiel weist das Medium in Einleitqualität (im Wesentlichen) kein Schwermetall mehr auf. Ein Medium in Einleitqualität kann organische Reste aufweisen, welche in Kläranlagen oder z.B. mittels eines Aktivkohlefilters entfernt werden können.

Im Rahmen dieses Dokuments kann unter dem Begriff "Teilstrom" insbesondere verstanden werden, dass ein Medium (insbesondere ein flüssiges Medium) innerhalb eines (Herstellungs-) Prozesses in einer bestimmten (erwünschten) Prozessrichtung geleitet wird. In anderen Worten kann der Fluss eines Mediums innerhalb eines (Herstellungs-) Prozesses auf erwünschte Weise gesteuert werden. Der Begriff "Teilstrom" kann sich hierbei insbesondere darauf beziehen, dass der entsprechende (Herstellungs-) Prozess zumindest zwei solcher Ströme (aus verschiedenen Prozessschritten) aufweist. Hierbei kann jeder einzelne Strom (von bevorzugt flüssigem Medium) innerhalb desselben (Herstellungs-) Prozesses bzw. derselben Industrieanlage als Teilstrom bezeichnet werden. Bei den Teilströmen kann es sich um (gezielt) gesteuerte Flüsse von Abfall-Medien der Produktion handeln. Zumindest zwei (insbesondere drei oder mehr) dieser Teilströme können zu einem Gesamtstrom vereinigt werden. In einem Ausführungsbeispiel weist ein erster Teilstrom ein aufbereitetes Metallsalz-haltiges Medium (z.B. Kupfersulfat und Salzsäure aufweisend) bzw. einen Abfallstrom aus einem Ätzprozess der Leiterplatten- und/oder Substrat-Herstellung auf, während ein zweiter Teilstrom ein aufbereitetes Metallsalz-haltiges Medium (z.B. Kupfersulfat, Eisensulfat und Schwefelsäure aufweisend) bzw. einen Abfallstrom aus einem Galvanikprozess der Leiterplatten- und/oder Substrat-Herstellung aufweist. Diese können in einem Beispiel zu einem Gesamtstrom zusammengeleitet werden, welcher dann aufbereitet wird, z.B. um das Metall des Metallsalzes in elementarer Form rückzugewinnen.

Im Rahmen dieses Dokuments kann unter dem Begriff "Leiterplatten- und/oder Substrat-Herstellung" insbesondere ein Prozess verstanden werden zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Eine Leiterplatten- und/oder Substrat-Herstellung umfasst gewöhnlich einen Ätzprozess, in welchem Metall mittels Ätzens derart entfernt wird, dass erwünschte Metallstrukturen erhalten werden, und einen Galvanisierungsprozess, in welchem Metall mittels Galvanisierens (plating) aufgetragen wird. Ausgangsmaterial für eine Leiterplatten- und/oder Substrat-Herstellung umfasst im Wesentlichen das Metall sowie elektrisch isolierendes Material, meist ein organisches Material wie ein Harz. Das Produkt des Prozesses kann die fertige Leiterplatte bzw. das Substrat sein, oder auch ein Zwischenprodukt.

In diesem Dokument kann unter dem Begriff "Ätzprozess" insbesondere ein Prozess der Leiterplatten- und/oder Substrat-Herstellung bezeichnet werden, welcher das Ätzen von Metall, insbesondere Kupfer, aufweist, um dadurch eine erwünschte metallische (elektrisch leitfähige) Struktur bereitzustellen. Gemäß einem exemplarischen Ausführungsbeispiel kann dieser Prozess wie folgt durchgeführt werden: ein Fotolack schützt Kupferpfade, die nicht weggeätzt werden sollen, während Kupferflächen, welche weggeätzt werden sollen, nicht mit dem Fotolack bedeckt sind. Zunächst wird hierzu die gesamte Kupferlage mit Fotolack überzogen. Dann wird durch eine Maske hinweg der Fotolack mittels UV-Licht entwickelt. Die Maske lässt nur an Stellen UV-Licht durch, an welchen der Fotolack bestehen bleiben soll (i.e. wo die erwünschten Leiterzüge bereitgestellt werden sollen). Während des Entwickelns vernetzt der Lack (bzw. das Polymer) an diesen Stellen, die mit UV-Licht belichtet wurden. Nach dem Entwickeln kann der Fotolack, welcher nicht belichtet wurde (bzw. nicht entwickelt wurde) einfach herunter gewaschen werden. Anschließend wird das Panel (bzw. die Komponententräger Vorform) geätzt. Der Fotolack schützt dabei die Leiterzüge während das Kupfer, welches nicht mit Fotolack bedeckt ist, geätzt/entfernt wird. Wenn der Ätzvorgang vorüber ist, wird der Fotolack entfernt bzw. abgezogen (der Lack ist vernetzt und fest) und die Leiterbahnen bleiben übrig. Der gestrippte Fotolack kann zu einem späteren Zeitpunkt mittels Eisenchlorid gefällt werden.

Im Rahmen dieses Dokuments kann unter dem Begriff "Galvanisierungsprozess" insbesondere ein Prozess innerhalb einer Leiterplatten- und/oder Substrat-Herstellung verstanden werden, bei welchem ein Galvanisieren (englisch: plating) durchgeführt wird. Unter Galvanisieren kann man die elektrochemische Abscheidung metallischer Niederschläge auf Vorrichtungen bezeichnen. Als Vorrichtung dient eine Leiterplatte und/oder ein Substrat, auf welcher der metallische Niederschlag (z.B. Kupfer) z.B. als elektrisch leitfähige Schichtstruktur bzw. Leiterbahn dienen kann. Ferner können z.B. Löcher (Vias) elektrisch leitfähig gemacht werden, indem diese seitlich galvanisiert werden oder mittels Galvanisierung komplett gefüllt werden. In einem Beispiel wird an einem elektrolytischen Bad ein Strom angelegt. Am Pluspol (Anode) befindet sich das Metall, das aufgebracht werden soll (z.B. Kupfer oder Nickel), am Minuspol (Kathode) der zu beschichtende Gegenstand (z.B. eine Leiterplatte). Mittels des elektrischen Stroms lagern sich die Metallionen durch Reduktion auf dem Gegenstand ab. In einem Beispiel kann dieser Prozess als eine Abfolge von elektrolytischen Bädern realisiert werden. Der Galvanisierungsprozess kann hierbei kontinuierlich oder diskontinuierlich (Batch-weise) durchgeführt werden. Gewöhnlich fällt bei diesem Prozess eine Menge Metallsalz-haltigen Mediums als Abfallkonzentrat ("Bleed") an. Dieses enthält generell Prozess-bedingt Fremdmetall und einen hohen Säureanteil, so dass ein Recycling des Metalls (des Metallsalzes) bislang nicht in wirtschaftlicher Weise ermöglicht ist.

Im Rahmen dieses Dokuments kann unter dem Begriff "Prozesskontrollvorrichtung" insbesondere jegliche Vorrichtung (oder Mehrzahl an Vorrichtungen) verstanden werden, welche geeignet ist eine Prozesskontrolle vorzunehmen, wobei der Prozess (zumindest teilweise) eine Leiterplatten- und/oder Substrat-Herstellung betrifft. Insbesondere ist die Prozesskontrollvorrichtung eingerichtet (zumindest teilweise) einen Wertstoffkreislauf zu steuern bzw. zu regeln, bei welchem Rückstände der Produktion derart rückgeführt werden, dass im Wesentlichen keine (Schwermetall und/oder Säure) Abfälle anfallen. Die Prozesskontrollvorrichtung kann hierfür insbesondere eine Datenbank (-Einheit) und eine Datenmodell-Einheit aufweisen, wobei erstere ermittelte Prozessdaten speichert, während letztere vorgesehene erwünschte Prozessdaten speichert. Die Prozesskontrollvorrichtung kann mit einer Vielzahl von Sensoren bzw. Messgeräten gekoppelt sein, um auf diese Weise an verschiedenen Prozessstationen aktuelle Parameter zu bestimmen. Ferner kann die Prozesskontrollvorrichtung eine Berechnungsvorrichtung aufweisen, welche die ermittelten Parameter mit den erwünschten vergleicht und basierend hierauf eine Steueroperation bestimmt und durchführt. In einem bevorzugten Ausführungsbeispiel weist die Prozesskontrollvorrichtung einen selbstlernenden Algorithmus (AI) auf, mittels welchem das Steuern bzw. das Regeln des Prozesses stetig verbessert werden kann.

Im Kontext des vorliegenden Dokuments kann der Begriff "(gedruckte) Leiterplatte" (PCB) insbesondere einen im Wesentlichen plattenförmigen Komponententräger (dieser kann flexibel, rigide, oder semi-flexibel sein) bezeichnen, welcher gebildet wird, indem mehrere elektrisch leitfähige Schichtstrukturen mit mehreren elektrisch isolierenden Schichtstrukturen laminiert werden, beispielsweise indem Druck angelegt wird und/oder indem thermische Energie zugeführt wird. Als bevorzugte Materialien für die PCB Technologie sind die elektrisch leitfähigen Schichtstrukturen aus Kupfer, wohingegen die elektrisch isolierenden Schichtstrukturen Harz und/oder Glasfasern aufweisen können, sogenanntes Prepreg oder FR4 Material. Die verschiedenen elektrisch leitfähigen Schichtstrukturen können miteinander auf gewünschte Weise verbunden werden, indem Durchgangsöffnungen durch das Laminat gebildet werden, beispielsweise mittels Laserbohrens oder mechanischen Bohrens, und indem diese mit elektrisch leitfähigem Material (insbesondere Kupfer) gefüllt werden, wobei dadurch Vias als Durchgangsöffnung Verbindungen gebildet werden. Neben einer oder mehreren Komponenten, welche in eine gedruckte Leiterplatte eingebettet sein können, ist eine gedruckte Leiterplatte typischerweise konfiguriert zum Aufnehmen von einer oder mehreren Komponenten auf einer oder beiden entgegengesetzten Oberflächen der plattenförmigen gedruckten Leiterplatte. Sie können mit der entsprechenden Hauptoberfläche mittels Lötens verbunden werden. Auch können diese Komponenten eingebettet werden. Ein dielektrischer Teil einer PCB kann Harz mit verstärkenden Strukturen (beispielsweise Glasfasern oder Glaskugeln) umfassen.

Im Kontext des vorliegenden Dokuments kann der Begriff "Substrat" insbesondere einen kleinen Komponententräger bezeichnen, welcher im Wesentlichen dieselbe Größe wie eine Komponente hat (insbesondere einer elektronischen Komponente), welche darauf zu montieren ist (wie bei einem Chip Scale Package (CSP)). Insbesondere kann unter einem Substrat ein Träger für elektrische Verbindungen oder elektrische Netzwerke oder auch ein Komponententräger verstanden werden, welcher mit einer gedruckten Leiterplatte (PCB) vergleichbar ist, allerdings mit einer beträchtlich höheren Dichte von seitlich und/oder vertikal angeordneten Verbindungen. Seitliche Verbindungen sind beispielsweise leitfähige Pfade, wohingegen vertikale Verbindungen beispielsweise Bohrlöcher sein können. Diese seitlichen und/oder vertikalen Verbindungen sind in dem Substrat angeordnet und können verwendet werden, um elektrische und/oder mechanische Verbindungen von gehäusten Komponenten oder ungehäusten Komponenten (beispielsweise Dies) bereitzustellen, insbesondere von IC Chips mit einer gedruckten Leiterplatte oder einer Zwischen-gedruckten Leiterplatte. Somit enthält der Begriff "Substrat" auch "IC Substrate". Ein dielektrischer Teil eines Substrats kann Harz mit verstärkenden Partikeln (beispielsweise verstärkende Kugeln, insbesondere Glaskugeln) umfassen.

Das Substrat oder der Interposer kann aus zumindest einer Glas-Schicht (Silizium (Si)) oder einer fotostrukturierbaren, oder einer trockenätzbaren organischen Schicht bestehen. Als organisches Material/organische Schicht kann beispielsweise ein Epoxid-basiertes Aufbaumaterial (beispielsweise Epoxidbasierter Aufbaufolie) oder Polymerverbindungen wie Polyimid, Polybenzoxazol oder Benzocyclobuten-funktionalisierten Polymeren herangezogen werden.

In einer Ausführungsform ist der Komponententräger ein Laminat-Typ Komponententräger. In einer derartigen Ausführungsform ist der Komponententräger ein Verbund aus mehreren Schichtstrukturen, welche gestapelt sind und miteinander verbunden sind, indem eine Presskraft und/oder Wärme aufgebracht wird.

In einer Ausführungsform weist zumindest eine der elektrisch leitfähigen Schichtstrukturen zumindest eines aus der Gruppe auf bestehend aus Kupfer, Aluminium, Nickel, Silber, Gold, Palladium, Magnesium, und Wolfram. Obwohl Kupfer typischerweise bevorzugt ist, sind auch andere Materialien oder beschichtete Versionen davon möglich, insbesondere beschichtet mit einem supra-leitfähigen Material wie beispielsweise Graphen.

Gemäß einem exemplarischen Ausführungsbeispiel kann die Erfindung auf der Idee basieren, dass anfallende Rückstände der Leiterplatten- und/oder Substrat-Herstellung in Teilströmen derart in einem Wertstoffkreislauf transportiert und rückgeführt werden können, dass im Betriebszustand des Verfahrens zum Herstellen von Leiterplatten und/oder Substraten als Abfall (im Wesentlichen) letztlich nur ein Medium in Einleitqualität (insbesondere in Kläranlagen oder Gewässer) anfällt.

Konventionell werden Abfälle und Abfallkonzentrate (reich an Metallsalzen und Säuren) aus der Leiterplatten- und/oder Substrat-Herstellung auf kostenintensive und wenig umweltfreundliche bzw. nachhaltige Weise entsorgt. Die Abfälle fallen in verschiedenen Prozessschritten, wie z.B. Ätzprozess, Galvanikprozess, und Spülprozess, an, und werden jeweils einzeln aufwendig entsorgt. Dies auch deswegen, weil jeder der Abfallströme eine andere Zusammensetzung aufweist, und daher auf verschiedene Weise abgeführt werden muss. Diese Medien sind zudem gewöhnlich sehr sauer und damit prädestiniert dafür, als Sondermüll aufwendig entsorgt zu werden. Eine (für ein Recycling zwingend notwendige) qualitativ hochwertige Rückgewinnung erscheint daher nicht auf Kosten-effiziente Weise ermöglicht.

Der beschriebene Prozess sieht nun einen vollständigen Paradigmenwechsel gegenüber dem Stand der Technik vor und zeigt, dass ein kostengünstiges, umweltfreundliches, und nachhaltiges Betreiben eines Verfahrens zum Herstellen von Leiterplatten und/oder Substraten unter Realisierung eines Wertstoffkreislaufs auf effiziente und robuste Weise ermöglicht ist.

In einem exemplarischen Ausführungsbeispiel wird das Verfahren zum Herstellen von Leiterplatten und/oder Substraten derart betrieben, dass die anfallenden (Prozess) Rückstände in drei hauptsächlichen Teilströmen (und insbesondere zumindest teilweise als Gesamtstrom) und drei hauptsächlichen Abtrennströmen (welche insbesondere Säure-Rückstände aufweisen) derart in einem Wertstoffkreislauf geleitet und rückgeführt (bzw. recycelt) werden, dass in dem Betriebszustand des Herstellungsverfahrens als Abfall (im Wesentlichen) nur ein Medium in Einleitqualität anfällt. In anderen Worten weist das Medium in Einleitqualität (im Wesentlichen) keine Hauptkomponenten (insbesondere kein Schwermetall) der Leiterplatten/Substrat-Herstellung mehr auf, sondern besteht lediglich aus Wasser, Salzen, und organischem Material. Dem Herstellungsverfahren müssen im Betriebszustand (im Wesentlichen) also nur Wasser und Energie zugeführt werden (anfallende Säure-Rückstände werden (im Wesentlichen) ebenfalls in dem Wertstoffkreislauf rückgeführt). Im Wesentlichen werden dem Herstellungsverfahren also nur solche Hauptkomponenten (insbesondere Schwermetall wie Kupfer) zugeführt, welche als Bestandteil einer fertigen gedruckten Leiterplatte und/oder eines Substrats das Herstellungsverfahren wieder verlassen. Daher werden dem Herstellungsverfahren (im Wesentlichen) keine Hauptkomponenten zugegeben, welche als Abfall das Herstellungsverfahren verlassen haben. Tatsächlich fällt ein solcher Abfall (im Wesentlichen) prinzipiell nicht an.

Gemäß einem Ausführungsbeispiel weist das Medium in Einleitqualität (im Wesentlichen) keine Hauptkomponenten der Leiterplatten- und/oder Substrat-Herstellung (insbesondere kein Schwermetall) auf. Dies kann den Vorteil haben, dass eine aufwendige Entsorgung der Schwermetalle entfällt und das Medium in Kläranlagen/Gewässer eingeleitet werden kann.

Gemäß einem weiteren Ausführungsbeispiel weist die Konzentration an Schwermetall in dem Medium in Einleitqualität 15 mg/L oder weniger auf, insbesondere weist die Konzentration an Kupfer in dem Medium in Einleitqualität 0,5 mg/L oder weniger auf (und liegt damit z.B. innerhalb der gesetzlichen Grenzwerte der Republik Österreich). Dies kann den Vorteil haben, dass das Medium in Einleitqualität im Wesentlichen Schwermetall-frei ist und in Kläranlagen/Gewässer einleitbar ist.

Gemäß einem weiteren Ausführungsbeispiel weist das Medium (im Wesentlichen) Wasser, Salze, und Organik auf, insbesondere besteht das Medium hieraus. Dies kann ebenfalls den Vorteil haben, dass das Medium in Einleitqualität im Wesentlichen Schwermetall-frei ist und in Kläranlagen/Gewässer einleitbar ist.

Gemäß einem weiteren Ausführungsbeispiel bezieht sich die Einleitqualität darauf, dass das Medium unter Einhaltung gesetzlicher Grenzwerte und/oder Normen in Kläranlagen einleitbar ist. Zusätzlich oder alternativ bezieht sich die Einleitqualität darauf, dass das Medium unter Einhaltung gesetzlicher Grenzwerte und/oder Normen in Gewässer einleitbar ist.

Gemäß einem weiteren Ausführungsbeispiel wird dem Herstellungsverfahren im Betriebszustand (im Wesentlichen) nur Wasser und Energie zugeführt. Insbesondere werden anfallende Säuren ebenfalls in dem Wertstoffkreislauf rückgeführt. Dadurch kann ein besonders effizienter und Ressourcen-sparender Recycling Kreislauf bereitgestellt werden.

Gemäß einem weiteren Ausführungsbeispiel weist das Verfahren ferner auf: Aufreinigen des Mediums in Einleitqualität derart, dass das Medium in Gewässer einleitbar ist. Insbesondere wird das Aufreinigen derart durchgeführt, dass der CSB-Wert, als Maß für die Konzentration organischer Verbindungen, 300 mg/L, insbesondere 75 mg/L, oder weniger beträgt. Dies kann den Vorteil haben, dass eine besonders einfache und flexible Entsorgung ermöglicht ist.

In einem Ausführungsbeispiel wird das Abwasser Medium in Einleitqualität derart aufgereinigt (z.B. in einer Prozess-internen Kläranlage), dass das Medium in Gewässer einleitbar ist. Diese Aufreinigung bezieht sich nicht auf Schwermetalle (welche bereits derart entfernt sind, dass das Medium Einleitqualität in Kläranlagen aufweist), sondern auf Organik-Reste. Diese können z.B. über Aktivkohlefilter einfach entfernt werden. Beispielsweise kann nach dem Aufreinigen der CSB (chemischer Sauerstoffbedarf)-Wert, als Maß für die Konzentration organischer Verbindungen, in dem Medium in Einleitqualität weniger als 300 mg/L, insbesondere weniger als 75 mg/L (weiter insbesondere weniger als 65 mg/L), betragen. Der CSB Wert kann hierbei die Menge an Sauerstoff (in mg/L) angeben, die zu der Oxidation der oxidierbaren Stoffe benötigt würde, wenn Sauerstoff das Oxidationsmittel wäre. Beispielsweise in Österreich liegt dieser Grenzwert per Gesetz bei 75 mg/L. Der CSB-Grenzwert für Kläranlagen kann stark variieren, und beträgt in einem Beispiel 300 mg/L.

Gemäß einem weiteren Ausführungsbeispiel werden dem Herstellungsverfahren im Betriebszustand (im Wesentlichen) nur Hauptkomponenten der Leiterplatten- und/oder Substrat-Herstellung zugeführt, um Hauptkomponenten zu ersetzen, welche das Herstellungsverfahren als Bestandteil einer Leiterplatte und/oder eines Substrats verlassen haben. Ungeachtet des Merkmals, dass dem Wertstoffkreislauf (im Wesentlichen) nur Wasser und Energie neu zugeführt werden müssen, werden Materialien von außen (Prozess-extern) ergänzt, welche sozusagen im Prozess "verbaut und/oder verbraucht werden". Verbaute und/oder verbrauchte Hauptkomponenten wie Kupfer (nachdem damit Leiterbahnen auf Leiterplatten bereitgestellt wurden) (oder z.B. auch Fotolacke, Lötpasten, einige Säuren, Basen) müssen dem Kreislauf selbstverständlich erneut zugeführt werden.

Gemäß einem weiteren Ausführungsbeispiel werden dem Herstellungsverfahren im Betriebszustand (im Wesentlichen) keine Hauptkomponenten der Leiterplatten- und/oder Substrat-Herstellung zugeführt, um Hauptkomponenten zu ersetzen, welche das Herstellungsverfahren als Bestandteil eines Abwassers verlassen haben. Anders als oben für verbaute Materialien beschrieben, kann der Wertstoffkreislauf derart implementiert werden, dass (im Wesentlichen) keine Hauptkomponenten den Prozess als Abfallprodukte verlassen. Daraus folgt, dass diese Hauptkomponenten auch nicht von außen (Prozess-extern) ersetzt werden müssen, weil sie in dem Recycling Kreislauf verbleiben.

Gemäß einem weiteren Ausführungsbeispiel ist eine Hauptkomponente der Leiterplatten- und/oder Substrat-Herstellung Metall, insbesondere Schwermetall, weiter insbesondere zumindest eines aus der Gruppe, welche besteht aus Kupfer, Eisen, Nickel, Gold, Silber, Palladium, Zinn. Dadurch kann sich der Vorteil ergeben, dass zugleich die hohen Kosten für Rohmaterialien gespart werden können und die aufwendige Entsorgung entfällt.

Gemäß einem weiteren Ausführungsbeispiel weisen die anfallenden Rückstände zumindest eines aus der Gruppe auf, welche besteht aus: Schwermetall, insbesondere Kupfer und/oder Eisen, Metallsulfat, Metallchlorid, Salzsäure, Schwefelsäure. Dies hat den Vorteil, dass Materialien, welche während des Herstellungsprozesses in großen Mengen (Volumina) anfallen, innerhalb des Wertstoffkreislaufes recycelt und rückgeführt werde können.

Gemäß einem weiteren Ausführungsbeispiel werden in dem Wertstoffkreislauf 90% oder mehr, insbesondere 95% oder mehr, weiter insbesondere 98% oder mehr, der Schwermetall Rückstände, insbesondere der Kupfer Rückstände, rückgeführt.

Gemäß einem weiteren Ausführungsbeispiel werden in dem Wertstoffkreislauf mindestens 80% der abgetrennten Salzsäure rückgeführt, und insbesondere mindestens 70% der benötigten Schwefelsäure können Verfahrens-intern produziert werden.

Gemäß einem weiteren Ausführungsbeispiel weisen die Teilströme zumindest einen der folgenden Merkmale auf: i) erster Teilstrom aus einem Ätzprozess der Leiterplatten- und/oder Substrat-Herstellung, ii) ein zweiter Teilstrom aus einem Galvanisierungsprozess der Leiterplatten- und/oder Substrat-Herstellung, iii) ein dritter Teilstrom aus Spülwasser und/oder Restwasser der Leiterplatten- und/oder Substrat-Herstellung.

Gemäß einem weiteren Ausführungsbeispiel weist der erste Teilstrom ein erstes aufbereitetes Metallsalz-haltiges Medium aus einem Ätzprozess der Leiterplatten- und/oder Substrat-Herstellung auf, welches in einem ersten Aufbereitungsprozess aufbereitet wird. Insbesondere ist das aufbereitete Metallsalz-haltige Medium (im Wesentlichen) frei von aufzubereitendem Metallsalz. Dies kann den Vorteil haben, dass ein Abfallmedium aus dem Ätzprozess, welches Prozess-bedingt einen hohen Säureanteil aufweist, effizient und sicher innerhalb eines Gesamtstroms aufbereitet werden kann. Beispielsweise kann ein Metallchlorid in ein Metallsulfat (oder Metallnitrat oder Metallphosphat) umgewandelt werden, welches sicher und ohne unerwünschte Nebeneffekte aufbereitet werden kann.

Gemäß einem exemplarischen Beispiel fällt aus dem Ätzprozess als aufzubereitendes Medium Kupfer in Form von Kupferchlorid (als aufzubereitendes Metallsalz) und Salzsäure als Säure an. Der hohe Anteil an Chlorid-Ionen begünstigt während eines Rückgewinnes, z.B. einer Elektrolyse, die unkontrollierbare Bildung von Chlorgas. Zusätzlich können sich Chlorid-Ionen an der Elektrolyse-Elektrode mit abscheiden, wodurch die Reinheit des abgeschiedenen Kupfers negativ beeinflusst wird.

Gemäß einem weiteren Ausführungsbeispiel wird das erste aufbereitete Metallsalz-haltige Medium aus einem aufzubereitenden Medium erhalten, welches ein aufzubereitendes Metallsalz (insbesondere Kupferchlorid) und eine Säure aufweist, unter Verwenden eines mehrstufigen Entfernens (insbesondere genau zwei Stufen) der Säure mittels Membrandialyse und Durchführen einer chemischen Reaktion (insbesondere Umsalzen). Insbesondere weist das Umsalzen ein Umwandeln des aufzubereitenden Metallsalzes in das Metallsalz mittels Zugebens einer weiteren Säure auf. Weiter insbesondere weist die weitere Säure zumindest eine aus der Gruppe auf, welche besteht aus: Schwefelsäure (H₂SO₄), Salzsäure (HCl), Salpetersäure (HNO₃), Phosphorsäure (H₃PO₄). Dies kann den Vorteil haben, dass auf flexible Weise eine Vielzahl aufzubereitender Metallsalze Prozess-intern in erwünschte Metallsalze umgewandelt werden können.

Bei dem Umsalzen kommt es zur Erzeugung von Säure (insbesondere Salzsäure) in dem nun vorliegenden Metallsalz-haltigen Medium. In einem exemplarischen Ausführungsbeispiel reagieren Kupferchlorid (als aufzubereitendes Metallsalz) und Schwefelsäure (als weitere Säure) aus dem Ätzprozess zu Kupfersulfat (Metallsalz) und Salzsäure. Sowohl ein Entfernen der Salzsäure als auch zumindest ein Teil der chemischen Reaktion werden mittels einer weiteren Membrandialyse durchgeführt.

Gemäß einem Ausführungsbeispiel weisen das Metallsalz (des Metallsalz-haltigen Mediums) und das aufzubereitende Metallsalz (des aufzubereitenden Mediums) zumindest ein Metall aus der Gruppe auf, welche besteht aus: Kupfer, Nickel, Cobalt, Zinn, Cadmium, Magnesium, Natrium. Gemäß einem weiteren Ausführungsbeispiel weist das aufzubereitende Metallsalz ein Metallchlorid (insbesondere Kupferchlorid, CuCl₂) auf. Gemäß einem weiteren Ausführungsbeispiel weist das Metallsalz ein Metallsulfat (insbesondere Kupfersulfat, CuSO₄) auf. Gemäß einem weiteren Ausführungsbeispiel weist die Säure Salzsäure, HCl, auf.

Gemäß einem weiteren Ausführungsbeispiel ist die chemische Reaktion eine exotherme Reaktion und das Verfahren weist ferner auf: Ableiten von (zumindest einem Teil) der Reaktionswärme derart, dass ein flüssiges Medium (insbesondere ein flüssiges Medium in einem Versorgungsbecken oder Elektrolysebecken) innerhalb derselben Leiterplatten- und/oder Substrat-Herstellung erwärmt wird. Dies kann den besonderen Vorteil bereitstellen, dass für den Leiterplatten- und/oder Substrat-Herstellungsprozess benötigte Energie direkt Prozess-intern produziert und bereitgestellt werden kann.

In einem Ausführungsbeispiel hat es sich herausgestellt, dass die oben beschriebene chemische Reaktion (insbesondere Kupferchlorid zu Kupfersulfat) stark exotherm ist, so dass dadurch entstehende Abwärme zusätzlich als Energiequelle genutzt werden kann. In einem exemplarischen Beispiel können auf diese Weise 800 kW pro Tag durch die chemische (exotherme) Reaktion bereitgestellt werden. Diese Energie kann wiederum direkt eingesetzt (abgeleitet bzw. umgeleitet) werden, um ein flüssiges Medium (z.B. in einem Versorgungsbecken oder einem Elektrolysebecken einer Reaktionszelle) innerhalb ein und desselben Leiterplatten- und/oder Substrat-Herstellungsprozesses zu erwärmen/heizen. Überraschenderweise hat sich also gezeigt, dass dem Wertstoffkreislauf weniger Energie hinzugeführt werden muss, weil eine exotherme, Prozess-interne Reaktion als effiziente Energiequelle verwendet werden kann.

Gemäß einem weiteren Ausführungsbeispiel weist ein zweiter Teilstrom ein zweites aufbereitetes Metallsalz-haltiges Medium aus einem Galvanisierungsprozess der Leiterplatten- und/oder Substrat-Herstellung auf, welches in einem zweiten Aufbereitungsprozess aufbereitet wird. Insbesondere ist das aufbereitete Metallsalz-haltige Medium (im Wesentlichen) frei von Fremdmetall. Weiter insbesondere weist das Fremdmetall zumindest eines aus der Gruppe, welche besteht aus: Eisen, Blei, Zinn, Molybdän, Nickel, Kobalt, Indium, Cadmium, Zink, Chrom, Natrium, Palladium. Dies kann den Vorteil haben, dass ein Abfallmedium aus dem Galvanikprozess, welches Prozess-bedingt einen hohen Anteil von Säure und Fremdmetall aufweist, effizient und sicher aufbereitet werden kann.

Insbesondere stören Fremdmetalle wie Eisen erheblich eine qualitativ hochwertige Elektrolyse. Durch eine entsprechende Aufbereitung kann diese Problematik überwunden werden. Zudem können Metalle, welche zunächst als störend angesehen werden, in abgetrennter Form wieder zu interessanten Rohstoffen werden. Somit kann ein Abwasser aus der Galvanisierung umfunktioniert werden in ein Rohstofflager wirtschaftlich bedeutender Metalle. In einem Ausführungsbeispiel liegt das Fremdmetall (zumindest teilweise) als Fremdmetallsalz vor.

Gemäß einem weiteren Ausführungsbeispiel wird das zweite aufbereitete Metallsalz-haltige Medium aus einem Fremdmetall- und Metallsalz-haltigen Medium erhalten unter Verwenden eines Separierens des Fremdmetalls, insbesondere Eisen, aus dem Fremdmetall- und Metallsalz-haltigen Medium. Dies insbesondere mittels eines Ionentauschers, welcher ein selektives Ionenaustauschharz, weiter insbesondere ein doppel-funktionalisiertes Ionenaustauschharz, aufweist. Dies kann den Vorteil bringen, dass ein besonders effektives und selektives Separieren ermöglicht ist.

Im Rahmen dieses Dokuments kann der Begriff "Ionentauscher" insbesondere Materialien (bzw. Vorrichtungen) umfassen, mit denen gelöste Ionen durch andere Ionen gleicher Ladung (positiv oder negativ) ersetzt werden können. Ionentauscher können z.B. als Säulen, die mit einem Ionenaustauschmaterial gefüllt sind, oder als Membranen realisiert werden, welche mit einer Lösung durchströmt werden. Die auszutauschenden Ionen werden am Ionenaustauschmaterial gebunden bzw. adsorbiert. In einem Beispiel weist ein Ionentauscher ein selektives Ionenaustauschharz, weiter insbesondere ein doppel-funktionalisiertes Ionenaustauschharz, auf.

In einem Ausführungsbeispiel weist das Trägermaterial des Ionenaustauschharzes des Ionentauscher Polystyrol auf. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Fremdmetall leichter vom Harz desorbiert werden.

Gemäß einem Ausführungsbeispiel hat es sich überraschend herausgestellt, dass gerade das Verwenden eines speziellen Ionenaustauschharzes mit zwei funktionellen Gruppen eine (effiziente) Desorption des Fremdmetalls (insbesondere Eisen) ermöglicht. Dies ist insbesondere deswegen beachtenswert, weil Ionenaustauschharze (insbesondere einfach-funktionalisierte) teilweise zu einer irreversiblen Adsorption des Fremdmetalls neigen. Insbesondere im Fall von Fe³⁺ wurde eine irreversible Adsorption beobachtet.

In einem exemplarischen Beispiel ist der Ionenaustauscher zweistufig aufgebaut. Der nachgeschaltete (zweite) Ionenaustauscher nimmt den Metallrest des vorangeschalteten (zu beladenden) Ionenaustauschers auf. Weist der erste Ionentauscher einen erhöhten Metallrest auf, kann dieser regeneriert und anschließend an die nachgeschaltete (zweite) Stelle geschaltet werden.

Gemäß einem weiteren Ausführungsbeispiel ist das Fremdmetall- und Metallsalz-haltige Medium ein stark saures Medium. Insbesondere beträgt der pH-Wert weniger als 3, insbesondere weniger als 2, weiter insbesondere weniger als 1. Gemäß einem weiteren Ausführungsbeispiel weist das Fremdmetall- und Metallsalz-haltige Medium Schwefelsäure (H₂SO₄) auf. Dies insbesondere in einer Konzentration > 50 g/L, insbesondere > 150 g/L. Weiter insbesondere liegt die Konzentration in dem Bereich zwischen 100 und 200 g/L. Gemäß einem weiteren Ausführungsbeispiel weist das Metallsalz ein Metallsulfat (insbesondere Kupfersulfat, CuSO₄) auf. Gemäß einem weiteren Ausführungsbeispiel weist das Aufbereiten auf: Oxidieren des Fremdmetalls (insbesondere im Falle von Eisen von Fe²⁺ zu Fe³⁺) des Fremdmetall- und Metallsalz-haltigen Mediums.

Gemäß einem weiteren Ausführungsbeispiel weist ein dritter Teilstrom ein drittes aufbereitetes Metallsalz-haltiges Medium aus Spülwasser der Leiterplatten- und/oder Substrat-Herstellung auf, welches in einem dritten Aufbereitungsprozess aufbereitet wird. Insbesondere ist das Metallsalz in dem aufbereiteten Metallsalz-haltigen Medium im Vergleich zu dem Spülwasser aufkonzentriert. Dies kann den Vorteil haben, dass ein effizientes Recycling von Wertstoffen, trotz der eigentlich vernachlässigbar geringen Konzentration in Spülwässern, ermöglicht ist.

Das Spülwasser (bzw. Restwasser) kann in einem Beispiel nicht zweckdienlich als Metall-Rohstoffquelle eingesetzt werden, weil die Konzentrationen zu gering und/oder die Verschmutzungen zu hoch sind. Das aufzubereitende Spülwasser Medium kann durch Mischen einer Vielzahl von Spülwässern des Leiterplatten Herstellungsprozesses erhalten sein. Beispielsweise können Spülwässer aus verschiedenen Prozessschritten stammen wie Ätzprozess (als Diffusat), Galvanik (als Rückstand der Elektrolyse) oder aus einem Rückgewinnen von Metall. Hierbei können die Spülwässer über Abtrennströme einem einzigen Aufbereitungsprozess zugeführt werden. Das Spülwasser kann ein saures (insbesondere stark saures) Medium sein. Ferner kann das Spülwasser eine (geringe) Konzentration an Metallsalz aufweisen. Insbesondere kann das Metallsalz während eines Aufbereitens vorteilhaft aufkonzentriert werden.

Gemäß einem Ausführungsbeispiel weist das Regeneriermedium Schwefelsäure (H₂SO₄) auf. Insbesondere stammt die Schwefelsäure aus einem Prozess der Leiterplatten- und/oder Substrat-Herstellung, wie z.B. einem Galvanisierprozess und/oder einem Rückgewinnen mittels Elektrolyse. Gemäß einem weiteren Ausführungsbeispiel weist das Regeneriermedium eine hohe Säurekonzentration auf, insbesondere ≥ 200 g/L, weiter insbesondere ≥ 300 g/L, weiter insbesondere ≥ 400 g/L, weiter insbesondere ≥ 500 g/L (z.B. an Schwefelsäure). Gemäß einem weiteren Ausführungsbeispiel weist das Metall zumindest ein Metall aus der Gruppe auf, welche besteht aus: Kupfer, Nickel, Cobalt, Palladium, Rhodium, Zinn, Cadmium, Magnesium, Natrium, Eisen, Gold, Silber. Gemäß einem weiteren Ausführungsbeispiel liegt das Metall als Metallsalz vor (insbesondere als Metallsulfat, weiter insbesondere als Kupfersulfat).

Gemäß einem weiteren Ausführungsbeispiel wird das dritte aufbereitete Metallsalz-haltige Medium aus einem aufzubereitenden Medium erhalten unter Verwenden eines Ionentauschers (z.B. wie oben beschrieben). Dies kann den Vorteil haben, dass ein besonders effizientes Konzentrieren von Metall ermöglicht ist, während ein (im Wesentlichen) Schwermetall-freies Abwasser (insbesondere in Einleitqualität) erhalten wird.

Gemäß einem weiteren Ausführungsbeispiel wird ein Regenerieren des Ionentauschers mittels Strömens eines Regeneriermediums durch den Ionentauscher derart durchgeführt, dass das Metall zumindest teilweise in dem Regeneriermedium gelöst wird und ein Regenerat bereitgestellt wird. Insbesondere wobei das Regeneriermedium (zumindest teilweise) Verfahrens-intern erzeugt ist.

Auf diese Weise ist es z.B. ermöglicht, (im Wesentlichen) ein und dasselbe Regeneriermedium mehrmals durch den Ionentauscher laufen zu lassen, um ein (selektives) Aufkonzentrieren des Schwermetalls in dem Regeneriermedium zu erreichen. Daraus ergeben sich gleich zwei besondere Vorteile: i) das Spülwasser kann derart aufgereinigt werden, dass ein (im Wesentlichen) Schwermetall- und Säure-freies (bzw. gering Säure-haltiges Medium in Einleitqualität den Prozess verlässt, während ii) durch den Prozess des Schwermetall-Abtrennens ein- und dasselbe Regeneriermedium immer weiter (selektiv) an Schwermetall aufkonzentriert wird, wodurch ein derart (hoch-) konzentriertes (Metallsalz-haltiges) Medium erhalten wird, dass ein wirtschaftliches Rückgewinnen des Metalls (z.B. mittels Elektrolyse) ermöglicht ist. Alle diese Schritte können innerhalb ein- und desselben Leiterplatten- und/oder Substrat-Herstellungsprozesses durchgeführt werden (und somit einen geschlossenen Wertstoffkreislauf bereitstellen). Im Vergleich zu konventionellen Regeneriertechniken fällt zudem nur wenig flüssiges Medium an und es muss im Prinzip kein Wasser mehr aus dem Regenerat entfernt werden.

In einem Ausführungsbeispiel wird das Medium (im Wesentlichen) dadurch Säure-frei, dass Spülwässer neutralisiert werden. Das passiert z.B. in einem vorgeschalteten Vorbehandlungsbecken, in welchem die Ströme gesammelt und der pH-Wert angehoben wird. In einem exemplarischen Beispiel wird der pH-Wert lediglich auf z.B. 3 oder 5 angehoben, um Lauge zur Neutralisation zu sparen. Diese Neutralisation hat zugleich den Vorteil, dass der Ionentauscher effizienter Metall aufnehmen kann, denn Protonen der Säure verdrängen das adsorbierte Metall. Ferner können in dem Vorbehandlungsbecken das Redoxpotential eingestellt (Reduzieren von H₂O₂) und organische Verbindungen (Aktivkohlefilter) entfernt werden.

Gemäß einem weiteren Ausführungsbeispiel weist das Verfahren (insbesondere das Vorbehandeln des aufzubereitenden Mediums) auf: Entfernen von organischen Rückständen. Gemäß einem weiteren Ausführungsbeispiel ist ein organischer Filter (insbesondere ein Aktivkohlefilter) an das Vorbehandlungsbecken gekoppelt, um organische Bestandteile zu filtern. Dies kann den Vorteil bereitstellen, dass ein erwünschter CSB-Wert (und eine entsprechende Einleitqualität) erreicht werden kann.

Gemäß einem weiteren Ausführungsbeispiel weist das Verfahren auf: Vorbehandeln des aufzubereitenden Mediums. Insbesondere weist das Vorbehandeln auf: Einstellen des pH-Werts des aufzubereitenden Mediums, insbesondere mittels Natronlauge, auf einen Wert im Bereich 1 bis 3 (insbesondere im Wesentlichen 2) und/oder chemisches Reduzieren des aufzubereitenden Mediums mittels eines Reduktionsmittels (z.B. Bisulfit). Dies kann den Vorteil haben, dass ein Spülwasser bzw. eine Mischung aus inhomogenen Spülwässern, zunächst derart vorbehandelt wird, dass ein effizientes und robustes weiteres Aufbereiten, insbesondere Regenerieren, ermöglicht ist.

Gemäß einem weiteren Ausführungsbeispiel wird das Regenerat des Ionentauschers für ein oder mehr Regenerierschritte in dem Ionentauscher verwendet. Insbesondere steigt die Konzentration des Metalls in dem Regenerat mit jedem Regenerierschritt an. Dies kann den Vorteil haben, dass Material gespart werden kann, während zugleich eine Aufkonzentrierung in dem Regenerat stattfindet und Abfall reduziert wird.

Gemäß einem weiteren Ausführungsbeispiel wird das Aufbereiten kontinuierlich betrieben. Dies kann den Vorteil haben, dass ein kontinuierliches Aufkonzentrieren des aufzubereitenden Mediums stattfindet bzw. dass der Ionentauscher besonders effizient regeneriert werden kann.

Gemäß einem weiteren Ausführungsbeispiel weist der dritte Aufbereitungsprozess auf: i) Beladen (insbesondere mehrfaches Beladen bzw. Einsetzen mehrerer Ionentauscher) des Ionentauschers mit dem Metallsalz-haltigen Medium aus Spülwasser der Leiterplatten- und/oder Substrat-Herstellung derart, dass das Metall zumindest teilweise an dem Ionentaucher verbleibt, und ii) Separieren des Mediums in Einleitqualität. Dies kann den Vorteil haben, dass Abfallkonzentrate (Metallsalz-haltige Medien) innerhalb des Wertstoffkreislaufes bereits derart abgereichert wurden, dass die verbleibenden Abtrennströme bzw. Spülwässer effizient von dem Schwermetall-Rest gereinigt werden können, wodurch Einleitqualität erreicht wird. Gleichzeitig werden die Schwermetall-Reste hierdurch aufkonzentriert, so dass diese ebenfalls innerhalb des Wertstoffkreislaufes rückgeführt werden können.

Gemäß einem weiteren Ausführungsbeispiel weist das Verfahren auf: Aufbereiten zumindest eines Teilstroms, wobei das Aufbereiten ferner aufweist: Rückgewinnen von elementarem Metall aus dem Metallsalz-haltigen Medium des Teilstroms in einer Reaktionszelle (insbesondere mittels Elektrolyse). Das elementare Metall (z.B. Kupfer) des Metallsalz-haltigen Mediums soll in der Reaktionszelle in (hoch) reiner Form rückgewonnen werden, um einem/dem Prozess zum Herstellen von Leiterplatten und/oder Substraten erneut zugeführt zu werden.

Im Rahmen dieses Dokuments kann mit dem Begriff "Reaktionszelle" insbesondere jeglicher Reaktor bezeichnet werden, welcher es ermöglicht aus einem Metallsalz-haltigen Medium das Metall des Metallsalzes in elementarer und hochreiner Form rückzugewinnen. Der Begriff "Rückgewinnen" kann hierbei insbesondere bezeichnen, dass das elementare Metall aus dem Metallsalz-haltigen Medium (zum Zwecke eines erneuten Verwendens) abgetrennt bzw. separiert wird. Ein Beispiel für eine Reaktionszelle kann eine Elektrolyse-Zelle sein. In einem Beispiel kann das Rückgewinnen als eine Abfolge von elektrolytischen Bädern realisiert werden. Das Rückgewinnen kann hierbei kontinuierlich oder diskontinuierlich (Batch-weise) durchgeführt werden.

Gemäß einem weiteren Ausführungsbeispiel weist das Verfahren ferner auf: Bereitstellen einer Fremdmetall-haltigen sauren Lösung aus dem Wertstoffkreislauf an einen weiteren Prozess bei der Leiterplatten- und/oder Substrat-Herstellung, insbesondere einen Prozess zum Fällen von Fotolack. Dies kann den Vorteil haben, dass (insbesondere auf kontinuierliche Weise) ohne Zusatzaufwand eine Produktion von (für die Leiterplatten- und/oder Substrat-Herstellung) benötigten Substanzen wie Eisenchlorid bereitgestellt ist. Die Fremdmetall-haltige Lösung kann somit ebenfalls innerhalb des Wertstoffkreislaufs (zumindest teilweise) rückgeführt werden.

Gemäß einem weiteren Ausführungsbeispiel weist das Fremdmetall Eisen auf, die saure Lösung weist Salzsäure, HCl, auf, und die Fremdmetall-haltige saure Lösung weist Eisenchlorid, FeCl₃, auf. In diesem exemplarischen Ausführungsbeispiel weist das Fremdmetall-haltige Dialysat Eisenchlorid auf (Eisen und Salzsäure). In diesem Sinne kann also das Aufbereiten eines Eisen- und Metallsalz-haltigen Mediums aus einem Galvanisierungsprozess zur Leiterplatten- und/oder Substrat-Herstellung als Ausgangsmaterial verwendet werden zur (bevorzugt kontinuierlichen) Produktion von Eisenchlorid für das Fällen von Polymer-basiertem Fotolack für die gedruckten Leiterplatten und/oder Substrate.

Gemäß einem weiteren Ausführungsbeispiel weist das Verfahren ferner auf: Rückführen des rückgewonnenen Metalls in das Herstellungsverfahren (insbesondere in einen Ätzprozess und/oder einen Galvanisierungsprozess) der Leiterplatten- und/oder Substrat-Herstellung. Dies kann den Vorteil haben, dass der Wertstoffkreislauf dadurch geschlossen wird, dass Hauptkomponenten der Herstellung (insbesondere Schwermetall) nach dem Aufbereiten (der vereinigten Teilströme) wieder als Rohstoffe bzw. Ausgangsstoffe eingesetzt werden.

Gemäß einem weiteren Ausführungsbeispiel weist die Berechnungsvorrichtung einen selbstlernenden Algorithmus (insbesondere mittels neuronaler Netzwerke) auf zum Vergleichen und/oder zum Bestimmen. Dies kann den Vorteil bereitstellen, dass die Prozesskontrollvorrichtung (zumindest teilweise) selbstständig arbeiten und sich basierend hierauf weiterentwickeln kann. Ein selbstlernender Algorithmus (maschinelles Lernen) kann ein künstliches System sein, welches aus Beispielen (bzw. Anwendungen) lernt und diese (nach oder während einer Lernphase) verallgemeinert. Ein solcher Algorithmus kann z.B. mittels neuronaler Netzwerke realisiert werden.

Gemäß einem weiteren Ausführungsbeispiel i) ist der selbstlernende Algorithmus eingerichtet, die bestimmte Steueroperation automatisch durchzuführen, und/oder ii) der selbstlernende Algorithmus ist eingerichtet die bestimmte Steueroperation einem Benutzer zum Überprüfen bereitzustellen. Dadurch kann sich der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist i) der selbstlernende Algorithmus eingerichtet basierend auf dem Vergleichen einen neuen vorbestimmten Prozessparameter zu bestimmen und automatisch der Datenmodell-Einheit zuzuführen und/oder ii) der selbstlernende Algorithmus ist eingerichtet basierend auf dem Vergleichen einen neuen vorbestimmten Prozessparameter zu bestimmen und dem Benutzer zum Überprüfen bereitzustellen. Dadurch kann sich ebenfalls der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist der selbstlernende Algorithmus eingerichtet, das Ergebnis des Überprüfens durch den Benutzer als Lerngrundlage zu verwenden. Dies kann den Vorteil bereitstellen, dass sich der selbstlernende Algorithmus während dem Betreiben des Verfahrens ständig in einer gewünschten Richtung weiterentwickelt und über die Zeit immer mehr Aufgaben direkt umsetzen kann.

Im Folgenden werden exemplarische Ausführungsbeispiele der vorliegenden Erfindung mit Verweis auf die folgenden Figuren detailliert beschrieben.

Die **Figuren 1 bis 3** zeigen jeweils eine Übersicht der Teilströme beim Herstellen von Leiterplatten und/oder Substraten gemäß Ausführungsbeispielen der Erfindung.

Die **Figuren 4 bis 7** zeigen einen ersten Aufbereitungsprozess eines Metallsalz-haltigen Mediums aus einem Ätzprozess aus der Leiterplatten- und/oder Substrat-Herstellung gemäß Ausführungsbeispielen der Erfindung.

Die **Figur 8** zeigt einen zweiten Aufbereitungsprozess eines Metallsalz-haltigen Mediums aus einem Galvanisierungsprozess aus der Leiterplatten- und/oder Substrat-Herstellung gemäß einem Ausführungsbeispiel der Erfindung.

Die **Figuren 9** **und** **10** zeigen einen dritten Aufbereitungsprozess eines Metallsalz-haltigen Mediums aus Spülwasser aus der Leiterplatten- und/oder Substrat-Herstellung gemäß Ausführungsbeispielen der Erfindung.

Die **Figuren 11 bis 15** zeigen jeweils ein Rückgewinnen eines elementaren Metalls aus einem Metallsalz-haltigen Medium aus der Leiterplatten- und/oder Substrat-Herstellung gemäß Ausführungsbeispielen der Erfindung.

Die **Figur 16** zeigt eine Übersicht der Aufbereitungsprozesse und des Rückgewinnens bei der Leiterplatten- und/oder Substrat-Herstellung gemäß einem Ausführungsbeispiel der Erfindung.

Die **Figur 17** zeigt eine Prozesskontrollvorrichtung zum Regulieren von zumindest einem Teil des oben beschriebenen Verfahrens (bzw. der Industrieanlage) gemäß einem Ausführungsbeispiel der Erfindung.

Gleiche oder ähnliche Komponenten in unterschiedlichen Figuren sind mit gleichen Bezugsziffern versehen.

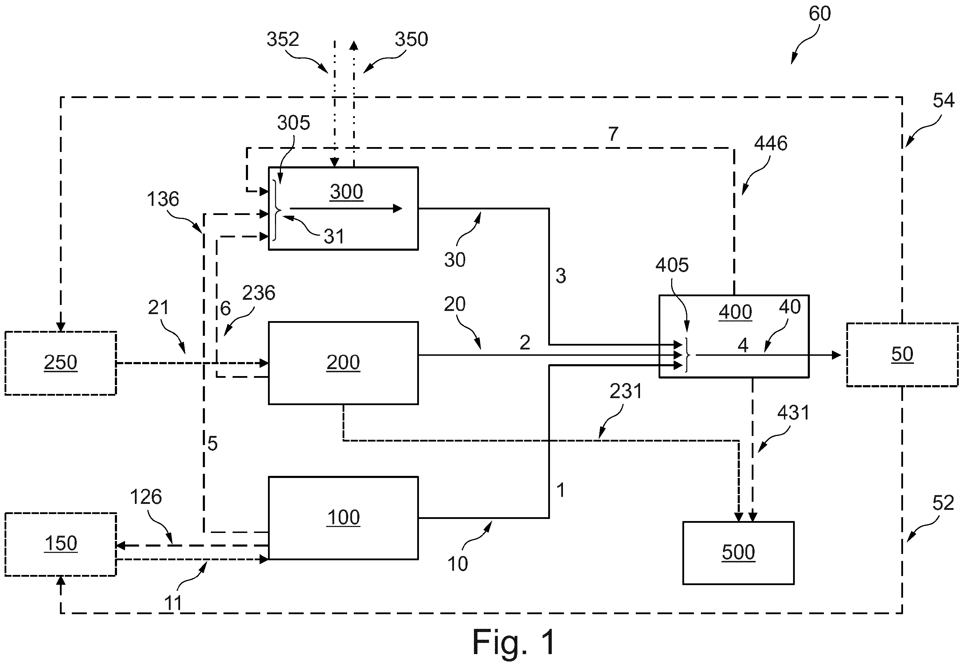

**Figur 1** zeigt eine Übersicht von Strömen 1 bis 7 beim Herstellen von Leiterplatten und/oder Substraten, z.B. in einer Industrieanlage 60, gemäß einem Ausführungsbeispiel der Erfindung. Das Verfahren zum Herstellen von Leiterplatten und/oder Substraten wird derart betrieben, dass die anfallenden Prozess-Rückstände 11, 21, 31 in drei hauptsächlichen Teilströmen 1, 2, 3 (und insbesondere zumindest teilweise als Gesamtstrom 4) und drei hauptsächlichen Abtrennströmen 5, 6, 7 (welche insbesondere Säure-Rückstände aufweisen) derart in einem Wertstoffkreislauf geleitet und rückgeführt (bzw. recycelt) werden, dass in dem (gezeigten) Betriebszustand des Herstellungsverfahrens als Abfall (im Wesentlichen) nur ein Medium 350 in Einleitqualität anfällt. In anderen Worten weist das Medium 350 in Einleitqualität (im Wesentlichen) keine Hauptkomponenten (insbesondere kein Schwermetall) der Leiterplatten/Substrat-Herstellung mehr auf, sondern besteht lediglich aus Wasser, Salzen, und organischem Material. Dem Herstellungsverfahren müssen im (gezeigten) Betriebszustand (im Wesentlichen) also nur Wasser 352 und Energie zugeführt werden (anfallende Säure-Rückstände werden (im Wesentlichen) ebenfalls in dem Wertstoffkreislauf rückgeführt). Im Wesentlichen werden dem Herstellungsverfahren also nur solche Hauptkomponenten (insbesondere Schwermetall wie Kupfer) zugeführt, welche als Bestandteil einer fertigen gedruckten Leiterplatte und/oder eines Substrats das Herstellungsverfahren wieder verlassen. Prinzipiell können in dem beschriebenen Wertstoffkreislauf 95% oder mehr, insbesondere 98% oder mehr, der Schwermetall-Rückstände (z.B. Kupfer Rückstände) rückgeführt werden. In einem exemplarischen Beispiel des Wertstoffkreislauf werden mindestens 80% (insbesondere mindestens 85%, weiter insbesondere mindestens 90%) der abgetrennten Salzsäure rückgeführt, und mindestens 70% (insbesondere mindestens 75%, weiter insbesondere mindestens 80%) der benötigten Schwefelsäure Verfahrens-intern produziert. Daher werden dem Herstellungsverfahren (im Wesentlichen) keine Hauptkomponenten zugegeben, welche als Abfall das Herstellungsverfahren verlassen haben. Tatsächlich fällt ein solcher Abfall (im Wesentlichen) prinzipiell nicht an.

Die anfallenden Rückstände 11, 21, 31 bzw. Abfallkonzentrate können als aufzubereitende Metallsalz-haltige Medien bezeichnet werden und weisen in einem exemplarischen Ausführungsbeispiel u.a. auf: Kupfer, Kupfersulfat, Kupferchlorid, Eisen, Nickel, Gold, Salzsäure, Schwefelsäure. Die aufzubereitenden Metallsalz-haltigen Medien 11, 21, und 31 werden jeweils in einem entsprechenden Aufbereitungsprozess 100, 200, 300 aufbereitet und dann als Teilströme 1, 2, 3, welche jeweils aufbereitetes Metallsalz-haltiges Medium 10, 20, 30 aufweisen, einem Rückgewinnungsprozess 400 zugeführt. Nach der Aufbereitung schließlich wird rückgewonnenes, elementares Metall 50 wieder in den Herstellungsprozess eingespeist (Pfeile 52 und 54). Im Folgenden wird ein prinzipieller Überblick über die Teilströme 1 bis 7 innerhalb des Wertstoffkreislaufs gegeben. Weiter unten folgen dann detaillierte Beschreibungen der einzelnen Prozesse.

Der erste Teilstrom 1 weist ein erstes aufbereitetes Metallsalz-haltiges Medium 10 aus einem Ätzprozess 150 der Leiterplatten- und/oder Substrat-Herstellung auf, welches in einem ersten Aufbereitungsprozess 100 aufbereitet wird. Das erste aufbereitete Metallsalz-haltige Medium 10 (welches im Wesentlichen kein aufzubereitendes Metallsalz aufweist) wird aus dem aufzubereitenden Medium 11 aus dem Ätzprozess 150 erhalten. Das aufzubereitende Medium 11 weist ein aufzubereitendes Metallsalz (z.B. Kupferchlorid) und eine Säure auf. Das Aufbereiten 100 umfasst ein mehrstufiges Entfernen 110, 120 der Säure mittels Membrandialyse und Durchführen einer chemischen Reaktion 140. Bei der Membrandialyse fällt ein erstes Säure-haltiges Diffusat 136 an. Ein weiteres Säure-haltiges Diffusat 126 kann direkt an den Ätzprozess 150 bereitgestellt werden.

Der zweite Teilstrom 2 weist ein zweites aufbereitetes Metallsalz-haltiges Medium 20 aus einem Galvanisierungsprozess 250 der Leiterplatten- und/oder Substrat-Herstellung auf. Das zweite aufbereitete Metallsalz-haltige Medium 20 (welches im Wesentlichen kein Eisen aufweist) wird aus einem Eisen- und Metallsalz-haltigen Medium 21 aus dem Galvanisierungsprozess 250 erhalten. Das Aufbereiten 200 umfasst ein Separieren des Eisens aus dem Eisen- und Metallsalz-haltigen Medium 21 mittels eines Ionentauschers 220. Bei einem Regenerieren 222 des Ionentauschers 220 fällt ein zweites Säure-haltiges Diffusat 236 an.

Der dritte Teilstrom 3 weist ein drittes aufbereitetes Metallsalz-haltiges Medium 30 aus Spülwasser 32 bzw. einer Spülwasser Mischung 31 der Leiterplatten- und/oder Substrat-Herstellung auf. Das dritte aufbereitete Metallsalz-haltige Medium 30 wird in einem dritten Aufbereitungsprozess 300 unter Verwenden eines Ionentauschers 320 erhalten, wobei das Metallsalz in dem aufbereiteten Metallsalz-haltigen Medium 30 im Vergleich zu dem Spülwasser 32 aufkonzentriert ist.

Die Teilströme 1, 2, 3 können (zumindest teilweise) vereint werden (siehe Schritt 405) zu einem Gesamtstrom 4 oder auch einzeln aufbereitet werden. Das Aufbereiten 400 umfasst ein Rückgewinnen 400 des elementaren Metalls 50 (z.B. elementares Kupfer) aus dem Metallsalz-haltigen Medium 40 in einer (Elektrolyse-) Reaktionszelle 450. Das (kontinuierliche) Einstellen der Zusammensetzung des Metallsalz-haltigen Mediums 40 als Elektrolyten umfasst ein Abtrennen 440 von Säure mittels Membrandialyse, wobei ein drittes Säure-haltiges Diffusat 446 anfällt. Alternativ kann das Diffusat 446 auch zur Regeneration eines Ionentauschers 320 zur Aufbereitung der Spülwässer herangezogen werden. Hierbei bleibt das Metall (insbesondere Kupfer) ebenfalls im Wertstoffkreislauf und kann daher nahezu vollständig aus dem Metallsalz-haltigen Medium entfernt werden. Das hat den Vorteil, dass ein weiterer Aufbereitungsschritt mittels Membrandialyse eingespart werden kann. Das erhaltene hochreine Metall 50 wiederum ist geeignet erneut in den Ätzprozess 150 rückgeführt (siehe Pfeil 52) zu werden und/oder in den Galvanisierungsprozess 250 rückgeführt (siehe Pfeil 54) zu werden.

Ein erster Abtrennstrom 5 stammt aus dem ersten Aufbereitungsprozess 100 und weist das erste Säure-haltige Diffusat 136 auf. Ein zweiter Abtrennstrom 6 stammt aus dem zweiten Aufbereitungsprozess 200 und weist das zweite Säure-haltige Diffusat 236 auf. Ein dritter Abtrennstrom 7 stammt aus dem Aufbereitungsprozess 410 des Gesamtstroms 4 und weist das dritte Säure-haltige Diffusat 446 auf. Die Abtrennströme 5, 6, 7 weisen jeweils das Metallsalz (z.B. Kupfersulfat) in geringer Konzentration auf, bzw. in geringerer Konzentration als die Konzentration des Metallsalzes in dem dritten Teilstrom 3. Die Abtrennströme 5, 6, 7 werden (zumindest teilweise) zusammengeführt (siehe Schritt 305) zu einem aufzubereitenden Medium 31 bzw. einer Mischung an Spülwässern (Gesamtabtrennstrom). Auch weitere Spülwässer 32 des Herstellungsverfahrens können hier einfließen. Das aufzubereitende Medium 31 wird, wie oben beschrieben, mittels des dritten Aufbereitungsprozesses 300 aufbereitet, um die Konzentration für das Rückgewinnen 400 deutlich zu erhöhen.

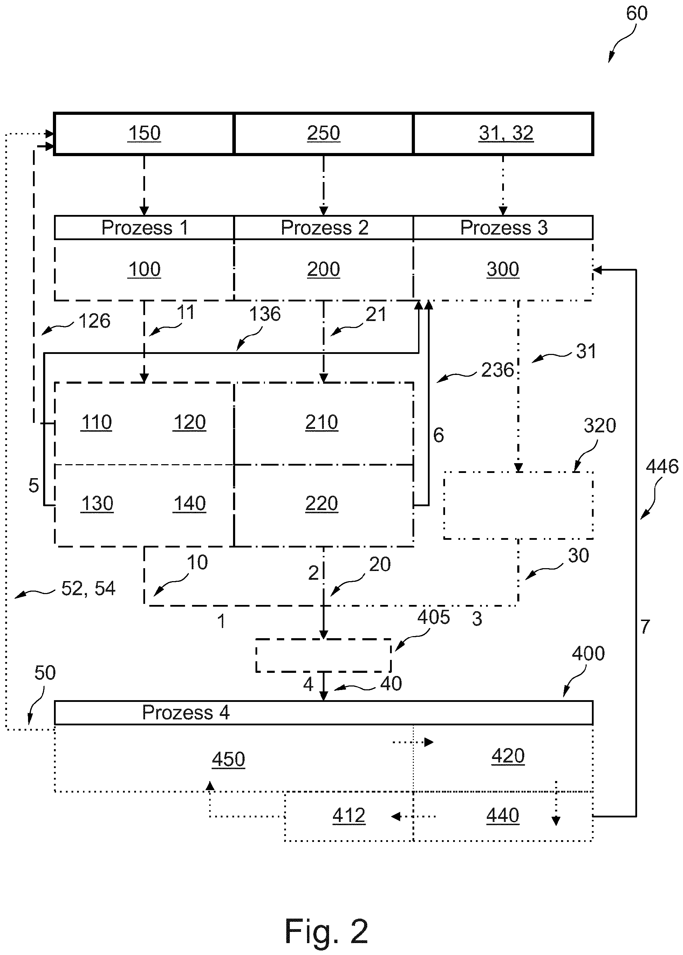

**Figur 2** zeigt eine Übersicht der Teilströme beim Herstellen von Leiterplatten und/oder Substraten, z.B. in einer Industrieanlage 60, gemäß einem weiteren Ausführungsbeispiel der Erfindung. Der Wertstoffkreislauf entspricht dem für Figur 1 oben beschriebenen in anderer Darstellungsweise. Es ist ferner gezeigt, dass das Rückgewinnen 400 ein (kontinuierliches) Einstellen der Zusammensetzung des Elektrolyten (bzw. des Metallsalz-haltigen Mediums) 40 aufweist. So wird der Elektrolyt aus der Reaktionszelle 450 (kontinuierlich) behandelt mittels eines organischen Filters 412, eines Separierens von Fremdmetall 420, und eines Separierens von Säure 440 (bei zu hoher Säurekonzentration).

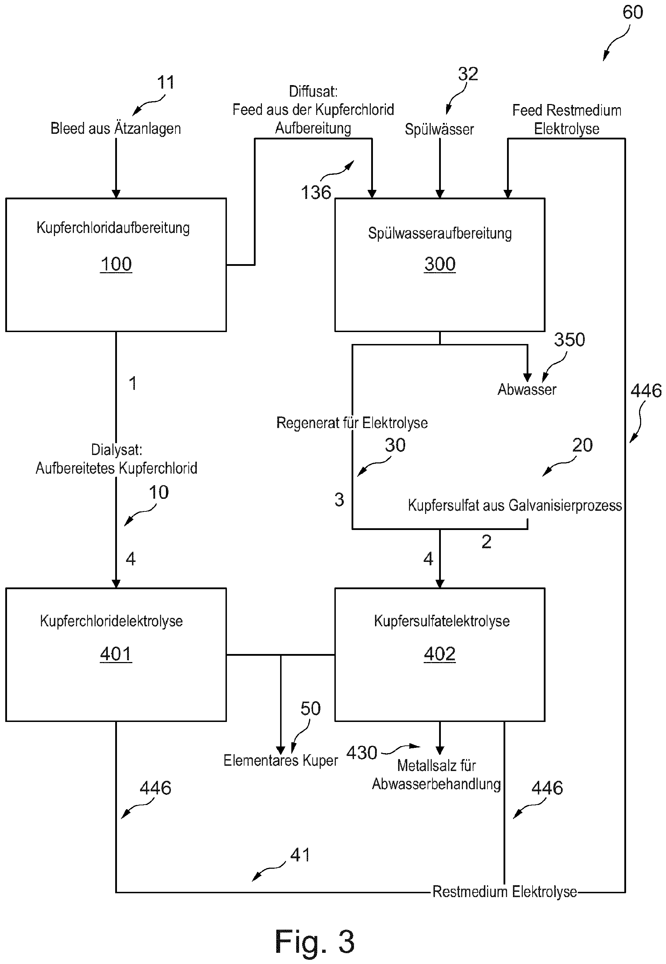

**Figur 3** zeigt ein exemplarisches Ausführungsbeispiel des für die Figuren 1 und 2 bereits beschriebenen Herstellens von gedruckten Leiterplatten und/oder Substraten. In diesem spezifischen Ausführungsbeispiel weist das aufzubereitende Metallsalz Kupferchlorid auf und das Metallsalz weist Kupfersulfat auf. Der Unterschied zu dem für die Figuren 1 und 2 beschriebenen Prozess besteht darin, dass der erste Teilstrom 1 einem ersten Rückgewinnungsprozess 401 (der Begriff "Kupferchloridelektrolyse" bezieht sich hierbei auf das Ausgangsmaterial, es wird eigentlich eine Kupfersulfatelektrolyse durchgeführt) zugeführt wird und ein Gesamtstrom 4, welcher aus dem zweiten Teilstrom 2 und dem dritten Teilstrom 3 besteht, einem zweiten Rückgewinnungsprozess 402 zugeführt wird.

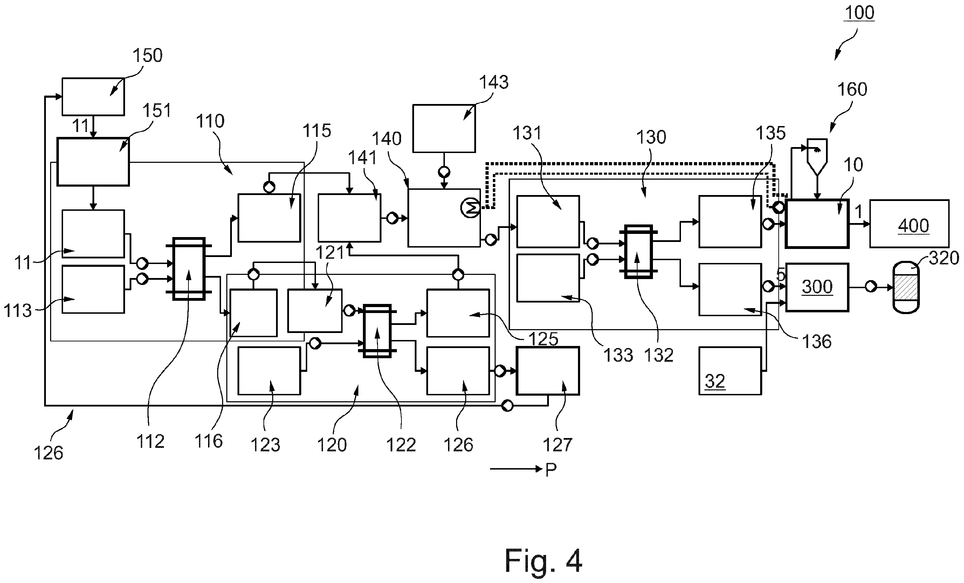

**Figur 4** zeigt den ersten Aufbereitungsprozess 100 zum Bereitstellen des ersten Metallsalz-haltigen Mediums 10 aus einem Ätzprozess 150 aus der Leiterplatten- und/oder Substrat-Herstellung gemäß Ausführungsbeispielen der Erfindung. Der erste Aufbereitungsprozess 100 umfasst ein Verfahren zum Aufbereiten eines aufzubereitenden Mediums 11 aus dem Ätzprozess 150, wobei das aufzubereitende Medium 11 ein aufzubereitendes Metallsalz und eine Säure 15 aufweist, um das erste Metallsalz-haltige Medium 10 bereitzustellen. Die Prozessrichtung ist mit dem Pfeil P angezeigt.

In den folgenden Ausführungsbeispielen wird meist Kupfer als exemplarisches Beispiel verwendet. Gleiches gilt aber auch für weitere Metalle wie z.B.: Nickel, Cobalt, Rhodium, Zinn, Cadmium, Magnesium, Natrium, Silber, Gold, Eisen. Diese können mit Säuren (z.B. Salzsäure, Schwefelsäure, Salpetersäure, Phosphorsäure) Metallsalze bilden.

Gemäß einem exemplarischen Ausführungsbeispiel fällt aus dem Ätzprozess 150 als aufzubereitendes Medium 11 Kupfer in Form von Kupferchlorid (als aufzubereitendes Metallsalz) und Salzsäure als Säure 15 an. Der hohe Anteil an Chlorid-Ionen begünstigt während eines Rückgewinnes, z.B. Elektrolyse, die unkontrollierbare Bildung von Chlorgas. Zusätzlich können sich Chlorid-Ionen an der Elektrode mit abscheiden, welche die Reinheit des abgeschiedenen Kupfers negativ beeinflussen. Daher wird in dem ersten Aufbereitungsprozess 100 das Kupferchlorid in Kupfersulfat umgewandelt, während die freie Säure 15 abgetrennt wird.

Der erste Aufbereitungsprozess 100 weist nun prinzipiell zwei Verfahrensschritte auf: i) mehrstufiges Entfernen 110, 120 der Säure 15 aus dem Säure-haltigen aufzubereitenden Medium 11 mittels Membrandialyse, um ein konzentriertes, im wesentlichen Säure-freies, aufzubereitendes Medium 141 bereitzustellen, und nachfolgend ii) Durchführen einer chemischen Reaktion 140 zum Erzeugen des Metallsalz-haltigen Mediums 10 aus dem konzentrierten, im wesentlichen Säurefreien, aufzubereitenden Medium 141.

Es hat sich hierbei herausgestellt, dass die chemische Reaktion 140 (insbesondere Kupferchlorid zu Kupfersulfat) stark exotherm ist, so dass dadurch entstehende Abwärme zusätzlich als Energiequelle genutzt werden kann. In einem exemplarischen Beispiel können auf diese Weise 800 kW pro Tag durch die chemische (exotherme) Reaktion bereitgestellt werden. Diese Energie kann wiederum direkt eingesetzt (abgeleitet bzw. umgeleitet) werden, um ein flüssiges Medium (z.B. in einem Versorgungsbecken 310, 410 oder einem Elektrolysebecken einer Reaktionszelle 450) innerhalb ein und desselben Leiterplatten- und/oder Substrat-Herstellungsprozesses zu erwärmen/heizen. Überraschenderweise hat sich also gezeigt, dass dem Wertstoffkreislauf weniger Energie hinzugeführt werden muss, weil eine exotherme, Prozess-interne Reaktion als effiziente Energiequelle verwendet werden kann.

Neben der Reaktion Kupferchlorid zu Kupfersulfat können beispielsweise auch folgende Umsalz-Reaktionen (jeweils mit den entsprechenden Säuren) stattfinden:
NiCl₂ + H₂SO₄ ↔ NiSO₄ + 2HCl
NiCl₂ + 2HNO₃ ↔ Ni(NO₃)₂ + 2HCl
CoCl₂ + H₂SO₄ ↔ CoSO₄ + 2HCl
CoCl₂+ 2HNO₃ ↔ Co(NO₃)₂ + 2HCl
3CoCl₂ + 2H₃PO₄ ↔ Co₃(PO₄)₂ + 6HCl
SnCl₂ + H₂SO₄ ↔ SnSO₄ + 2HCl
SnCl₂ + 2HNO₃ ↔ Sn(NO₃)₂ + 2HCl
CdCl₂ + H₂SO₄ ↔ CdSO₄ + 2HCl
CdCl₂ + 2HNO₃ ↔ Cd(NO₃)₂ + 2HCl
3CdCl₂ + 2H₃PO₄ ↔ Cd₃(PO₄)₂ + 6HCl
MgCl₂ + H₂SO₄ ↔ MgSO₄ + 2HCl
MgCl₂ + 2HNO₃ ↔ Mg(NO₃)₂ + 2HCl
3MgCl₂ + 2H₃PO₄ ↔ Mg₃(PO₄)₂ + 6HCl
2NaCl + H₂SO₄ ↔ Na₂SO₄ + 2HCl
NaCl + HNO₃ ↔ NaNO₃ + HCl
3NaCl + H₃PO₄ ↔ Na₃PO₄ + 3HCl
Der Doppelpfeil stellt dabei die Gelichgewichtsreaktion dar. Prinzipiell kann auch von der Produkt-Seite ausgegangen und mit HCl umgesalzt werden, z.B. wie folgt:
NiSO₄ + 2HCl ↔ NiCl₂ + H₂SO₄
Wird die Säure während der Entstehung entfernt, kann das Gleichgewicht auf die Seite der Produkte geschoben werden, so dass aus einem Doppelpfeil ein Pfeil wird, z.B. wie folgt:
NiSO₄ + 2HCl → NiCl₂ + H₂SO₄ (wenn man H₂SO₄ kontinuierlich entfert).

Das aufzubereitende Metallsalz-haltige Medium 11 wird in einem Überlaufbecken 151 des Ätzprozesses 150 gesammelt und als Dialysat 11 der ersten Membrandialyse 110 zugeführt. Weiterhin wird der Membrandialyse 110 entsalztes Wasser über einen ersten Diffusat Zulauf 113 zugeführt.

Die Membran 112 kann hierbei z.B. eine Wickelmembran oder eine Plattenmembran aufweisen. Die Membran 112 ist semipermeabel und lässt Anionen (z.B. Chlorid) passieren (Anionen-Membran), während Kationen (z.B. Cu²⁺) nicht passieren können. Die Membrandialyse 110 weist einen Durchsatz in dem Bereich 0,5 bis 5 L/hm² (insbesondere 1 bis 2 L/hm²) auf. Es kann für die im folgenden beschriebenen Membrandialysen jeweils dieselbe Membran eingesetzt werden oder (bevorzugt) werden unterschiedliche Membranen verwendet (z.B. je nachdem aus welchem (Ätz-) Prozess die jeweilige Metallsalz-haltige Lösung stammt). Eine Anionen-Membran kann z.B. mit Brom (Br⁻) funktionalisiert sein, wobei das Trägermaterial beispielsweise PET oder PVC sein kann. In bestimmten Fällen kann die Metallsalz-haltige Lösung Wasserstoffperoxid (H₂O₂) beinhalten. In diesem Fall kann bevorzugt eine oxidationsbeständige Membran genutzt werden, welche z.B. auf PEEK (Polyetheretherketon-Trägermaterial) basiert.

Es wird ein erster Teil der Säure 15a aus dem aufzubereitenden Medium 11 mittels der ersten Membrandialyse 110 entfernt, um ein erstes Dialysat 115 mit einer ersten Konzentration des aufzubereitenden Metallsalzes und ein erstes Diffusat 116, welches den ersten Teil der Säure 15a aufweist, zu erhalten.

Das erste Diffusat 116 weist ferner eine zweite Konzentration (welche geringer ist als die erste Konzentration) des aufzubereitenden Metallsalzes auf. Dies liegt daran, dass doch einige Kationen die Membran 112 passieren, insbesondere wenn die Kationen mit den Anionen einen Komplex bzw. ein Aggregat (z.B. einen Kupfer-Chlor Komplex) bilden. Ohne an eine bestimmte Theorie gebunden sein zu wollen, wird derzeit davon ausgegangen, dass eine solche Aggregat-Bildung stattfinden kann, wenn die Konzentration der Kationen in einer Lösung erhöht ist.

Nachfolgend wird das erste Diffusat 116 einer zweiter Membrandialyse 120 unterzogen. Das erste Diffusat 116 wird hierbei der zweiten Membrandialyse 120 als Dialysat Zulauf 121 zugeführt. Als zweiter Diffusat Zulauf 123 wird entsalztes Wasser verwendet. Ein zweiter Teil der Säure 15b wird aus dem ersten Diffusat 116 entfernt, um ein zweites Dialysat 125 mit einer dritten Konzentration (welche kleiner ist als die zweite Konzentration) des aufzubereitenden Metallsalzes und ein zweites Diffusat 126, welches den zweiten Teil der Säure 15b aufweist, zu erhalten. Das erste Diffusat 116 weist ferner eine zweite Konzentration des aufzubereitenden Metallsalzes auf. Das zweite Diffusat 126 weist eine vierte Konzentration des aufzubereitenden Metallsalzes auf, welche kleiner ist als die dritte Konzentration. Die Konzentration an Kationen des aufzubereitenden Metallsalzes in dem ersten Diffusat 116 ist deutlich geringer als die Kationen-Konzentration in dem Dialysat-Zulauf 11. Daher wird davon ausgegangen, dass sich nun im Wesentlichen keine Aggregate mehr bilden, und nur noch eine vernachlässigbare Menge an Kationen durch die Membran 112, 122 diffundiert. Aus diesem Grund werden vorzugsweise genau zwei Membrandialyse-Stufen 110, 120 durchgeführt. Dadurch kann in vorteilhafter Weise eine hohe Konzentration des Metallsalzes erreicht werden während zugleich die Menge an eingesetzter Flüssigkeit nicht zu hoch wird.

Das zweite Diffusat 126, welches nur noch eine vernachlässigbare Menge des aufzubereitenden Metallsalzes aber eine hohe Säurekonzentration aufweist, wird in einem Ätzprozess-Sammelbecken 127 gesammelt und dann wieder an den Ätzprozess 150 aus der Leiterplatten- und/oder Substrat-Herstellung bereitgestellt. Insbesondere wird das zweite Diffusat 126 zunächst aufbereitet.

Das erste Dialysat 115 und das zweite Dialysat 126 werden zusammengeführt, um das konzentrierte, im Wesentlichen Säure-freie, aufzubereitende Metallsalz-haltigen Medium 141 bereitzustellen. Zusätzlich wird eine weitere Säure 143 bereitgestellt, welche z.B. Schwefelsäure aufweist. Die weitere Säure 143 und das konzentrierte aufzubereitende Metallsalz-haltige Medium 141 werden in einer Mischanlage 140 (z.B. Kustan Mischanlage) zusammengeführt, um die chemische Reaktion 140 zu starten. Die chemische Reaktion 140 findet teilweise in der Mischanlage 140 und/oder teilweise in einer dritten Membrandialyse 130 statt. Die Reaktion 140 umfasst das Erzeugen eines Metallsalz-haltigen Mediums 10 mittels Umsalzens aus dem konzentrierten aufzubereitenden Medium 141. Bei dem Umsalzen kommt es zur Erzeugung von Säure 15 (insbesondere Salzsäure) in dem nun vorliegenden Metallsalz-haltigen Medium 10. In einem exemplarischen Ausführungsbeispiel reagieren Kupferchlorid (als aufzubereitendes Metallsalz) und Schwefelsäure (als weitere Säure) zu Kupfersulfat (Metallsalz) und Salzsäure. Sowohl ein Entfernen dieser Säure als auch zumindest ein Teil der chemischen Reaktion 140 werden mittels der dritten Membrandialyse 130 durchgeführt.

Die Mischung aus der weiteren Säure 143 und dem konzentrierten aufzubereitenden Medium 141 werden als Dialysat Zulauf 131 der dritten Membrandialyse 130 zugeführt. Als dritter Diffusat Zulauf 133 wird entsalztes Wasser verwendet. Es wird ein drittes Dialysat 135 erhalten, welches das Metallsalz aufweist, und ein drittes Diffusat 136, welches einen dritten Teil der Säure 15c aufweist.

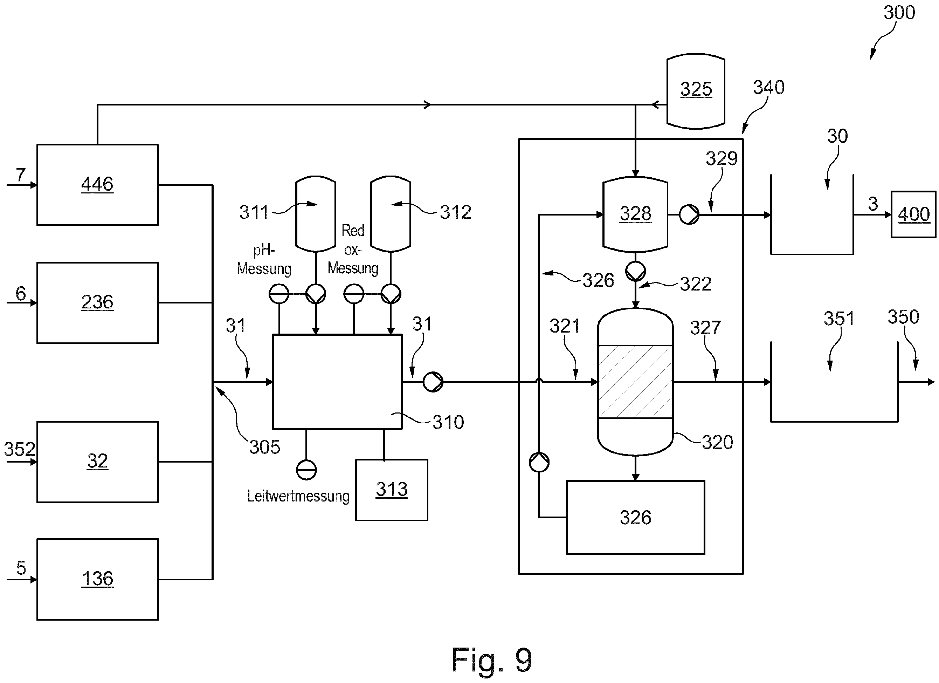

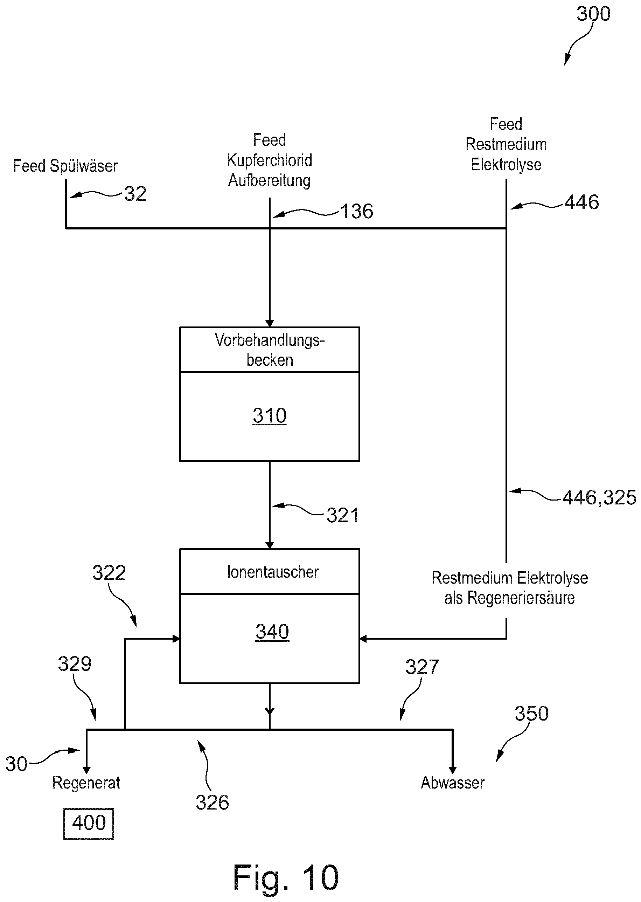

Das dritte Diffusat 136 enthält nun die Säure 15 und die weitere Säure (z.B. Salzsäure und Schwefelsäure) und eine geringe Konzentration des Metallsalzes. Dieses dritte Diffusat 136 wird im Zuge des ersten Abtrennstroms 5 an ein Verfahren 300 bereitgestellt zum Aufbereiten eines Metallsalz-haltigen Mediums aus Spülwasser aus der Leiterplatten- und/oder Substrat-Herstellung. In diesem Verfahren 300 wird das dritte Diffusat 136 (vorzugsweise mit weiterem Spülwasser 32) mittels eines Ionentauschers 320 aufbereitet (siehe Figuren 9 und 10).

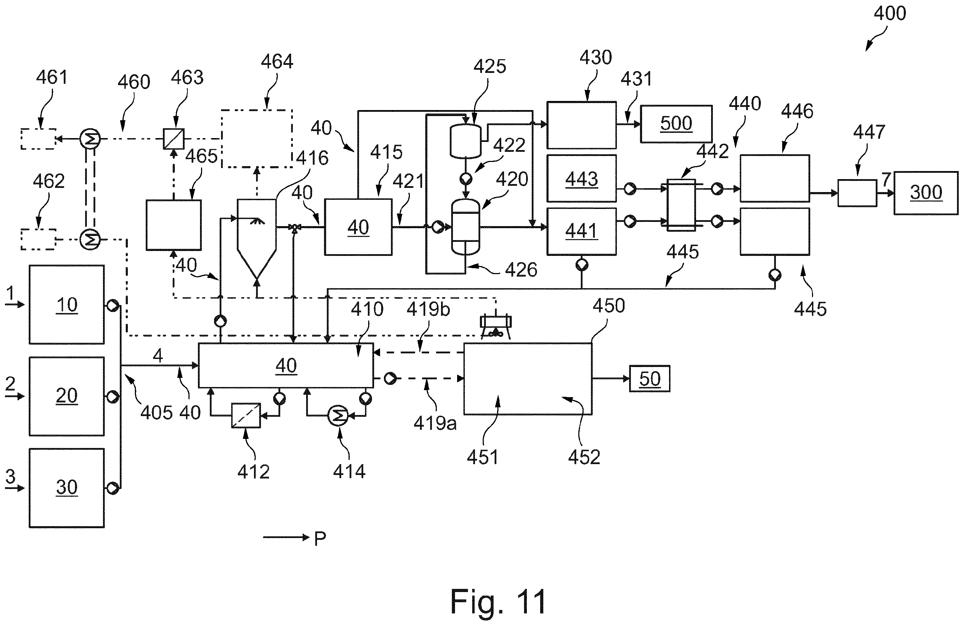

Das dritte Dialysat 135 (optional mittels eines Verdunsters 160 aufkonzentriert) stellt das Metallsalz-haltige Medium 10 dar. Dieses wird über den ersten Teilstrom 1 an ein Verfahren zum Rückgewinnen 400 des elementaren Metalls aus dem Metallsalz-haltigen Medium 10 bereitgestellt (siehe Figuren 11 bis 14).

In einem bevorzugten Beispiel weist das Verfahren 100 auf: Vorgeben eines Maximalwerts für das Volumen zumindest eines Diffusats-Zulaufs 113, 123, 133 der Membrandialyse 110, 120, 130 und Vorgeben eines Minimalwerts für die Konzentration an aufzubereitendem Metallsalz. Die Prozessparameter (z.B. Durchflussgeschwindigkeit, Durchflussvolumen etc.) werden derart gesteuert (bzw. geregelt), dass der vorgegebene Maximalwert nicht überschritten wird und der vorgegebene Minimalwert nicht unterschritten wird. Dies führt in besonders vorteilhafter Weise dazu, dass keine unnötig großen Mengen an flüssigem Medium (bzw. Wasser und Säure) anfallen, sondern immer mit höchstmöglichen Konzentrationen an Metallsalz gearbeitet wird. Daher kann es sich anbieten, lediglich genau zwei Membrandialyse-Stufen 110, 120 durchzuführen, wodurch eine optimale Ausbeute bereitgestellt wird ohne, dass große Mengen an flüssigem Medium bei drei oder mehr Dialysen anfallen. In einem weiteren bevorzugten Ausführungsbeispiel wird das Verfahren 100, insbesondere das Entfernen 110, 120, 130, kontinuierlich betrieben.

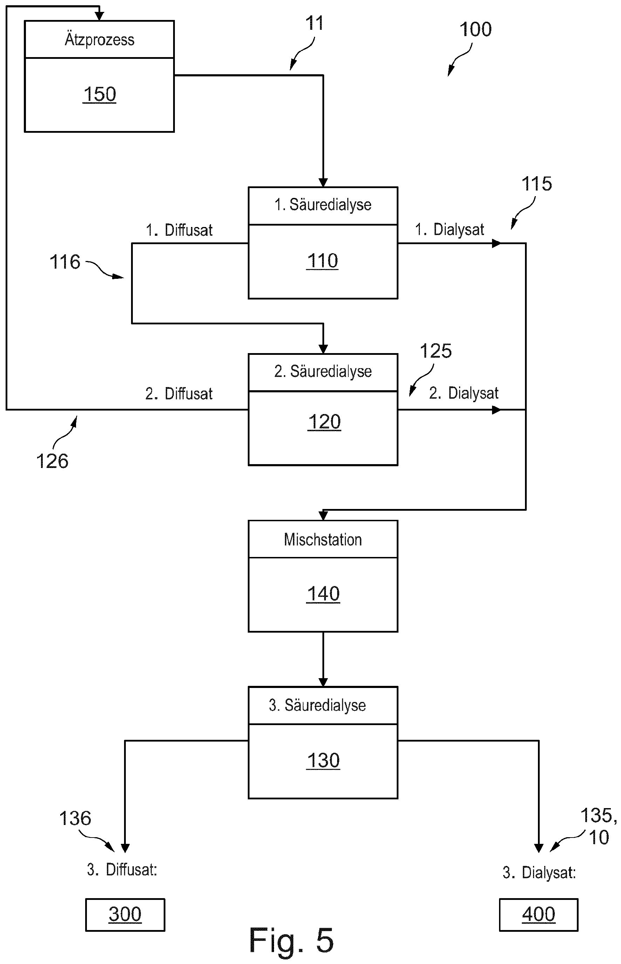

**Figur 5** zeigt den ersten Aufbereitungsprozess 100 des Metallsalz-haltigen Mediums aus einem Ätzprozess 150 aus der Leiterplatten- und/oder Substrat-Herstellung, welcher in Figur 4 im Detail beschrieben wurde, nochmals aus Gründen der Übersichtlichkeit als Flussdiagram.

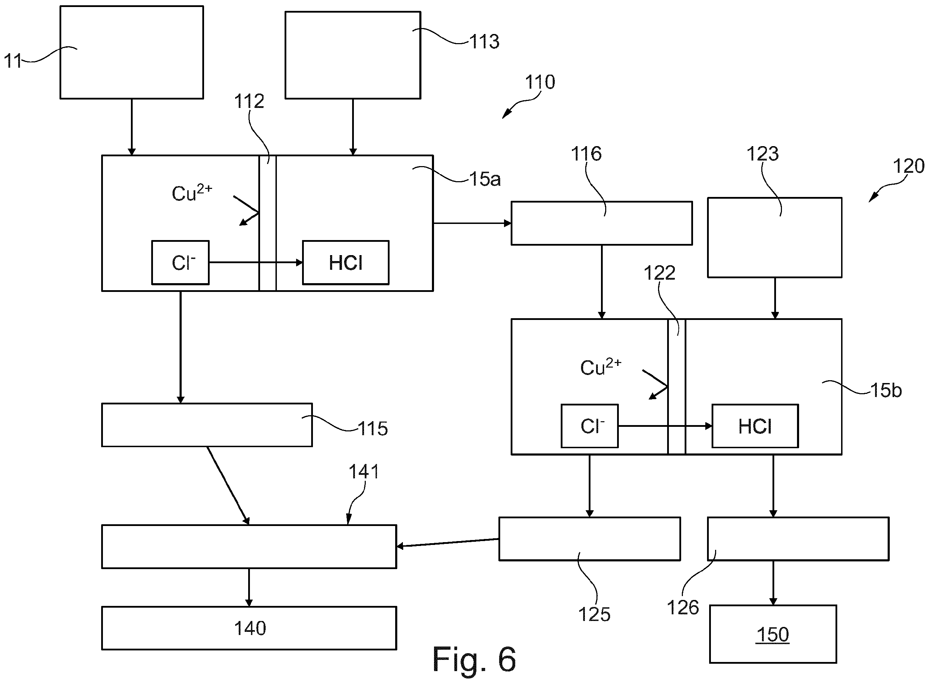

**Figur 6** zeigt ein exemplarisches Ausführungsbeispiel der ersten Membrandialyse 110 und der zweiten Membrandialyse 120, wobei in diesem konkreten Beispiel das aufzubereitende Medium 11 Kupferchlorid (aufzubereitendes Metall) und Salzsäure (Säure 15) aufweist. Bei der Membrandialyse bzw. Säuredialyse sind zwei Zuläufe 11, 113 notwendig, welche örtlich voneinander mittels einer semipermeablen Membran 112 getrennt sind. Die Membran 112 ist mit einer dauerhaft positiven Ladung konditioniert und sowohl für negative Ionen als auch für H⁺ durchlässig, nicht jedoch für positive Kupfer Ionen (Cu²⁺). Mit diesem Aufbau ergeben sich auch zwei örtlich getrennte Abläufe (erstes Diffusat 116 und erstes Dialysat 115), die ebenfalls voneinander durch dieselbe Membran 112 getrennt sind. Der Zulauf 113 auf der Diffusat-Seite besteht aus voll entsalztem Wasser (VE-Wasser), während der Zulauf auf der Dialysat-Seite das aufzubereitende Medium 11 aus dem Ätzprozess 150 darstellt. Die unterschiedliche Stoffkonzentration (insbesondere Säurekonzentration) zwischen den beiden Zuläufen 11, 113 ist die treibende Kraft der die Dialyse bewirkenden Diffusion. Durch den kontinuierlichen Betrieb bleibt eine bestimmte Konzentrationsdifferenz entlang der Membran 112 erhalten und die Trennung kann ebenfalls kontinuierlich erfolgen. Die Salzsäure 15 diffundiert auf Grund des Konzentrationsunterschieds auf die Diffusat-Seite des Wassers 113, während sich auf der Seite des Dialysats Kupfer anreichert. Geringe Konzentrationen an Kupfer gelangen auch in das erste Diffusat 116, während der Hauptteil des Kupfers im ersten Dialysat 115 verbleibt. Dennoch kann die Kupfer-Konzentration im ersten Diffusat 116 in bestimmten Fällen um die 30% der Konzentration des Kupfers in dem aufzubereitenden Medium 11 betragen. Das erste Diffusat 116 wird daher mittels der zweiten Membrandialyse 120 aufbereitet, um möglichst viel weiteres Kupfer abzutrennen. Das zweite Diffusat 126 der zweiten Membrandialyse 120 wird in den Ätzprozess 150 zurückgeführt, während das zweite Dialysat 125 der zweiten Membrandialyse 120 mit dem ersten Dialysat 115 aus der ersten Membrandialyse 110 gemeinsam als konzentriertes (Säure-freies) aufzubereitendes Medium 141 weiter aufbereitet wird.

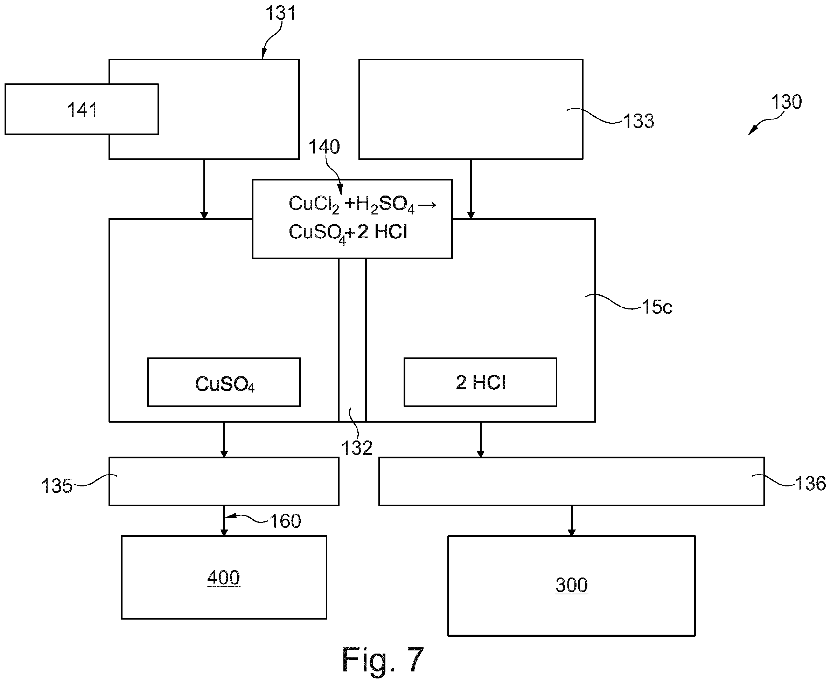

**Figur 7** zeigt ein exemplarisches Ausführungsbeispiel der chemischen Reaktion 140 und der dritten Membrandialyse 130, wobei in diesem konkreten Beispiel das konzentrierte und im Wesentlichen Säure-freie aufzubereitende Medium 141 (das im Wesentlichen Kupferchlorid aufweist) nach dem Beispiel von Figur 6 (siehe oben) verwendet wird. Während das zweite Diffusat 126 zurück in den Ätzprozess 150 geführt wird, wird das konzentrierte aufzubereitende Medium 141 in einem weiteren Schritt (zumindest teilweise) mit Hilfe der dritten Membrandialyse 130 zu Kupfersulfat umgewandelt. Dazu wird das konzentrierte aufzubereitende Medium 141 in Schwefelsäure 143 aufgegeben. Dabei wandelt sich teilweise Kupferchlorid in Kupfersulfat um. Das Gleichgewicht dieser Reaktion liegt jedoch auf der Seite des Edukts, welches die vollständige Umwandlung zu Kupfersulfat verhindert und die Bildung des Kupferchlorids bevorzugt. Mittels der dritten Membrandialyse 130 ist es jedoch möglich die gebildete Salzsäure in-situ abzutrennen und so das Reaktionsgleichgewicht auf die Seite des Kupfersulfats zu treiben. Folglich werden während der Dialyse 130 kontinuierlich Kupfersulfat und Salzsäure gebildet, wobei letztere kontinuierlich abgetrennt wird. Als (dritter) Diffusat Zulauf 133 wird VE-Wasser verwendet. Im dritten Dialysat 135 befindet sich das umgewandelte Kupfersulfat (so dass das Metallsalz-haltige Medium 10 vorliegt), während sich die Säuren (Salzsäure und Schwefelsäure) auf der Seite des dritten Diffusats 136 ansammeln. Geringe Konzentrationen an Kupfer gelangen auch bei diesem Schritt in das dritte Diffusat 136, weswegen dieses dem Spülwasser-Aufbereitungsprozess 300 zugeführt wird. Dort kann Kupfer z.B. mittels eines selektiven Ionenaustauschharzes abgetrennt werden.

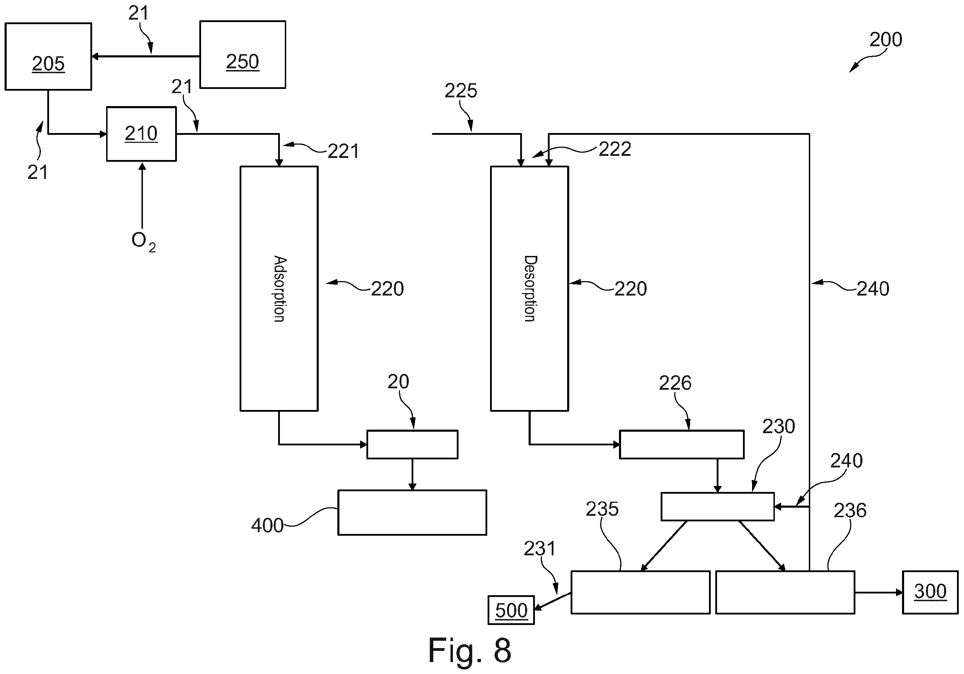

**Figur 8** zeigt den zweiten Aufbereitungsprozess 200 gemäß einem Ausführungsbeispiel der Erfindung, bei welchem ein Fremdmetall (insbesondere Eisen)- und Metallsalz-haltiges Medium 21 aus einem Galvanisierungsprozess 250 aus der Leiterplatten- und/oder Substrat-Herstellung aufbereitet wird, um das zweite Metallsalz-haltige Medium 20 bereitzustellen. Die folgenden Ausführungsbeispiele werden für Eisen als Fremdmetall exemplarisch beschrieben, gelten ebenso aber auch für andere Fremdmetalle, wie z.B.: Blei, Zinn, Molybdän, Nickel, Kobalt, Indium, Cadmium, Zink, Chrom, Natrium, Palladium.

Das Eisen- und Metallsalz-haltige Medium 21 wird zunächst aus dem Galvanisierungsprozess 250 in einem Speicher-Modul 205 bereitgestellt. Das Eisen- und Metallsalz-haltige Medium 21 ist eine stark saure Lösung mit einem pH-Wert unter 3 (insbesondere unter 1), welcher von einer starken Säure (insbesondere Schwefelsäure mit einer Konzentration in dem Bereich 100 bis 200 g/L) verursacht wird.

Als erster Schritt wird eine Oxidation 210 des Eisens von Fe²⁺ zu Fe³⁺ durchgeführt. Bevorzugt geschieht dies in einem Oxidationsmodul 210 mit Sauerstoff als Oxidationsmittel. In einem weiteren Schritt wird das oxidierte Eisen (zumindest teilweise) aus dem Eisen- und Metallsalz-haltigen Medium 21 separiert, um das (im Wesentlichen Eisen-freie) Metallsalz-haltige Medium 20 bereitzustellen. Für das Separieren wird ein Ionentauscher 220 mit einem selektiven Ionenaustauschharz, insbesondere Polystyrol aufweisend, verwendet. Hierfür wird der Ionentauscher 220 mit dem Eisen- und Metallsalz-haltigen Medium 21 beladen (Schritt 221), also derart durchströmt, dass das Eisen an dem Harz des Ionentauschers 220 adsorbiert. Den Ionentauscher 220 verlässt danach das Metallsalz-haltige Medium 20, welches im Wesentlichen Eisen-frei ist. Dieses kann dem Verfahren zum Rückgewinnen 400 des elementaren Metalls 50 aus dem Metallsalz-haltigen Mediums 20 zugeführt werden.

Das am Ionentauscher 220 adsorbierte Eisen muss jedoch entfernt werden, um den Ionentauscher 220 weiter einsetzen zu können. Dieses Regenerieren 222 wird dadurch ausgeführt, dass der Ionentauscher 220 von einer sauren Lösung 225 durchströmt wird, welche das Eisen löst, also desorbiert. Entsprechend wird das Eisen in der durchströmten sauren Lösung 225 gelöst als Eisen-haltige saure Lösung 226 vorliegen. Diese Eisen-haltige saure Lösung 226 wird mittels einer Säuredialyse 230 aufbereitet, um ein Eisen-haltiges Dialysat 235 und ein Säure-haltiges Diffusat 236 bereitzustellen. Die Säuredialyse 230 wird mittels Membrandialyse (z.B. wie oben beschrieben) durchgeführt, insbesondere wobei zumindest eine Membran der Membrandialyse eine Wickelmembran oder eine Plattenmembran aufweist.

Die Eisen-haltige saure Lösung 226 (bzw. das Säure-haltige Diffusat 236 mittels Rückführens 240) kann zu einem mehrfachen Regenerieren des Ionenaustauschers 220 genutzt werden. Hierbei kann die Eisen-haltige saure Lösung 226 in einem exemplarischen Beispiel (bis zu) fünf-sechs Mal als Regenerationsmedium herangezogen werden, bevor diese dann z.B. als Fällungsmittel 231 genutzt wird.

Das Trägermaterial des Ionenaustauschharzes des Ionentauscher 220 ist bevorzugt Polystyrol. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Eisen leichter vom Harz desorbiert werden. Gemäß einem Ausführungsbeispiel hat es sich überraschend herausgestellt, dass gerade das Verwenden dieses speziellen Ionenaustauschharzes mit den zwei funktionellen Gruppen eine (effiziente) Desorption des Eisens ermöglicht. Dies ist insbesondere deswegen beachtenswert, weil Ionenaustauschharze (insbesondere einfach-funktionalisierte) generell zu einer irreversiblen Adsorption des Eisens neigen.

Das Eisen-haltige Dialysat 235 kann an einen Prozess 500 bei der Leiterplatten- und/oder Substrat-Herstellung weitergeleitet 231 werden. Dieser Prozess 500 kann z.B. ein Fällen von Polymer-basiertem Fotolack (aus einem Abwasser) umfassen. In einem exemplarischen Ausführungsbeispiel weist das Eisen-haltige Dialysat 235 Eisenchlorid auf. In diesem Sinne kann also das Aufbereiten 200 eines Eisen- und Metallsalz-haltigen Mediums 21 aus einem Galvanisierungsprozess 250 zur Leiterplatten- und/oder Substrat-Herstellung als Ausgangsmaterial 231 verwendet werden zur (bevorzugt kontinuierlichen) Produktion von Eisenchlorid für das Fällen von Polymer-basiertem Fotolack für die gedruckten Leiterplatten und/oder Substrate.

Fotolacke bestehen generell aus photo-aktiven Initiatoren und einem Harz, wobei das Harz ein funktionalisiertes Polymer oder ein Copolymer sein kann. Harze für Positivlacke sind z.B. Lacke oder Phenol-Formaldehyd-basierte Polymere wie Novolac. Als Photoinitiator kann z.B. Diazonaphthoquinon (Mischung: DNQ-Novolac) verwendet werden. Harze für Negativlacke umfassen z.B. Harze auf Epoxid-Basis. Ferner gibt es auch Trockenlacke, welche z.B. auf Polyacrylaten basieren. In einem Ausführungsbeispiel lassen sich insbesondere Trockenlacke besonders effizient fällen.

Das Säure-haltige Diffusat 236 kann (insbesondere nach einem Aufbereiten) zu der Säuredialyse 230 oder dem (Säure-) Regenerieren 222 des Ionentauschers 220 rückgeführt werden. Bevorzugt wird das Säure-haltige Diffusat 236 in einem zweiten Abtrennstrom 6 dem Verfahren 300 zum Aufbereiten von Spülwasser aus der Leiterplatten- und/oder Substrat-Herstellung zugeführt. Dies insbesondere deswegen, weil das Säure-haltige Diffusat 236 geringe Konzentrationen des Metalls aus dem Metallsalz-haltigen Medium 20 aufweist.

Gemäß einem exemplarischen Ausführungsbeispiel weisen Eisen- und Metallsalz-haltige Medien 21 (Abfallkonzentrate) aus der Galvanik (Bleed) 250 Kupfersulfat und Schwefelsäure auf. Zusätzlich weisen diese Konzentrationen Eisen in Form von Eisensulfat, Fe²⁺, und Fe³⁺ auf. Während einem Rückgewinnen 400 (z.B. Elektrolyse) wird das Fe²⁺ an der Anode zu Fe³⁺ oxidiert, welches wiederum mit steigender Konzentration die Kupferabscheidung an der Kathode hemmt. Um das zu verhindern, muss das Eisen entweder vorab vom Elektrolyten abgetrennt werden, oder kontinuierlich während der Elektrolyse ausgetragen werden. Damit die Eisen-Ionen effizient mittels Ionenaustauschharz separiert getrennt werden können, werden diese in einem ersten Schritt oxidiert. Dazu wird der mit Eisen belastete Bleed 21 erst in einem Auffangbecken 205 gesammelt und mit einem geeigneten Oxidationsmittel (beispielsweise O₂, H₂O₂, Ozon, KMnO₄) behandelt. Der Vorteil der Behandlung mittels Sauerstoffs ist, dass keinerlei Rückstände vom Oxidationsmittel im Abfallkonzentrat verbleiben. In einem nächsten Schritt wird das aus dem Bleed 21 gewonnene Fe³⁺ mittels des selektiven Ionenaustauschharzes abgetrennt. Mehrere Ionenaustauscher 220 werden dazu in Serie installiert, welche ausschließlich Fe³⁺ am Harz immobilisieren, nicht jedoch Cu²⁺. Sobald der erste, in Reihe geschaltete Ionenaustauscher mit Fe³⁺ vollständig beladen 221 ist, und dieser beginnt durchzubrechen, wird dieser aus der Reihe genommen und mittels speziellem Regenerieren 222 wieder vom Fe³⁺ befreit. Die Abfallkonzentrate werden weiter über die restlichen Ionenaustauscher 220 geleitet. Der vormals zweite, in Serie geschaltete Ionenaustauscher, wird dabei zum Ersten. Beim Beladen des Harzes wird daher zurückgehaltenes Eisen von Kupfer getrennt. Der Ablauf 20 besteht in diesem Fall aus dem mit Kupfer beladenen Metallsalz-haltigen Medium 20, während das Eisen bis zur Regeneration 222 am Harz verbleibt. Das Metallsalz-haltige Medium 20 enthält Kupfer in Form von Kupfersulfat und Schwefelsäure. Die Regeneration des Harzes erfolgt mittels 30%-iger Salzsäure im Überschuss, welche mittels anschließender Säuredialyse 230 zurückgewonnen werden kann. Diese kann dadurch noch für beispielsweise sieben weitere Regenerationsschritte 222 verwendet werden. Bei der Regeneration 222 kommt es zu der Reaktion: Fe³⁺ + 4HCl -> FeCl₃ + HCl + 3H⁺. Das mittels der Säuredialyse 230 abgetrennte Eisenchlorid kann in einer Abwasseranlage des Prozesses 500 zur Fällung von Fotolack (polymerbasierten Trockenlack) verwendet werden.

Eine weitere Methodik, um das störende Eisen abzutrennen, besteht in einem thermischen Separieren (nicht gezeigt), z.B. Auskristallisieren. Hierfür wird das Eisen- und Metallsalz-haltige Medium 21 derart eingedampft, dass das Metallsalz auskristallisiert und das Eisen in einem Eisen-haltigen Medium verbleibt. Danach wird das Eisen-haltige Medium von dem Metallsalz separiert, und das Metallsalz in das Metallsalz-haltige Medium 20 überführt.

Gemäß einem exemplarischen Ausführungsbeispiel findet ein Auskristallisieren von Kupfersulfat aus dem Eisen- und Metallsalz-haltigen Medium 21 der Galvanik 250 statt. Dabei wird z.B. der mit Eisen verunreinigte Bleed 21 erst in Schwefelsäure aufgegeben und anschließend solange eingedampft, bis Kupfer als Kupfersulfat ausfällt. Das unterschiedliche Löslichkeitsprodukt von Kupfersulfat und Eisensulfat ermöglicht, dass das Eisen in Lösung bleibt, während Kupfersulfat aus der Lösung ausfällt. Dieses kann in einem weiteren Schritt abfiltriert werden und einem Rückgewinnen 400 zugeführt werden. Dieser Prozess kann mehrfach wiederholt werden, um eine immer höhere Reinheit der Kupfersulfat (-Kristalle) zu erzielen. In einem exemplarischen Beispiel kann eine sehr hohe Reinheit bereits nach dem zweiten Auskristallisieren erzielt werden. Zusätzlich oder alternativ kann das ausgefallene und abfiltrierte Kupfersulfat nochmals in Schwefelsäure gelöst werden, und dem Ionenaustauschharz 220 zur Eiseneliminierung (Entfernen von Rest-Eisen) zuführt werden.

In einem weiteren Beispiel kann das Kupfersulfat dem Galvanikprozess 250 direkt zurückgeführt werden. Während der Galvanisierung kann Kupfer in Form von Kupfersulfat dem Elektrolyten zudosiert werden. In diesem speziellen Ausführungsbeispiel kann auf ein Rückgewinnen 400 (z.B. über Elektrolyse) verzichtet werden. Dies kann dadurch ermöglicht sein, dass ein wesentlicher Teil des Fremdmetalls (insbesondere des Eisens) entfernt worden ist. Hierbei müsste dann nur der aufbereitete Teilstrom 1 aus dem Ätzprozess 150 elektrolytisch aufbereitet werden. Dies kann dann zu einem sortenreinen Rückgewinnen (Teilstrom 1 (optional Teilstrom 3), nicht Teilstrom 2) führen.

**Figur 9** zeigt den dritten Aufbereitungsprozess 300 gemäß einem Ausführungsbeispiel der Erfindung zum Aufbereiten eines aufzubereitenden Mediums 31 aus Spülwasser aus der Leiterplatten- und/oder Substrat-Herstellung, um ein drittes Metallsalz-haltiges Medium 30 bereitzustellen. Das aufzubereitende Medium 31 wird bereitgestellt (siehe Schritt 305) durch Mischen einer Vielzahl von Spülwässern des Leiterplatten Herstellungsprozesses. Ein erstes Spülwasser ist ein Diffusat 136 aus dem ersten Aufbereitungsprozess 100 zum Aufbereiten von Rückständen aus dem Ätzprozessen 150, welches über den ersten Abtrennstrom 5 bereitgestellt wird. Ein zweites Spülwasser ist ein Diffusat 236 aus dem zweiten Aufbereitungsprozess 200 zum Aufbereiten von Rückständen aus der Galvanik 250, welches über den zweiten Abtrennstrom 6 bereitgestellt wird. Ein drittes Spülwasser ist ein Diffusat 446aus dem Rückgewinnen 400 von elementarem Metall 50 aus den aufbereiteten Rückständen, welches über den dritten Abtrennstrom 7 bereitgestellt wird. Ferner können noch weitere Spülwässer 32 aus dem Leiterplattenprozess (falls anfallend) bereitgestellt werden. Diese resultieren letztendlich aus dem Prozess zugeführtem Wasser 352. Die beschriebenen Abtrennströme 5, 6, 7, 352 können alle gemischt werden, teilweise gemischt werden, oder separat voneinander aufbereitet werden.

In einem weiteren Ausführungsbeispiel wird der Ionenaustauscher 320 der Spülwässer mit verbrauchtem Elektrolyt 41, der nur noch eine geringe Konzentration an Kupfer aufweist, regeneriert. Während der Elektrolyse 450 entsteht Schwefelsäure, welche vom Elektrolyt 40 abgetrennt werden muss, um die gewünschte Abscheiderate erhalten zu können. Mit steigender Schwefelsäurekonzentration nimmt die Menge an abzuscheidendem Kupfer 50 ab. Würde Säure beispielsweise kontinuierlich mittels Membrandialyse 440 vom Elektrolyten 40 getrennt werden, würde hierfür wieder eine große Menge an Wasser eingesetzt werden. Dies erfordert (Energie-intensive) Maßnahmen wie einen Verdunsterturm, um die Säure in einer geeigneten Konzentration wieder zurückgewinnen zu können. Eine Alternative hierzu ist das Betreiben der Elektrolyse 450 nur so lange, bis der Elektrolyt 40 eine definierte Säure- und Kupfer Konzentration (z.B. Cu²⁺ etwa 5 g/L) erreicht hat. Anschließend kann dieser verbrauchte Elektrolyt 41 für die Regeneration des Ionenaustauschers 320 zur Aufbereitung der Spülwässer 300 herangezogen werden. Dadurch verbleibt das Kupfer im Wertstoffkreislauf und die Säure muss nicht über eine Dialyse 440 in einem zusätzlichen Prozessschritt abgetrennt werden.

In einem exemplarischen Ausführungsbeispiel kann während der Elektrolyse 450 ein großes Volumen Schwefelsäure (z.B. 1000 L pro Tag) anfallen. Dadurch kann (im Wesentlichen) die gesamte Menge an produzierter Schwefelsäure als Regeneriersäure (bzw. Regeneriermedium) für das Aufbereiten 300 von Spülwässern herangezogen werden. Dies kann den Vorteil bereitstellen, dass (im Wesentlichen) keine Schwefelsäure in den Wertstoffkreislauf zugeführt (bzw. zugekauft) werden muss. In einem spezifischen Ausführungsbeispiel kann dennoch mit frischer Schwefelsäure "nachgeschärft" werden.

In einem weiteren Ausführungsbeispiel wird der Überschuss an Schwefelsäure zusätzlich (abgesehen von der Aufbereitung 300 bzw. Regeneration der Spülwässer) in ein Vorbehandlungsbecken 310 der Spülwässer geleitet. Hierin wird die Schwefelsäure zuerst neutralisiert 311 und anschließend dem Ionenaustauschharz 320 zugeführt. Dadurch kann die Restkonzentration an Kupfer (im verbrauchten Elektrolyten 41) in dem Wertstoffkreislauf erhalten und zurückgewonnen werden.

Das (gemischte) aufzubereitende Medium 31 wird einer Vorbehandlung 310 unterzogen, denn es können sehr niedrige pH-Werte vorliegen (durch die starken Säuren in den Diffusaten). Ferner können starke Oxidationsmittel wie Wasserstoffperoxid vorliegen, welche reduziert werden müssen. Einstellen des pH-Werts (bei 311) (Neutralisieren) des aufzubereitenden Mediums 31 kann z.B. mittels Natronlauge auf einen Wert im Bereich 1 bis 3 (insbesondere 2) durchgeführt werden. Chemisches Reduzieren (bei 312) des aufzubereitenden Mediums 31 gelingt mittels eines Reduktionsmittels, beispielsweise Bisulfit.

Sowohl ein stark saurer pH-Wert als auch starke Oxidationsmittel wie Wasserstoffperoxid greifen das Ionenaustauschharz an. Insbesondere Wasserstoffperoxid zersetzt sukzessive das Harz. Bevorzugt wird bei Ionenaustauschharz für Spülwässer, aus welchen Wasserstoffperoxid bereits im Wesentlichen entfernt wurde, ein mit Iminodiessigsäure-funktionalisiertes Polystyrol verwendet. Im Falle von Spülwässern, aus welchen Wasserstoffperoxid nicht entfernt wurde, wird bevorzugt ein Wasserstoffperoxid-beständiges (bzw. Oxidationsmittel-beständiges) Harz mit einem Trägermaterial aus Polystyrol verwendet, welches zusätzlich noch mittels Divinylbenzol quervernetzt ist. Diese zusätzliche Quervernetzung schützt das Polymer effektiv vor dem Oxidationsmittel. Dieses Harz kann in einem exemplarischen Beispiel mit einer maximalen Konzentration an 20g/L Wasserstoffperoxid beladen werden.

Zusätzlich oder alternativ kann das Vorbehandlungsbecken 310 mit einem Aktivkohle-Filter 313 gekoppelt werden, welcher das Wasserstoffperoxid zersetzt. Dies hat den Vorteil, dass zeitgleich und ohne weitere Aufwendungen organische Reste aus den Spülwässern entfernt werden können. Insbesondere kann der Aktivkohlefilter 313 an das Vorbehandlungsbecken 310 gekoppelt werden, um organische Bestandteile zu filtern. Dies kann den Vorteil bereitstellen, dass ein erwünschter CSB-Wert (und eine entsprechende Einleitqualität) des Mediums erreicht werden kann.

Das eigentliche Aufbereiten wird mittels eines Ionentauscher-Moduls 340 durchgeführt. Zunächst wird ein Ionentauscher 320 mit dem aufzubereitenden Medium 31 derart beladen, dass das Metall, welches das aufzubereitende Medium 31 aufweist, an dem Ionentaucher 320 verbleibt. Dadurch strömt aus dem Ionentauscher 320 ein Abwasser 327, welches im Wesentlichen Wasser, Salz (z.B. Magnesium-, Natrium-, Calcium-Salze), und Organik aufweist und (im Wesentlichen) Schwermetall-frei ist. Dieses Abwasser Medium 350 weist daher eine Einleitqualität in Kläranlagen auf. Die Konzentration an Schwermetall ist 15 mg/L oder weniger, insbesondere ist die Konzentration an Kupfer 0,5 mg/L oder weniger (und liegt damit z.B. innerhalb der gesetzlichen Grenzwerte der Republik Österreich). Das Abwasser Medium 350 in Einleitqualität wird derart aufgereinigt (z.B. in einer Prozess-internen Kläranlage 351), dass das Medium in Gewässer einleitbar ist. Diese Aufreinigung bezieht sich nicht auf Schwermetalle, sondern auf Organik-Reste. Diese können z.B. über Aktivkohlefilter einfach entfernt werden. Beispielsweise kann nach dem Aufreinigen (351) der CSB (chemischer Sauerstoffbedarf)-Wert, als Maß für die Konzentration organischer Verbindungen, in dem Medium in Einleitqualität 350 weniger als 300 mg/L, insbesondere weniger als 75 mg/L (weiter insbesondere weniger als 65 mg/L), betragen. Der CSB Wert kann hierbei die Menge an Sauerstoff (in mg/L) angeben, die zu der Oxidation der oxidierbaren Stoffe benötigt würde, wenn Sauerstoff das Oxidationsmittel wäre. Beispielsweise in Österreich liegt dieser Grenzwert per Gesetz bei 75 mg/L. Der CSB-Grenzwert für Kläranlagen kann stark variieren, und beträgt in einem Beispiel 300 mg/L.

In einem exemplarischen Beispiel ist der Ionenaustauscher 320 zweistufig aufgebaut. Der nachgeschaltete (zweite) Ionenaustauscher nimmt den Kupferrest des vorangeschalteten (zu beladenden) Ionenaustauschers auf und dient als Absicherung zur Einhaltung der Schwermetall-Grenzwerte (siehe Einleitqualität). Weist der erste Ionentauscher einen erhöhten Kupferrest auf, kann dieser regeneriert und anschließend an die nachgeschaltete (zweite) Stelle geschaltet werden (siehe hierzu auch die Beschreibung des Ionentauschers 220 oben).

Danach findet ein Regenerieren 322 des Ionentauschers 320 statt mittels Strömens eines Regeneriermediums 325, 326 durch den Ionentauscher 320. Dadurch wird das Metall zumindest teilweise in dem Regeneriermedium 325, 326 gelöst und ein Regenerat 326 wird bereitgestellt. Zunächst kann der Ionentauscher 320 von einer weiteren Säure 325 (z.B. Schwefelsäure) als Regeneriermedium 325 durchströmt (bei 322) werden. Die weitere Säure 325 kann direkt bereitgestellt werden und/oder aus einem Abtrennstrom 5, 6, 7 der Leiterplatten- und/oder Substrat-Herstellung stammen, insbesondere aus dem Verfahren zum Rückgewinnen (bzw. Erzeugen) 400 (Diffusat 446 über den dritten Abtrennstrom 7). Um eine erwünschte Effizienz zu gewährleisten, soll bevorzugt das Regeneriermedium 325, 326 (zumindest teilweise) Verfahrens-intern erzeugt sein. Damit ist also ein Rückgewinnen des Regeneriermediums 325, 326 vorgesehen. Daher ergibt sich für das Regeneriermedium eine Zusammensetzung aus weiterer Säure 325 und Regenerat 326. Das erhaltene Regenerat 326 weist neben der Regeneriersäure eine Metall-Konzentration (z.B. Kupfer, in Schwefelsäure als Kupfersulfat vorliegend) auf. Diese Konzentration kann durch mehrere Regenerierschritte 322 deutlich erhöht werden, so dass entsprechend eine Mehrzahl von Regenerierschritten vorgesehen sind. Diese Anforderung deckt sich vorteilhaft mit dem erwünschten Rückgewinnen des Regeneriermediums 325, 326. Das erhaltene Regenerat 326 wird einem Regenerat Speicher-Modul 328 zugefügt. Dort kann es, falls notwendig, mit weiterer Säure 325 gemischt werden. Von dem Regenerat Speicher-Modul 328 durchströmt (bei 322) das Regenerat 326, welches bereits eine Metall-Konzentration aufweist, ein zweites Mal den Ionentauscher 320. Dabei wird die Metall-Konzentration erneut erhöht durch Metall, welcher noch an dem Ionentauscher 320 adsorbiert war. Nach diesem zweiten Regenerierschritt 322 folgt ein dritter Regenerierschritt 322 mit dem Regenerat 326, so dass nachfolgend einer Mehrzahl von Regenerierschritten (z.B. fünf oder mehr) die Metall-Konzentration im Regenerat 326 immer weiter ansteigt, während immer weniger Metall in dem Ionentauscher 320 verbleibt. Wenn eine erwünschte (Metall) Mindestkonzentration in dem Regenerat 326 erreicht ist, kann das Regenerat 326 dem Ionentauscher-Modul 340 als Metallsalz-haltiges Medium 30 entzogen werden (Pfeil 329). Das Metallsalz-haltige Medium 30 kann dann über den dritten Teilstrom 3 einem Verfahren zum Rückgewinnen 400 des elementaren Metalls 50 aus dem Metallsalz-haltigen Medium 30 zugeführt werden. Mit Vorteil wird das beschriebene Aufbereitungsverfahren 300 kontinuierlich betrieben.

Gemäß einem exemplarischen Ausführungsbeispiel enthalten aufzubereitende Medien 31 (Abfallkonzentrate) aus den Spülwässern der Leiterplatten- und/oder Substrat-Herstellung vergleichsweise nur geringe Konzentrationen an Kupfer, welche in Form von Kupfersulfat vorliegen. Das vorliegende Kupfer wird daher mittels eines selektiven Ionenaustauschharzes 320 (selektiv für Kupfer) von den Abfallkonzentraten 31 getrennt. Das am Harz immobilisierte Kupfer wird anschließend über eine spezielle Regeneriertechnik gelöst. Während konventionell Harze mittels Salzsäure bei einem maximalen Gehalt von 1,5 bis 8 Gewichtsprozent regeneriert werden, haben die Erfinder überraschend festgestellt, dass die Regeneration 322 auch mit stark konzentrierten Säuren effizient durchführbar ist. Daher kann das Kupfer z.B. mittels konzentrierter Schwefelsäure 325 vom Harz gelöst werden.

In einem exemplarischen Ausführungsbeispiel werden folgende Parameter verwendet: H₂SO₄ Konzentration: ca. 1,5-8 Gewichtsprozent; H₂SO₄ Menge (Gleichstrom): mindestens 120 g/L Harz; und H₂SO₄ Menge (Gegenstrom): mindestens 80 g/L Harz. Insbesondere kann aber eine SchwefelsäureKonzentration von etwa 25 Gewichtsprozent verwendet werden, die nach dem ersten Regenerieren auf ca. 20 Gewichtsprozent sinkt. Das Regenerieren wird bevorzugt im Gegenstrom betrieben, um die Menge an benötigter Säure für die Regeneration geringstmöglich zu halten. Das Einsparungspotential kann ca. 30% Säure betragen, wenn im Gegenstrom regeneriert wird.

Die somit generierte Kupfersulfat-Lösung als Regenerat 326 kann direkt für die Rückgewinnung 400 herangezogen werden. Dadurch kann das Volumen an Schwefelsäure 325, das zur Regeneration 322 des Harzes benötigt wird, geringgehalten werden. Die volumengesteuerte Regeneration 322 mittels konzentrierter Schwefelsäure 325, 326 funktioniert kontinuierlich oder diskontinuierlich. Das Harz wird daher nach der Immobilisierung des Kupfers abgesenkt und gespült, bevor das Harz mit konzentrierter Schwefelsäure regeneriert 322 werden kann. Die Schwefelsäure 325, 326 wird für mehrere Regenerationsschritte 322 verwendet (rückgewonnen), um eine ausreichend hohe Konzentration an Kupfer im Metallsalz-haltigen Medium 30 zu erzielen. Im Vergleich zu konventionellen Regeneriertechniken fällt nur wenig flüssiges Medium an und es muss kein Wasser mehr aus dem Regenerat 326 entfernt werden.

**Figur 10** zeigt den dritten Aufbereitungsprozess 300 des Metallsalz-haltigen Mediums aus einem Spülprozess aus der Leiterplatten- und/oder Substrat-Herstellung, welcher in Figur 9 im Detail beschrieben wurde, nochmals aus Gründen der Übersicht als Flussdiagram.

**Figuren 11** zeigt das Verfahren 400 zum Rückgewinnen von elementarem Metall 50 aus einem Metallsalz-haltigen Medium 40 aus der Leiterplatten- und/oder Substrat-Herstellung gemäß einem Ausführungsbeispiel der Erfindung. Das Verfahren 400 umfasst ein Bereitstellen 405 des Metallsalz-haltigen Mediums 40, welches ein Metallsalz (z.B. Kupfersulfat) und ein Fremdmetall (z.B. Eisen) aufweist, wobei das Fremdmetall chemisch unedler ist als das (abzuscheidende) Metall.

Das Standardpotential (Redoxpotential, bzw. nach DIN 38404-6 "Redox-Spannung") des Fremdmetalls muss hierfür also niedriger sein als das Redoxpotential des abzuscheidenden Metalls.

Metalle mit hohem Redoxpotential (abzuscheidende Metalle) sind beispielsweise: Kupfer Cu²⁺, E⁰ = +0,35V; Kupfer Cu⁺, E⁰ = +0,52V, Palladium Pd²⁺, E⁰ = +0,85V; Gold Au³⁺, E⁰ = +1,4V; Gold Au³⁺, E⁰ = +1,5V; Gold Au⁺, E⁰ = +1,69V; Iridium Ir³⁺, E⁰ = +1,156V; Silber Ag⁺, E⁰ = +0,8V.

Metalle mit hohen Redoxpotential (Fremdmetalle) sind beispielsweise: Eisen Fe³⁺, E⁰ = -0,04V; Eisen Fe²⁺, E⁰ = -0,41V; Blei Pb²⁺, E⁰ = -0,13V; Zinn Sn²⁺, E⁰ = -0,14V; Molybdän Mo³⁺, E⁰ = -0,20V; Nickel Ni²⁺, E⁰ = -0,23V; Kobalt Co²⁺, E⁰ = -0,28V; Indium In³⁺, E⁰ = -0,34V; Cadmium Cd²⁺, E⁰ = -0,40V; Zink Zn²⁺, E⁰ = -0,76V; Chrom Cr³⁺, E⁰ = -0,76V; Natrium Na⁺, E⁰ = -2,71V. Insbesondere bei Eisen (Fe³⁺ -> Fe²⁺, E⁰ = + 0,77) findet eine Reaktion statt, bei welcher durch das Fe²⁺ abgeschiedenes Kupfer wieder von der Elektrode weggeätzt wird.

Das elementare Metall 50 (z.B. Kupfer) des Metallsalz-haltigen Mediums 40 soll in einer Reaktionszelle 450 in reiner Form rückgewonnen werden, um dem Prozess zum Herstellen von Leiterplatten und/oder Substraten erneut zugeführt zu werden. Insbesondere wird das elementare Metall 50 in den Galvanisierungsprozess 250 rückgeführt (bei 54). Optional kann auch elementares Metall 50 in den Ätzprozess 150 rückgeführt werden (bei 52). Unedles Fremdmetall stört die Rückgewinnung des elementaren Metalls 50, welche bevorzugt im Rahmen einer Elektrolyse 451 durchgeführt wird. Anstelle eines aufwendigen weiteren Aufbereitungsprozesses (das Metallsalz-haltige Medium 40 stammt in bestimmten Fällen bereits aus drei verschiedenen Aufbereitungsprozessen 100, 200, 300), findet nun in der Reaktionszelle 450 ein Oxidieren 452 des Fremdmetalls statt.

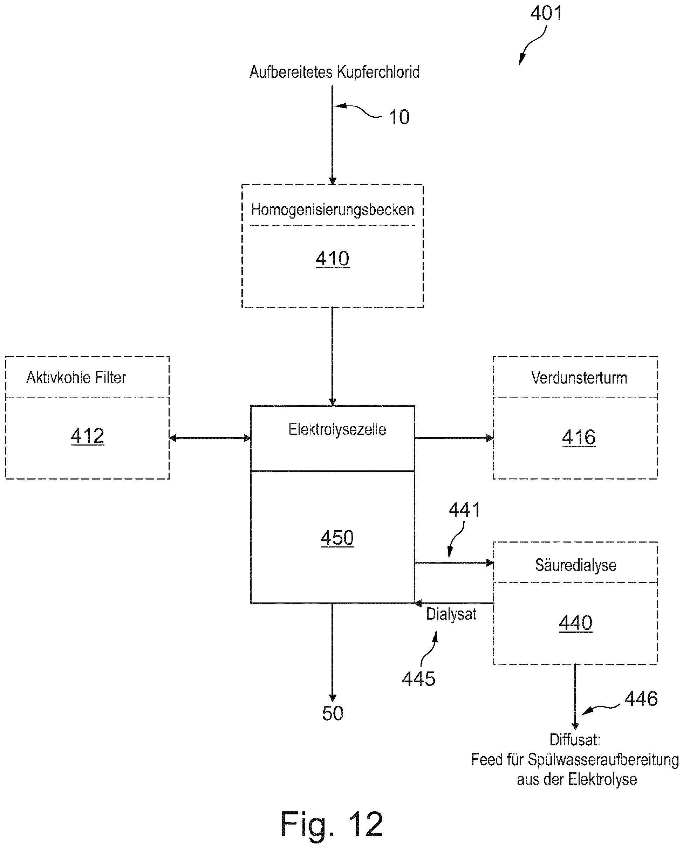

Das Metallsalz-haltige Medium 40 wird bereitgestellt aus i) dem Metallsalz-haltigen Medium 10 aus dem Ätzprozess 150 mittels des ersten Teilstroms 1, ii) dem Metallsalz-haltigen Medium 20 aus dem Galvanisierungsprozess 250 mittels des zweiten Teilstroms 2, und iii) dem Metallsalz-haltigen Medium 30 aus dem Verfahren 300 zum Aufbereiten von Spülwasser. Diese Teilströme 1, 2, 3 werden gemischt (siehe Schritt 405) zu einem Gesamtteilstrom 4, welcher dem Rückgewinnen 400 zugeführt wird. Gemäß einem Ausführungsbeispiel (siehe Figur 12 unten) kann der erste Teilstrom 1 auch alleine als Gesamtteilstrom 4 verwendet werden. Dies insbesondere dann, wenn das Metallsalz-haltige Medium 10 des ersten Teilstroms 1 nicht vernachlässigbare Rückstände an aufzubereitendem Metallsalz (z.B. Kupferchlorid) und/oder Säure aufweist. Das Metallsalz-haltige Medium 20 aus dem Galvanisierungsprozess 250 und das Metallsalz-haltige Medium 30 aus dem Verfahren 300 zum Aufbereiten von Spülwasser können dann beispielsweise zu einem weiteren Gesamtstrom 4 vermischt werden.

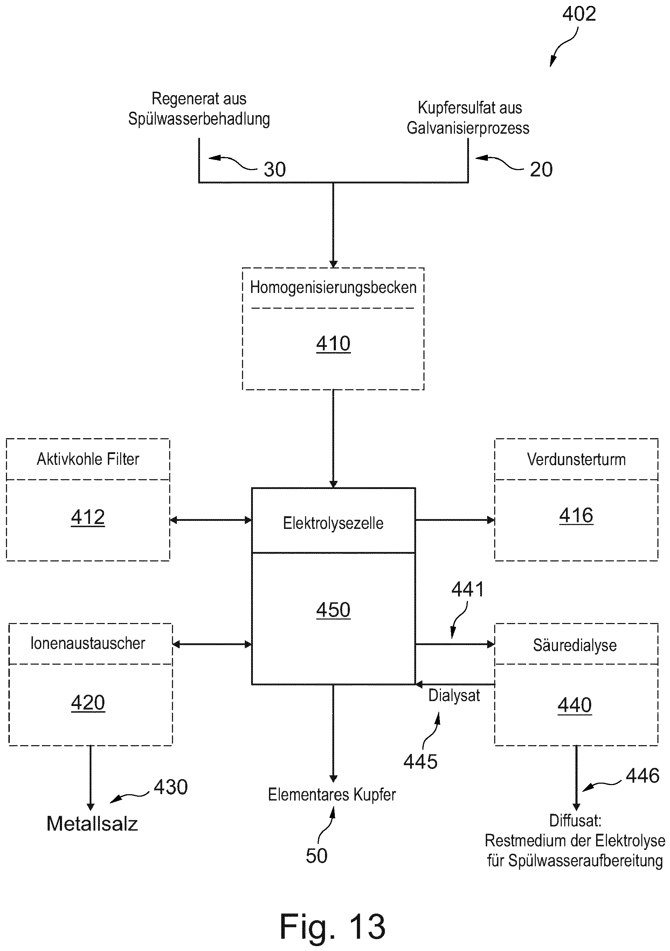

Der Gesamtstrom 4 mit dem Metallsalz-haltigen Medium 40 wird in ein Versorgungsbecken bzw. Harmonisierungsbecken 410 geleitet, welches mit der Reaktionszelle 450 in beidseitiger Fluidkommunikation 419a, b verbunden ist. In dem gezeigten Ausführungsbeispiel wird das Versorgungsbecken 410 verwendet, um die Zusammensetzung des Metallsalz-haltigen Mediums 40 (welches den Elektrolyten 40 für die Elektrolyse 451 in der Reaktionszelle 450 darstellt) zu regeln. Bevorzugt wird das Verfahren zum Rückgewinnen 400 kontinuierlich betrieben, so dass das Versorgungsbecken 410 in vorteilhafter Weise eine gewünschte Zusammensetzung des Elektrolyten 40 regelt. Alternativ oder zusätzlich kann das Einstellen der Zusammensetzung des Elektrolyten 40 (bzw. ein kontinuierlich durchgeführtes Regeln) auch direkt von der Reaktionszelle 450 aus erfolgen (siehe hierzu z.B. die Figuren 12 und 13 unten). Die Reaktionszelle 450 weist bevorzugt eine Mehrzahl (z.B. zwanzig) Elektrolyse Module 451 (E-Module) auf, in welchen elementares Metall 50 (z.B. Kupfer) an einer Kathode abgeschieden wird. Bei dieser Reaktion kommt es zur Oxidation 452 von Fremdmetall (des Elektrolyten 40), welches chemisch unedler als das abzuscheidende Metall ist (siehe oben). Ferner weist die Reaktionszelle 450 eine Mehrzahl von Löse-Modulen 455 (L-Module) auf, in welchen das elementare Metall 50 von der Kathode wieder abgetrennt wird, um das elementare Metall 50 in hochreiner Form zu erhalten, welche für ein Wiederverwenden 52, 54 in der Leiterplatten- und/oder Substrat-Herstellung geeignet ist. Abtrennen kann z.B. mittels Säure erfolgen, um eine hochreine Metallsalz-Lösung bereitzustellen. Auch ein mechanisches Abtrennen ist möglich, um das Metall als hochreine Partikel zu erhalten, welche z.B. in Platten umgeformt werden können. Die Reaktionszelle 450 wird mit Vorteil kontinuierlich betrieben. Beispielsweise kann ein kontinuierlicher Transport zwischen E-Modulen 451 und L-Modulen 455 stattfinden. Dies kann z.B. mittels eines flexiblen Transportsystems (nicht gezeigt) realisiert werden (z.B. an der Decke entlang fahrende Vehikel oder Greifer), welche u.a. beladene Kathoden aus den E-Modulen 451 in leere L-Module 455 transportieren und danach die abgereicherten Kathoden nach dem Abtrennen des Metalls 50 wieder in ein leeres E-Modul 451 positionieren.

Das Rückgewinnen 400 kann von einem System 460 unterstützt werden, welches die Luftzirkulation regelt. Hierbei können die Zuluft 462 und die Abluft 461 geregelt werden und über Wärmetauscher die Temperatur. Gesättigte Abluft 464 (z.B. aus einem Verdunster 416) kann einem Filter 463 zugeführt werden. Der Verdunster 416 (z.B. ein Verdunsterturm) kann verwendet werden zum Aufkonzentrieren des Metallsalzes in dem Metallsalz-haltigen Medium 40. Natürliche Verdunstung (die Elektrolyse wird z.B. bei etwa 50°C oder 60°C (insbesondere in dem Bereich 40°C bis 70°C) betrieben) ist in Block 465 dargestellt. Die Temperatur des Elektrolyten 40 wird in dem Bereich von etwa 40°C bis 60°C durch einen Temperaturregler 414, z.B. eine Heizung, eingestellt.

Das Einstellen (insbesondere kontinuierliche Regeln) der Zusammensetzung des Metallsalz-haltigen Mediums 40 (von dem Versorgungsbecken 410 und/oder von der Reaktionszelle 450 aus) umfasst im Wesentlichen drei Schritte: i) Filtern von organischen Bestandteilen mittels eines Filters 412, bevorzugt eines Aktivkohlefilters, aus dem Metallsalz-haltigen Medium 40, ii) Separieren des oxidierten Fremdmetalls aus dem Metallsalz-haltigen Medium 40 mittels eines Ionentauschers 420, und iii) Separieren 440 von Säure (insbesondere Schwefelsäure) aus dem Metallsalz-haltigen Medium 40.

Der Ionentauscher 420 weist ein selektives Ionenaustauschharz, insbesondere Polystyrol (siehe weitere Spezifizierungen eines Ionentauscher(harze)s oben), auf (z.B. 1000 L Harzvolumen bei einem Harzgewicht von 700 kg). Das Metallsalz-haltige Medium 40 wird (nach einem optionalen Aufkonzentrieren mittels des Verdunsters 416) über ein Pumpvorlage-Modul 415 dem Ionentauscher 420 derart zugeführt, dass dieser mit dem Metallsalz-haltigen Medium 40, in welchem das Fremdmetall oxidiert vorliegt, beladen (siehe Schritt 421) wird. Das Fremdmetall adsorbiert hierbei an dem Harz des Ionentauschers 420. Das dadurch erhaltene Metallsalz-haltige Medium 40 ist im Wesentlichen frei von dem oxidierten Fremdmetall und kann zurück in die Reaktionszelle 450 oder das Versorgungsbecken 410 geleitet werden. In dem gezeigten Beispiel wird das erhaltene Metallsalz-haltige Medium 40 als Dialyse Zulauf 441 für das Separieren 440 von Säure aus dem Metallsalz-haltigen Medium 40 verwendet (siehe Beschreibung unten).

Der beladene Ionentauscher 420 wird regeneriert (bei 422) mittels Strömens einer sauren Lösung 425 durch den Ionentauscher 420. Dies bevorzugt im Gegenstrom, um die Menge an benötigter Säure für die Regeneration geringstmöglich zu halten. Das Einsparungspotential kann hierbei z.B. ca. 30% Säure betragen.

Dadurch wird das Fremdmetall in der sauren Lösung 425 gelöst und eine Fremdmetall-haltige saure Lösung 426, 430 wird als Regenerat 426 erhalten. Um ein kontinuierliches Rückgewinnen zu ermöglichen, wird des Regenerats 426 (zumindest teilweise) als weiteres Regeneriermedium 425, 426 für mehrere weitere Regenerierschritte 422 in dem Ionentauscher 420 verwendet. Bevorzugt steigt mit jedem Regenerierschritt 422 die Konzentration an Fremdmetall in dem Regenerat 426 an, so dass nach einigen Regenerierschritten 422 ein konzentriertes Regenerat 430 vorliegt. Die Fremdmetall-haltige saure Lösung des Regenerats 426 bzw. das konzentrierte Regenerat 430 werden bereitgestellt (siehe Schritt 431) an einen weiteren Prozess 500 bei der Leiterplatten- und/oder Substrat-Herstellung. Gemäß einem exemplarischen Ausführungsbeispiel handelt es sich bei dem Fremdmetall um Eisen und bei der Säure 425 um Salzsäure, so dass im Regenerat 430 Eisenchlorid gebildet wird. Dieses kann z.B. als Fällungsmittel verwendet werden, um Fotolack (siehe oben) aus Abwässern bzw. Prozesswässern zu fällen. Gemäß einem exemplarischen Ausführungsbeispiel kann das Separieren 420 des Fremdmetalls als eigenständiger Prozess betrieben werden, um (insbesondere kontinuierlich) Eisenchlorid zu produzieren.

Während der Elektrolyse 450 entsteht Schwefelsäure, welche vom Elektrolyt 40 abgetrennt werden muss, um die gewünschte Abscheiderate erhalten zu können. Mit steigender Schwefelsäurekonzentration nimmt die Menge an abzuscheidendem Kupfer 50 ab. Das Separieren 440 der Säure weist das Durchführen einer Membrandialyse auf. Das Metallsalz-haltige Medium (bzw. der Elektrolyt) 40 werden der Membrandialyse 440 als Dialysat 441 zugeführt. Ein Zulauf 443 des Diffusats der Membrandialyse 440 beinhaltet entsalztes Wasser. Die Membran 442 kann aufgebaut sein wie oben für die anderen Membrandialysen beschrieben. Durch das Separieren 440 wird das Metallsalz-haltige Medium 40 mit einer deutlich geringeren Säure-Konzentration als Dialysat 445 erhalten, während das Diffusat 446 eine hohe Säure-Konzentration (insbesondere Schwefelsäure) aufweist. Das Säure-haltige Diffusat 446 wird im Zuge des dritten Abtrennstroms 7 an das Verfahren 300 zum Aufbereiten von Spülwasser aus der Leiterplatten- und/oder Substrat-Herstellung bereitgestellt (siehe Schritt 447) bzw. rückgeführt.

Eine Alternative bzw. Ergänzung (eine kontinuierliche Membrandialyse 440 vom Elektrolyten 40 erfordert ein großes Volumen an Wasser, was wiederum Maßnahmen wie einen Verdunsterturm erfordert, um die Säure in einer geeigneten Konzentration wieder zurückgewinnen zu können) hierzu ist das Betreiben der Elektrolyse 450 nur so lange, bis der Elektrolyt 40 eine definierte Säure- und Kupfer Konzentration (z.B. Cu²⁺ etwa 5 g/L) erreicht hat. Anschließend kann dieser verbrauchte Elektrolyt 41 für die Regeneration des Ionenaustauschers 320 zur Aufbereitung 300 der Spülwässer herangezogen werden. Dadurch verbleibt das Kupfer im Wertstoffkreislauf und die Säure muss nicht (kontinuierlich) über eine Dialyse 440 in einem zusätzlichen Prozessschritt abgetrennt werden.

**Figur 12** zeigt den Prozess zum Rückgewinnen 400 des elementaren Metalls 50 aus dem Metallsalz-haltigen Medium 40, welcher für Figur 11 oben im Detail beschrieben wurde, nochmals aus Gründen der Übersicht als Flussdiagram. In diesem exemplarischen Ausführungsbeispiel wird als Metallsalz-haltiges Medium 40 das Metallsalz-haltige Medium 10 aus dem Aufbereiten der Rückstände 11 des Ätzprozesses 150 verwendet (zunächst in ein Harmonisierungsbecken 410 eingeleitet). Das Einstellen bzw. Regeln der Zusammensetzung des Metallsalz-haltigen Mediums 40 wird von der Reaktionszelle 450 aus durchgeführt. Diese steht in Fluidkommunikation mit dem Aktivkohlefilter 412, dem Verdunster (-turm) 416, und der Membrandialyse 440. Der Ionentauscher 420 ist in diesem exemplarischen Ausführungsbeispiel nicht notwendig, da das Metallsalz-haltige Medium 10 (aus dem Aufbereiten der Rückstände 11 des Ätzprozesses 150) nur geringe Konzentration an Fremdmetallen (z.B. Eisen) aufweist.

In einem exemplarischen Ausführungsbeispiel ist das aufzubereitende Metallsalz 11 Kupferchlorid. Ein Großteil des Chlorids kann mittels der Membrandialysen 110, 120, 130 und dem Umsalzen 140 entfernt werden, allerdings kann noch ein Restgehalt an Chlorid im Elektrolyten 40 verbleiben. Eine zu hohe Chlorid-Konzentration im Elektrolyten 40 kann zu einer Chlorid Verunreinigung des abgeschiedenen Kupfers 50 führen. Mit steigender Chlorid Konzentration steigt auch die potentielle Bildung von Chlorgas. Daher kann die Elektrolyse-Zelle 450 zusätzlich mit einer Absaugung ausgestattet sein, welche einen Chlorgas-Austritt verhindern soll. Chlorgas ist ein schweres Gas, das sich an der Elektrolysebad-Oberfläche absetzt. Daher wird eine Luftzufuhr und Luft-Absaugvorrichtung (prinzipiell von links nach rechts in der Figur) entlang der Badoberfläche installiert. Die abgesaugte Luft wird dann über einen Filter (Luftwäscher) wieder aus dem Prozess geleitet.

Damit die abgeschiedene Kupfermenge die entsprechende Reinheit für eine mögliche Rückführung in den Prozess erzielt, darf die Chlorid Konzentration nicht zu hoch werden. Der Grenzwert liegt hierbei in einem Ausführungsbeispiel bei ca. 3 g/L Cl⁻ im Elektrolyten. Ein sortenreines Verwenden des Metallsalz-haltigen Mediums 10 aus Teilstrom 1 kann daher den Vorteil haben, dass bei zu hoher Chlorid-Konzentration die Kupferabscheidung separat von den anderen Trennströmen 2, 3 durchgeführt wird.

**Figur 13** zeigt den Prozess zum Rückgewinnen 400 des elementaren Metalls 50 aus dem Metallsalz-haltigen Medium 40, welcher für Figur 11 oben im Detail beschrieben wurde, nochmals aus Gründen der Übersicht als Flussdiagram. In diesem exemplarischen Ausführungsbeispiel wird als Metallsalz-haltiges Medium 40 eine Mischung aus dem Metallsalz-haltigen Medium 20 aus dem Aufbereiten der Rückstände 21 des Galvanisierungsprozesses 250 und dem Metallsalz-haltigen Medium 30 aus dem Aufbereiten der Spülwässer 31 verwendet (zunächst in ein Harmonisierungsbecken 410 eingeleitet). Das Einstellen bzw. Regeln der Zusammensetzung des Metallsalz-haltigen Mediums 40 wird von der Reaktionszelle 450 aus durchgeführt. Diese steht in Fluidkommunikation mit dem Aktivkohlefilter 412, dem Verdunster (-turm) 416, der Membrandialyse 440, und dem Ionentauscher 420. Insbesondere das Metallsalz-haltige Medium 20 aus dem Aufbereiten der Rückstände 21 des Galvanisierungsprozesses 250 kann eine hohe Konzentration an Fremdmetallen (z.B. Eisen) aufweisen.

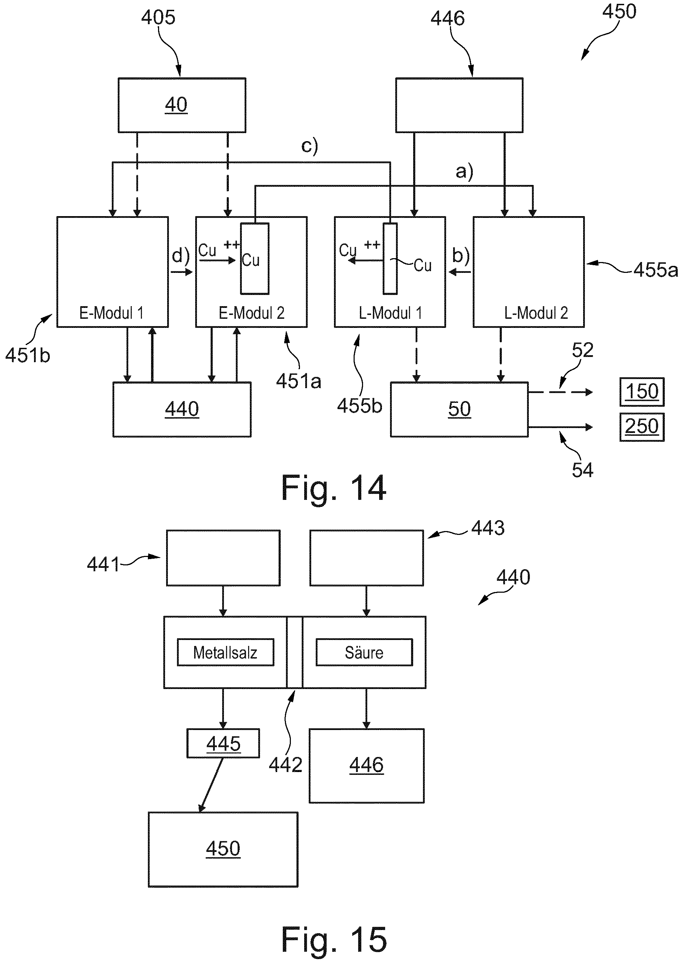

**Figur 14** zeigt detailliert ein exemplarisches Ausführungsbeispiel des Rückgewinnens 400 des elementaren Metalls 50 aus dem Metallsalz-haltigen Medium 40 mittels einer Elektrolyse 451 in der Reaktionszelle 450. In diesem exemplarischen Ausführungsbeispiel weist das Metallsalz Kupfersulfat auf und das elementare Metall 50 weist Kupfer auf. Um eine geeignete Konzentration an Kupfersulfat im Elektrolyten 40 zu gewähren, wird der Elektrolyse ein Verdunster (nicht gezeigt) vorangestellt. In den E-Modulen 451a,b kann mittels Platten- oder Trommel-Elektrolyse das Kupfer bei einer Temperatur von ca. 50°C-60°C abgeschieden werden. Die Kupferlösung (Elektrolyt) 40 wird innerhalb des E-Moduls umgewälzt und ggf. gezielt an die Kathode geströmt (siehe E-Modul 451a). An dieser findet die Kupferabscheidung dadurch vermehrt statt. Das Verfahren arbeitet bevorzugt kontinuierlich. Die Verarmung des Kupfers im Elektrolyten 40 durch dessen Abscheidung an der Kathode wird mit frischer Kupfersulfat-Lösung stetig ausgeglichen.

In einem speziellen Ausführungsbeispiel wird die Elektrolyse bis zu einer definierten Konzentration an Sulfat- und Kupfer-Ionen betrieben (z.B. Cu²⁺ etwa 5 g/L in etwa 100-300 g/L Schwefelsäure). Hierbei kann indirekt die Abscheiderate von Kupfer über die Säurekonzentration gesteuert werden: je höher die Säurekonzentration, desto wahrscheinlicher fällt auch Kupfer in Form von Kupfersulfat aus. Anschließend wird der (saure) Elektrolyt abgepumpt und z.B. als Regenerierhilfe (Regeneriermedium) dem Ionenaustauschharz zur Aufbereitung 300 der Spülwässer zugeführt.

In diesem Ausführungsbeispiel (analog für andere Metalle bzw. Metallsalze) wird kein Verdunsterturm benötigt, da nicht kontinuierlich Wasserdampf entfernt werden muss. Dies kann einen deutlichen Vorteil darstellen, denn ein Verdunsterturm verbraucht im Betrieb sehr viel Energie, z.B. 400 KW/h und ca. 10000 KW pro Tag. Auf diese Weise kann aufzuwendende Energie eingespart werden und dem Wertstoffkreislauf muss weniger Energie zugeführt werden.

Auch wird in diesem Ausführungsbeispiel keine Säuredialyse 440 benötigt, um die anfallende Säure abzutrennen, denn die angereicherte Säure kann (direkt) als Regenerierhilfe (Regeneriermedium) 325, 326 verwendet werden. Dadurch wird die benötigte Menge an Wasser für den Gesamtprozess ebenfalls reduziert.

Die einzelnen Elektrolysezellen 450 werden in einem spezifischen Beispiel bevorzugt Batch-weise (nicht kontinuierlich) betrieben: während des Abpumpens des Elektrolyten wird die Elektrolyse angehalten. Durch eine Prozessanordnung von mehreren parallellaufenden Elektrolyse-Zellen 450 ist jedoch wieder ein kontinuierlicher Kupferabscheidungs-Prozess ermöglicht.

Das Volumen innerhalb des E-Moduls 451a wird automatisch überwacht. Jedes Modul besitzt eine sog. Badabsaugung um Wasserdampf kontrolliert abzuführen. Dadurch wird die Zugabe der Kupfersulfat-Lösung 40 im Abgleich mit der Wasserverdunstung gesteuert. Die Wasserverdunstungsrate (Liter pro Stunde) wird mit der notwendigen Zugabe von Kupfersulfat-Lösung (Liter pro Stunde) abgestimmt. Hat sich auf der Kathode eines E-Moduls 451a ausreichend viel hochreines Kupfer abgeschieden, wird das Substrat (Kathode) samt abgeschiedenem Kupfer automatisch in ein Kupfer-Lösemodul (siehe L-Modul 455a) transportiert (Schritt a). Dies geschieht mit einem programmgesteuerten Transportsystem, welches mit einer vertikalem Hub- und Senkvorrichtung ausgestattet ist und oberhalb der gesamten Modulreihe (E-Module 451a,b und L-Module 455a,b) jede Modul-Position erreichen kann. Ist eine bestimmte Kupferkonzentration im Elektrolyten 40 des L-Moduls (nun 455b) erreicht (Schritt b), wird der von Kupfer abgereicherte Substratträger (vormals Kathode) automatisch vom Transportsystem von dem L-Modul (siehe 455b) wieder in ein freies E-Modul 451b gesetzt (Schritt c). Die Gewichtsabnahme (Lösen des Kupfers) am Substratträger kann gemessen werden, ebenso die Gewichtszunahme (Kupferabscheidung). Mit dieser Verfahrensweise entsteht ein Pendelbetrieb zwischen E-Modul 451 und L-Modul 455. Die Kupferfracht wird gezielt als Kupfersulfat in die bestehenden Kupfer Redumaten verteilt und so in die Produktion zurückgeführt. Dort kann die Kupferkonzentration zusätzlich angeglichen und an die Leiterplatten Produktion weitergegeben werden. Das Verteilersystem der Redumaten bleibt bestehen. Eine weitere Methodik zur Freisetzung des an der Elektrode abgeschiedenen Kupfers wäre ein Lösen des Kupfers mittels Säure, z.B. Schwefelsäure. Auch in diesem Fall, könnte das Kupfer in flüssiger Form dem Prozess zurückgeführt werden. Das Kupfer sollte zunächst oxidiert werden, denn Schwefelsäure oxidiert, und in weiterer Folge löst, Kupfer nur langsam. Daher kann ein Oxidations(hilfs)mittel zugeführt werden, im einfachsten Fall Sauerstoff. Deutlich beschleunigt kann das Lösen mittels Wasserstoffperoxid stattfinden.

Auch ein Abklopfen und anschließendes Schreddern des abgeschiedenen Kupfers kann verwendet werden, um Kupfer in fester Form dem Prozess zurückzuführen. Während des Betriebs wird vorteilhaft an den E-Modulen 451a,b regelmäßig (kontinuierlich) eine Membrandialyse 440 durchgeführt, um einem Überschuss an Säure entgegenzuwirken.

**Figur 15** zeigt detailliert ein exemplarisches Ausführungsbeispiel der Membrandialyse 440 während dem Rückgewinnen des elementaren Metalls 50 aus dem Metallsalz-haltigen Medium 40. Die Verdunstungsrate während der Elektrolyse kann durch Umwälzung, Elektrolyttemperatur und Absauggeschwindigkeit beeinflusst werden. Um eine Aufkonzentrierung von Sulfat (SO₄²⁻) und Elektrolytschmutz zu verhindern, ist wiederum die Membrandialyse 440 vorgesehen, welches kontinuierlich eine Art "Nierenfunktion" ausführt. Dabei wird Schwefelsäure vom Elektrolyten 441 abgetrennt und somit der pH-Wert des Elektrolyten 40 konstant gehalten. Das (Schwefelsäure) Diffusat 446, welches zum Lösen des Kupfers benötigt wird (siehe oben), wird kontinuierlich mit frischer Säure nachgeschärft und anschließend dem L-Modul 455a,b zugeführt. Das Dialysat 445 wird über einen Aktivkohlefilter geleitet um restliche organische Zusatzstoffe, die sich andernfalls im Elektrolyten ansammeln würden, abzutrennen. Anschließend wird das Dialysat 445 der Reaktionszelle 450 bzw. Elektrolyse 451 zurückgeführt.

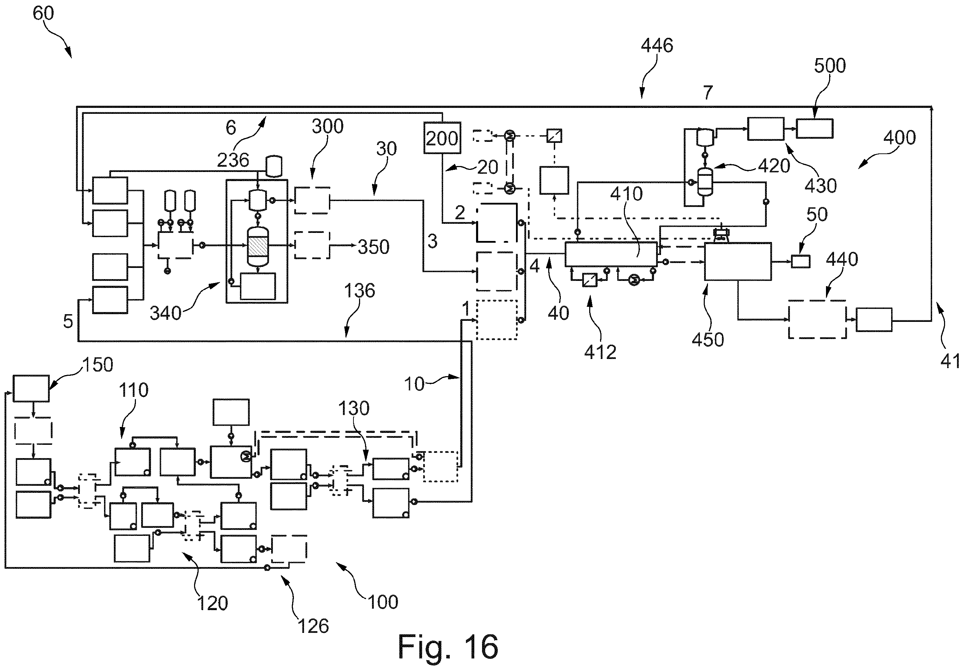

**Figur 16** zeigt eine Übersicht der Aufbereitungsprozesse 100, 200, 300 und des Rückgewinnens 400 bei der Leiterplatten- und/oder Substrat-Herstellung gemäß einem Ausführungsbeispiel der Erfindung. Die Übersicht zeigt die Verzahnung sämtlicher Prozesse ineinander und den sich hieraus ergebenden Wertstoffkreislauf. Sämtliche Prozesse wurden für die oben ausgeführten Ausführungsbeispiele jeweils bereits im Detail diskutiert.

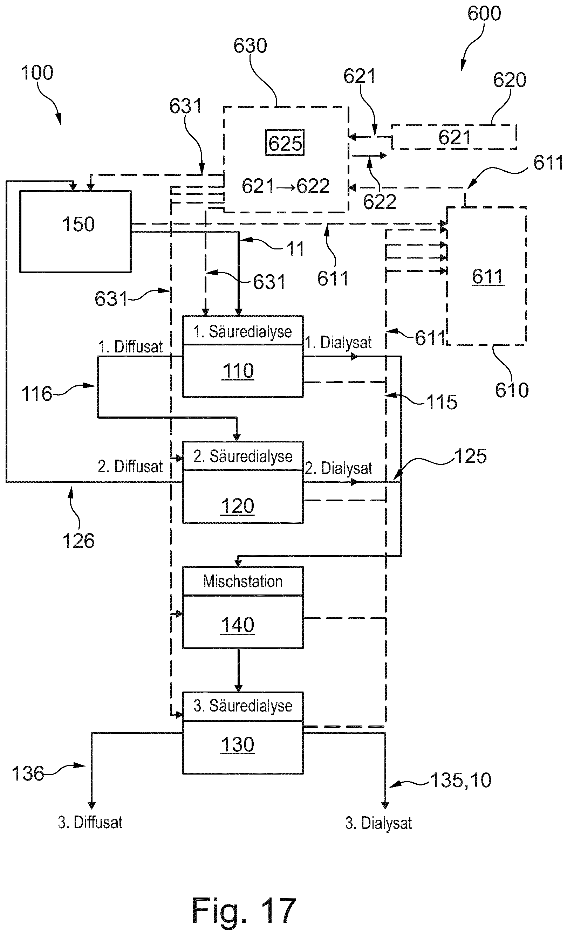

**Figur 17** zeigt eine Prozesskontrollvorrichtung 600 zum Regulieren (bzw. Regeln) von zumindest einem Teil des oben beschriebenen Verfahrens (bzw. der Industrieanlage 60) gemäß einem Ausführungsbeispiel der Erfindung. In dem gezeigten Beispiel ist die Prozesskontrollvorrichtung 600 in den ersten Aufbereitungsprozess 100 zum Bereitstellen des ersten Metallsalz-haltigen Mediums 10 aus einem Ätzprozess 150 aus der Leiterplatten- und/oder Substrat-Herstellung implementiert. Auf dieselbe Weise kann die Prozesskontrollvorrichtung 600 auch in die weiteren (oben beschriebenen) Prozesse (bzw. Verfahren) implementiert werden.

Die Prozesskontrollvorrichtung 600 weist auf: i) eine Datenbank 610 zum Erfassen von zumindest einem Prozessparameter 611 aus dem laufenden (im Betriebszustand befindlichen) Prozess (in dem gezeigten Beispiel der erste Aufbereitungsprozess 100). In dem exemplarischen Ausführungsbeispiel ist gezeigt, dass an allen Prozessschritten Prozessparameter (Werte und/oder Bereiche) 611 erfasst werden (z.B. mittels Sensoren) und der Datenbank 610 zugeführt werden. Die Prozessparameter stellen daher "Ist"-Werte dar (z.B. HCl Konzentration, Kupfer Konzentration, Druckdifferenz, etc). Die Prozesskontrollvorrichtung 600 weist ferner auf: ii) eine Datenmodell-Einheit 620, welche eingerichtet ist zum Speichern von zumindest einem vorbestimmten Prozessparameter 621 (Werte und/oder Bereiche). In dem gezeigten Beispiel werden eine Vielzahl von Prozessparametern gemäß einem oder mehr Datenmodellen in der Datenmodell-Einheit 620 für die verschiedenen Prozessschritte bereitgestellt. Diese vorbestimmten Prozessparameter 621 stellen daher "Soll"-Werte dar. Die Prozesskontrollvorrichtung 600 weist ferner auf: iii) eine Berechnungsvorrichtung 630 (z.B. eine einzelne (separate) Einheit oder eine Mehrzahl von Einheiten), welche eingerichtet ist zum a) Vergleichen des erfassten Prozessparameters 611 (bzw. der Mehrzahl dieser Parameter) mit dem vorbestimmten Prozessparameter 621 (bzw. der Mehrzahl dieser Parameter) (z.B. Vergleich "Ist-Wert" gegen "Soll"-Wert), b) Bestimmen einer Steueroperation 631, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation 631 (z.B. Flussrate anpassen).

Gemäß einem exemplarischen Ausführungsbeispiel der (Software-basierten) Prozesskontrollvorrichtung 600 sammelt die Datenbank 610 Daten aus dem laufenden Prozess (Prozessparameter 611) bzw. greift auf Werte aus einem vorgelagerten Prozessschritt (Prozessparameter 611) zu und archiviert daher (alle) "Ist"-Werte. Ein Datenmodell bzw. mehrere voneinander unabhängige Datenmodelle (welche(s) in der Datenmodell-Einheit 620 z.B. ebenfalls in Form einer Datenbank angelegt sind/ist) beinhalten u.a. "Soll"-Werte (bzw. "Soll"-Bereiche), optional auch deren Zusammenhänge und Variablen (z.B. Datenmodelle 621 als Referenzwerte/Referenzmodelle, die zur Überprüfung der "Ist"-Werte 611 herangezogen werden). Die Berechnungsvorrichtung 630 gleicht die "Ist"-Werte mit den "Soll"-Werten (bzw. setzt einen Rechenschritt basierend auf den Datenmodellen 621 in Kombination mit den "Ist"-Werten 611) ab und setzt anschließend eine Aktion (Steueroperation 631) entsprechend dem Abgleichergebnis (z.B. "Ist"-Wert entspricht "Soll"-Wert, "Ist"-Wert weicht von "Soll"-Wert ab, "Ist"-Wert erfüllt bestimmte Kriterien, etc). Die bestimmte Steueroperation 631 kann (zumindest einen Teil) eines Verfahrensschritts wie oben beschrieben aufweisen.

Gemäß einem exemplarischen Ausführungsbeispiel weist die Berechnungsvorrichtung 630 einen selbstlernenden Algorithmus (AI) 625 (z.B. realisiert mittels neuronaler Netzwerke) auf zum Vergleichen und/oder zum Bestimmen. Der selbstlernende Algorithmus 625 ist eingerichtet, die bestimmte Steueroperation 631 automatisch durchzuführen und/oder einem Benutzer zum Überprüfen bereitzustellen. Ferner ist der selbstlernende Algorithmus 625 eingerichtet basierend auf dem Vergleichen einen neuen vorbestimmten Prozessparameter 622 zu bestimmen und diesen automatisch der Datenmodell-Einheit 620 zuzuführen und/oder dem Benutzer zum Überprüfen bereitzustellen. Bevorzugt ist der selbstlernende Algorithmus 625 eingerichtet, das Ergebnis des Überprüfens durch den Benutzer als Lerngrundlage zu verwenden.
Gemäß einem exemplarischen Ausführungsbeispiel weist die Berechnungseinheit 630 einen selbstlernenden Algorithmus 625 auf, der Aktionen (Steueroperationen 631) setzt, welche entweder direkt im System implementiert werden oder die dem Operator zur Überprüfung zur Verfügung gestellt werden. Zudem kann die Entscheidung des Operators bei der Überprüfung wiederum die Lerngrundlage für die AI-Funktion bilden. Ferner kann die AI basierend auf den erfassten "Ist"-Werten 611 neue "Soll"-Werte/Bereiche 621 kreieren bzw. vorschlagen, die dann entweder automatisch oder Operator-gesteuert in das Datenmodell übernommen werden.

In einem spezifischen Ausführungsbeispiel werden die folgenden Prozessparameter 611 überwacht bzw. gemessen (im Folgenden angegeben ist jeweils eine beispielhafte Messmethode) und in der Datenbank 610 erfasst:
i) Füllstände; mittels Ultraschallmessungen,
ii) Volumenströme; mittels Flowmeter,
iii) H₂O₂ Konzentration; über das Redoxpotential bestimmt,
iv) Säure Konzentration; pH-Wert (in-line) oder Titration (Proben ziehen),
v) Organik Konzentration; photometrisch (in-line) oder Cyclovoltammetrie (Proben ziehen),
vi) Chlorid Konzentration; Titration (Proben ziehen),
vii) Eisen/Kupfer Konzentration; photometrisch oder Dichtemessungen (in-line) oder Titration (Proben ziehen),
viii) Temperatur; Temperatursensoren (in-line),
ix) Differenzdruck bei der Membrandialyse zwischen Diffusat und Dialysat; Drucksensoren (in-line).

In diesem spezifischen Ausführungsbeispiel werden nach dem Vergleichen (bzw. Auswerten, Datenanalyse) der bestimmten (gemessenen) Prozessparameter 611 und der vorbestimmten Prozessparameter 621 durch die Berechnungsvorrichtung 630 mittels der Berechnungsvorrichtung 630 z.B. die folgenden Steueroperationen 631 (bzw. Aktionen) bestimmt und durchgeführt (bzw. getriggert):
i) Chlorgas-Bildung (z.B.: über Gassensoren); Steueroperation: Elektrolyse aus,
ii) zu hohe Peroxidbelastung; Steueroperation: kein Beladen des Ionentauschers zur Aufbereitung der Spülwässer,
iii) zu niedriger Füllstand; Steueroperation: Pumpen aus,
iv) zu hohe Eisenkonzentration im Elektrolyten; Steueroperation: Zuschalten des Ionenaustauschharzes,
v) zu hohe Säure-Konzentration im Elektrolyten; Steueroperation: Zuschalten der Membrandialyse oder Abpumpen der Elektrolysezelle,
vi) geringe Kupfer-Konzentration im Elektrolyten; Steueroperation: Elektrolysezelle abpumpen und Fördern des Elektrolyten zum Vorbehandlungsbecken der Spülwässer,
vii) zu hoher Differenzdruck bei Membrandialyse; Steueroperation: Volumenströme (Flowrate) anpassen,
viii) Kupfer-Konzentration im Permeat des Ionentauschers zur Aufbereitung der Spülwässer; Steueroperation: Regenerieren,
ix) Eisen-Konzentration im Permeat des Ionentauschers zur Eliminierung von Eisen aus den Galvanikabwässer; Steueroperation: Regenerieren,
x) zu hohe Chlorid-Konzentration im Dialysat; Steueroperation: Volumenströme (Flowrate) anpassen.

### Bezugszeichen

1, 2, 3 Erster Teilstrom, zweiter Teilstrom, dritter Teilstrom
4 Gesamtstrom
5, 6, 7 Erster Abtrennstrom, zweiter Abtrennstrom, dritter Abtrennstrom
52 Metall Rückführung zu Ätzprozess
54 Metall Rückführung zu Galvanisierungsprozess
60 Industrieanlage zum Herstellen gedruckter Leiterplatten
100 Aufbereitung eines Metallsalz-haltigen Mediums aus einem Ätzprozess aus der Herstellung gedruckter Leiterplatten
10 Metallsalz-haltiges Medium
11 Aufzubereitendes Medium
15 Säure
15a Erster Teil Säure
15b Zweiter Teil Säure
15c Dritter Teil Säure
110 Erste Membrandialyse
112 Erste Membran
113 Erster Zulauf
115 Erstes Dialysat
116 Erstes Diffusat
120 Zweite Membrandialyse
122 Zweite Membran
123 Zweiter Zulauf
125 Zweites Dialysat
126 Zweites Diffusat
127 Ätzprozess Sammelbecken
130 Dritte Membrandialyse
131 Zulauf für Dialysat
132 Dritte Membran
133 Dritter Zulauf
135 Drittes Dialysat
136 Drittes Diffusat (erster Abtrennstrom)
140 Reaktor, Mischen und Durchführen der chemischen Reaktion
141 Konzentriertes (Säure-freies) aufzubereitendes Medium
143 Weitere Säure
150 Ätzprozess
151 Ätzprozess Überlaufbecken
160 Verdunster
200 Aufbereitung eines Metallsalz-haltigen Mediums aus einem Galvanisierungsprozess aus der Herstellung gedruckter Leiterplatten
20 Metallsalz-haltiges Medium
21 Eisen- und Metallsalz-haltiges Medium
205 Speicher-Modul, Bereitstellen
210 Oxidier-Modul
220 Separier-Modul, Ionentauscher
221 Beladen
222 Regenerieren, Strömen
225 Saure Lösung
226 Eisen-haltige saure Lösung, Regenerat
230 Aufbereiten, Säuredialyse
231 Bereitstellen an Leiterplatten Prozess
235 Eisen-haltiges Dialysat
236 Säure-haltiges Diffusat (zweiter Abtrennstrom)
240 Rückführen Säure
250 Galvanisierungsprozess
300 Aufbereitung eines Metallsalz-haltigen Mediums aus Spülwasser aus der Herstellung gedruckter Leiterplatten
30 Metallsalz-haltiges Medium
31 Aufzubereitendes Medium, Gesamtabtrennstrom
32 Weiteres Spülwasser
305 Bereitstellen
310 Vorbehandeln
311 Behälter Natronlauge, Einstellen pH-Wert
312 Behälter Bisulfit, chemisches Reduzieren
313 Organischer Filter, Aktivkohlefilter
320 Ionentauscher
321 Beladen
322 Regenerieren, Strömen
325 Regeneriermedium, weitere Säure
326 Regeneriermedium, Regenerat
327 Separieren von Abwasser
328 Speicher-Modul für Regenerat
329 Bereitstellen von konzentriertem Medium
340 Separier-Modul
350 Abfall Medium, Wasser mit Einleitqualität
351 Aufreinigung Wasser
352 Zufuhr Wasser
400 Rückgewinnen eines elementaren Metalls aus einem Metallsalz-haltigen Medium aus der Herstellung gedruckter Leiterplatten
40 Metallsalz-haltiges Medium, Elektrolyt
41 Verbrauchter Elektrolyt
50 Elementares Metall (Kupfer)
401 Rückgewinnen erster Teilstrom
402 Rückgewinnen zweiter und dritter Teilstrom
405 Bereitstellen, Zusammenführen, Aufkonzentrieren
410 Versorgungsbecken, Einstellen der Zusammensetzung
412 Aktivkohlefilter, Filtern
414 Temperaturregelung
415 Pumpvorlage für Separieren von Fremdmetall
416 Verdunster, Aufkonzentrieren
419a,b Fluidkommunikation
420 Ionentauscher, Separieren von Fremdmetall
421 Beladen
422 Regenerieren, Strömen
425 Saure Lösung, Regeneriermedium
426 Regenerat, Fremdmetall-haltige saure Lösung, Regeneriermedium
430 Konzentrierte Fremdmetall-haltige saure Lösung
431 Bereitstellen an Leiterplatten Prozess
440 Membrandialyse, Separieren von Säure
441 Zulauf Dialyse
442 Membran
443 Zulauf Diffusat
445 Dialysat mit Metallsalz
446 Diffusat mit Säure (dritter Abtrennstrom)
447 Speicher-Modul Säure
450 Reaktionszelle, Elektrolysezelle
451 Elektrolyse (E-Modul)
452 Oxidation
455 Ablöse-Modul (L-Modul)
460 Luftzirkulation
461 Abluft
462 Zuluft
463 Luftfilter
464 Gesättigte Abluft
465 Natürliche Verdunstung
500 Weiterer Leiterplatten Prozess, Fotolack-Prozess
600 Prozesskontrollvorrichtung
610 Datenbank
611 Prozessparameter, Ist-Wert
620 Datenmodell-Einheit
621 Vorbestimmter Prozessparameter, Soll-Wert
622 Neuer vorbestimmter Prozessparameter
625 Selbstlernender Algorithmus
630 Berechnungsvorrichtung
631 Bestimmte Steueroperation
P Prozessrichtung

## Patentansprüche

1. Ein Verfahren zum Herstellen von Leiterplatten und/oder Substraten, wobei anfallende Rückstände (11, 21, 31) in Teilströmen (1 bis 7) derart in einem Wertstoffkreislauf rückgeführt werden, dass im Betriebszustand des Herstellungsverfahrens als Abfall im Wesentlichen nur ein Medium (350) in Einleitqualität anfällt.

2. Das Verfahren gemäß Anspruch 1,
wobei das Medium (350) in Einleitqualität im Wesentlichen keine Hauptkomponenten der Leiterplatten- und/oder Substrat-Herstellung, insbesondere kein Schwermetall, aufweist.

3. Das Verfahren gemäß Anspruch 1 oder 2,
wobei die Konzentration an Schwermetall in dem Medium (350) in Einleitqualität 15 mg/L oder weniger aufweist,
insbesondere wobei die Konzentration an Kupfer in dem Medium (350) in Einleitqualität 0,5 mg/L oder weniger aufweist.

4. Das Verfahren gemäß einem beliebigen der vorhergehenden Ansprüche, aufweisend zumindest eines der folgenden Merkmale:
wobei das Medium im Wesentlichen Wasser, Salze, und Organik aufweist, insbesondere daraus besteht;
wobei sich die Einleitqualität darauf bezieht, dass das Medium (350) unter Einhaltung gesetzlicher Grenzwerte und/oder Normen in Kläranlagen einleitbar ist;
wobei sich die Einleitqualität darauf bezieht, dass das Medium (350) unter Einhaltung gesetzlicher Grenzwerte und/oder Normen in Gewässer einleitbar ist;
wobei dem Herstellungsverfahren im Betriebszustand im Wesentlichen nur Wasser und Energie zugeführt werden;
wobei anfallende Säuren (41, 126, 136, 236, 446) ebenfalls in dem Wertstoffkreislauf rückgeführt werden;
wobei das Verfahren ferner aufweist:
Aufreinigen (351) des Mediums (350) in Einleitqualität derart, dass das Medium (350) in Gewässer einleitbar ist,
insbesondere Aufreinigen (351) derart, dass der CSB-Wert, als Maß für die Konzentration organischer Verbindungen, 300 mg/L, insbesondere 75 mg/L, oder weniger beträgt;
wobei dem Herstellungsverfahren im Betriebszustand im Wesentlichen nur Hauptkomponenten der Leiterplatten- und/oder Substrat-Herstellung zugeführt werden, um Hauptkomponenten zu ersetzen, welche das Herstellungsverfahren als Bestandteil einer Leiterplatte und/oder eines Substrats verlassen haben;
wobei dem Herstellungsverfahren im Betriebszustand im Wesentlichen keine Hauptkomponenten der Leiterplatten- und/oder Substrat-Herstellung zugeführt werden, um Hauptkomponenten zu ersetzen, welche das Herstellungsverfahren als Bestandteil eines Abwassers verlassen haben;
wobei eine Hauptkomponente der Leiterplatten- und/oder Substrat-Herstellung Metall ist, insbesondere Schwermetall, weiter insbesondere zumindest eines aus der Gruppe, welche besteht aus Kupfer, Eisen, Nickel, Gold, Silber, Palladium, Zinn;
wobei die anfallenden Rückstände (11, 21, 31) zumindest eines aus der Gruppe aufweisen, welche besteht aus: Schwermetall, insbesondere Kupfer und/oder Eisen, Metallsulfat, Metallchlorid, Salzsäure, Schwefelsäure;
wobei in dem Wertstoffkreislauf 90% oder mehr, insbesondere 95% oder mehr, weiter insbesondere 98% oder mehr, der Schwermetall Rückstände, insbesondere der Kupfer Rückstände, rückgeführt werden;
wobei in dem Wertstoffkreislauf mindestens 80% der abgetrennten Salzsäure rückgeführt werden, und mindestens 70% der benötigten Schwefelsäure Verfahrens-intern produziert werden.

5. Das Verfahren gemäß einem beliebigen der vorhergehenden Ansprüche, wobei die Teilströme (1 bis 7) zumindest eines der folgenden Merkmale aufweisen:
ein erster Teilstrom (1) aus einem Ätzprozess (150) der Leiterplatten- und/oder Substrat-Herstellung;
ein zweiter Teilstrom (2) aus einem Galvanisierungsprozess (250) der Leiterplatten- und/oder Substrat-Herstellung;
ein dritter Teilstrom (3) aus Spülwasser (32) und/oder Restwasser der Leiterplatten- und/oder Substrat-Herstellung.

6. Das Verfahren gemäß Anspruch 5,
wobei der erste Teilstrom (1) ein erstes aufbereitetes Metallsalz-haltiges Medium (10) aus einem Ätzprozess (150) der Leiterplatten- und/oder Substrat-Herstellung aufweist, welches in einem ersten Aufbereitungsprozess (100) aufbereitet wird,
insbesondere wobei das aufbereitete Metallsalz-haltige Medium (10) im Wesentlichen frei von aufzubereitendem Metallsalz, weiter insbesondere im Wesentlichen frei von Säure (15), ist.

7. Das Verfahren gemäß Anspruch 6,
wobei das erste aufbereitete Metallsalz-haltige Medium (10) aus einem aufzubereitenden Medium (11), welches ein aufzubereitendes Metallsalz, insbesondere Kupferchlorid, und eine Säure (15) aufweist, erhalten wird unter Verwenden eines mehrstufigen Entfernens (110, 120) der Säure (15) mittels Membrandialyse und Durchführens einer chemischen Reaktion (140), insbesondere Umsalzen, insbesondere
wobei die chemische Reaktion (140) eine exotherme Reaktion ist und wobei das Verfahren ferner aufweist:
Ableiten von zumindest einem Teil der Reaktionswärme derart, dass ein flüssiges Medium, insbesondere ein flüssiges Medium in einem Versorgungsbecken oder Elektrolysebecken, innerhalb derselben Leiterplatten- und/oder Substrat-Herstellung erwärmt wird.

8. Das Verfahren gemäß einem beliebigen der Ansprüche 5 bis 7,
wobei der zweite Teilstrom (2) ein zweites aufbereitetes Metallsalz-haltiges Medium (20) aus einem Galvanisierungsprozess (250) der Leiterplatten- und Substrat-Herstellung aufweist, welches in einem zweiten Aufbereitungsprozess (200) aufbereitet wird,
insbesondere wobei das aufbereitete Metallsalz-haltige Medium (20) im Wesentlichen frei von Fremdmetall ist,
weiter insbesondere wobei das Fremdmetall zumindest eines aus der Gruppe aufweist, welche besteht aus: Eisen, Blei, Zinn, Molybdän, Nickel, Kobalt, Indium, Cadmium, Zink, Chrom, Natrium, Palladium, insbesondere wobei das zweite aufbereitete Metallsalz-haltige Medium (20) aus einem Fremdmetall- und Metallsalz-haltigen Medium (21) erhalten wird unter Verwenden eines Separierens (220) des Fremdmetalls, insbesondere Eisens, aus dem Fremdmetall- und Metallsalz-haltigen Medium (21),
insbesondere mittels eines Ionentauschers, welcher ein selektives Ionenaustauschharz, weiter insbesondere ein doppel-funktionalisiertes Ionenaustauschharz, aufweist.

9. Das Verfahren gemäß einem beliebigen der Ansprüche 5 bis 8,
wobei der dritte Teilstrom (3) ein drittes aufbereitetes Metallsalz-haltiges Medium (30) aus Spülwasser (32) der Leiterplatten- und/oder Substrat-Herstellung aufweist, welches in einem dritten Aufbereitungsprozess (300) aufbereitet wird, insbesondere wobei das Metallsalz in dem aufbereiteten Metallsalz-haltigen Medium (30) im Vergleich zu dem Spülwasser (32) aufkonzentriert ist.

10. Das Verfahren gemäß Anspruch 9,
wobei das dritte aufbereitete Metallsalz-haltige Medium (30) aus einem aufzubereitenden Medium (31) erhalten wird unter Verwenden eines Ionentauschers (320), insbesondere aufweisend zumindest eines der folgenden Merkmale:
wobei ein Regenerieren (322) des Ionentauschers (320) mittels Strömens eines Regeneriermediums (325, 326) durch den Ionentauscher (320) derart durchgeführt wird, dass das Metall zumindest teilweise in dem Regeneriermedium (325, 326) gelöst wird und ein Regenerat (326) bereitgestellt wird, und
wobei das Regeneriermedium (325, 326) zumindest teilweise Verfahrens-intern erzeugt ist;
wobei das Regenerat (326) des Ionentauschers (320) für ein oder mehr Regenerierschritte (322) in dem Ionentauscher (320) verwendet wird, insbesondere wobei die Konzentration des Metalls in dem Regenerat (326) mit jedem Regenerierschritt (322) ansteigt;
wobei der dritte Aufbereitungsprozess (300) aufweist:
Beladen (321) des Ionentauschers (320) mit dem Metallsalz-haltigen Medium (30) aus Spülwasser (32) der Leiterplatten- und/oder Substrat-Herstellung derart, dass das Metall zumindest teilweise an dem Ionentaucher (320) verbleibt; und
Separieren (327) des Mediums (350) in Einleitqualität.

11. Das Verfahren gemäß einem beliebigen der vorhergehenden Ansprüche, wobei das Verfahren aufweist:
Aufbereiten (400) zumindest eines Teilstroms (1, 2, 3), wobei das Aufbereiten (400) ferner aufweist:
Rückgewinnen (400) von elementarem Metall (50) aus dem Metallsalz-haltigen Medium des Teilstroms (1, 2, 3) in einer Reaktionszelle (450), insbesondere mittels Elektrolyse (451),
insbesondere wobei das Verfahren ferner aufweist:
Rückführen des rückgewonnenen Metalls (50) in das Herstellungsverfahren, insbesondere in einen Ätzprozess (150) und/oder einen Galvanisierungsprozess (250) der Leiterplatten- und/oder Substrat-Herstellung.

12. Das Verfahren gemäß einem beliebigen der vorhergehenden Ansprüche, ferner aufweisend:
Bereitstellen (231, 431) einer Fremdmetall-haltigen sauren Lösung (235, 426, 430) aus dem Wertstoffkreislauf an einen weiteren Prozess (500) bei der Leiterplatten- und/oder Substrat-Herstellung, insbesondere einen Prozess zum Fällen von Fotolack, insbesondere
wobei das Fremdmetall Eisen aufweist, wobei die saure Lösung Salzsäure, HCl, aufweist, und wobei die Fremdmetall-haltige saure Lösung (235, 426, 430) Eisenchlorid, FeCl₃, aufweist.

13. Eine Prozesskontrollvorrichtung (600) zum Regulieren eines Verfahrens gemäß einem beliebigen der Ansprüche 1 bis 12, wobei die Prozesskontrollvorrichtung (600) aufweist:
eine Datenbank (610) zum Erfassen von zumindest einem Prozessparameter (611) aus dem laufenden Prozess;
eine Datenmodell-Einheit (620), welche eingerichtet ist zum Speichern von zumindest einem vorbestimmten Prozessparameter (621); und
eine Berechnungsvorrichtung (630), welche eingerichtet ist zum Vergleichen des erfassten Prozessparameters (611) mit dem vorbestimmten Prozessparameter (621),
Bestimmen einer Steueroperation (631), welche auf dem Ergebnis des Vergleichens basiert, und
Durchführen der bestimmten Steueroperation (631).

14. Die Prozesskontrollvorrichtung (600) gemäß Anspruch 13, ferner aufweisend zumindest eines der folgenden Merkmale:
wobei die Berechnungsvorrichtung (630) einen selbstlernenden Algorithmus (625), insbesondere mittels neuronaler Netzwerke, zum Vergleichen und/oder zum Bestimmen aufweist;
wobei der selbstlernende Algorithmus (625) eingerichtet ist, die bestimmte Steueroperation (631) automatisch durchzuführen, und/oder
wobei der selbstlernende Algorithmus (625) eingerichtet ist, die bestimmte Steueroperation (631) einem Benutzer zum Überprüfen bereitzustellen;
wobei der selbstlernende Algorithmus (625) eingerichtet ist basierend auf dem Vergleichen einen neuen vorbestimmten Prozessparameter (622) zu bestimmen und automatisch der Datenmodell-Einheit (620) zuzuführen, und/oder
wobei der selbstlernende Algorithmus (625) eingerichtet ist basierend auf dem Vergleichen einen neuen vorbestimmten Prozessparameter (622) zu bestimmen und dem Benutzer zum Überprüfen bereitzustellen;
wobei der selbstlernende Algorithmus (625) eingerichtet ist, das Ergebnis des Überprüfens durch den Benutzer als Lerngrundlage zu verwenden.

15. Ein Computerprogramm-Produkt zum Steuern eines Verfahrens zum Herstellen von Leiterplatten und/oder Substraten, insbesondere in einer Industrieanlage (60), welches Computerprogramm-Produkt, wenn es von einem oder mehreren Prozessoren ausgeführt wird, das Verfahren nach einem beliebigen der Ansprüche 1 bis 12 und/oder die Prozesskontrollvorrichtung (600) gemäß Anspruch 13 oder 14 steuert.
